# EUROPEAN PATENT APPLICATION

(11) **EP 1 897 971 A1**
(43) Date of publication of application: **12.03.2008**
(21) Application number: 06713301.7
(22) Date of filing: 08.02.2006
(51) Int. Cl.: C23C 18/20, H05K 3/18

(54) **METHOD FOR ELECTRICALLY CONDUCTIVE CIRCUIT FORMATION**

(30) Priority: 29.06.2005 JP 2005189836
(71) Applicant: HARIMA CHEMICALS, INC., Kakogawa-shi, Hyogo-ken 657-0019 (JP)
(72) Inventor: TERADA, Nobuto, c/o Tsukuba Research Laboratory, Tsukuba-shi, Ibaraki 300-2635 (JP); YOSHIHARA,Ritsuko, c/o Tsukuba Research Laboratory, Tsukuba-shi, Ibaraki 300-2635 (JP); MATSUBA,Yorishige, c/o Tsukuba Research Laboratory, Tsukuba-shi, Ibaraki 300-2635 (JP)
(74) Representative: Mathys & Squire
(86) International application number: PCT/JP2006/302158
(87) International publication number: WO 2007/000833

(57) **Abstract**

The present invention provides a novel approach for selectively forming an electroless plated metal layer which enables selective formation of an electroless plated metal layer in an intended shape of the circuit pattern on a surface of a non-conductive substrate, without using a plating mask layer, in a form that a surface of an adhesive layer and the plated metal layer are in direct contact with each other. In the method, an adhesive layer of a curable binder resin is provided to a surface of a non-conductive substrate on which metal fine particles having an average particle size of 1 to 200 nm are closely exposed at a high area density, and an energy beam is irradiated to a region corresponding to the shape of a circuit pattern, and the non-conductive substrate is subjected to a deforming process and then to electroless plating, so that an electroless plated metal layer is selectively formed only to the energy beam irradiated region which is fixedly attached to the surface of the non-conductive substrate via the adhesive layer with a high adhesion.

## Description

### Technical Field

The present invention relates to a conductive circuit manufacturing method in which an electroless plated layer is used as a conductive layer. Particularly, the present invention relates to a conductive circuit manufacturing method in which when an electroless plated layer having a predetermined circuit pattern is formed, a pattern of an adhesive resin layer made of an adhesive resin composition that contains metal ultra fine particles of an average particle size on the order of nanometers as a plated underlayer is used, and the metal ultra fine particles that are exposed on the pattern surface are used as nuclei to selectively and closely form an electroless plated layer thereon to is used as a conductive layer having a desired pattern shape.

### Background Art

A conductive circuit is manufactured by providing a conductive layer having a desired shape of the circuit pattern on a surface of a non-conductive substrate. As the conductive layer, employed is usually a metal plated film (foil). On the other hand, as a non-conductive substrate, a polymeric resin material in a sheet or film form which has excellent insulation property and flexibility is used, for example in flexible circuit boards. And, polymeric resin materials used as the material for a non-conductive substrate have poor adhesion to most of metals. Thus, in order to fixedly attach a metal plated film (foil) to a surface of a non-conductive substrate, many approaches have been used in which an adhesive layer is provided to an interface between the surface and the film to adhesively bond them to each other.

Many years ago, a conductive circuit was manufactured by fixedly attaching a metal plated film (foil) to a surface of a non-conductive substrate uniformly via an adhesive layer, printing an etching and masking layer which has a desired circuit pattern shape onto the surface of the metal plated film, and etching unnecessary regions of the metal plated film. Alternatively, a uniform and extremely thin metal film for plating was formed on a surface of a non-conductive substrate, and a plating mask layer having an opening corresponding to a desired shape of the circuit pattern is provided to the plating mask layer, so that a metal plated layer was selectively formed on the surface of the opening, which is used as a metal plated conductive layer of a conductive circuit. Eventually, a plating mask layer which is made of a resist resin or the like is removed, and then a metal film for plating which was covered with the plating mask layer is selectively removed, to form a metal plated conductive layer having a desired shape of the circuit pattern.

Also when an electroless plating method is used as an approach for manufacturing a metal plated film, after a metal film for plating is formed, a plating mask layer having openings corresponding to a desired shape of the circuit pattern is provided to the metal film, which is subjected to a electroless plating treatment, so that eventually the plating mask layer is removed to obtain an intended metal plated conductive layer. In using the electroless plating method, as well as an electroplating method, an electroless plated metal layer is uniformly precipitated on a metal film for plating which is fixedly attached to a surface of a non-conductive substrate, and is closely fixed by a metal-metal bonding.

The above described approach for selectively precipitating an electroless plated metal layer to openings corresponding to a desired shape of the circuit pattern is effective means, but has an essential problem because it can be hardly used when a ratio H/W between a beam width of the pattern (W) and a thickness of the plated layer (H) is large. Specifically, a plating mask layer is a photoresist film, for example, which is manufactured by exposing an intended circuit pattern thereto by using photolithography. A ratio T/W between an opening width (W) of the exposed opening and a film thickness (T) of the photoresist film is generally not more than 1/5, and therefore, it is difficult to obtain an aspect ratio: H/W ≤ 1/5 of the plated metal layer for a fine wiring portion. In addition, when a photoresist film is used as a plating mask layer, various agents are used in a step for removing the photoresist film after an exposing and developing process by using photolithography or a plating treatment, but depending on the material of the used photoresist film, the photoresist film may not have a sufficient resistance to the agents.

Moreover, the adhesion between the plating mask layer which is made of a photoresist film and the metal film surface for plating has a certain level of adhesion strength, but after the exposure, the photoresist film itself which was subjected to a post-baking treatment has poor elastic deformability and plastic deformability. Therefore, for example, when the entire assembly including the backing board is subjected to a deforming such as bending deformation, the photoresist film does not follow the deformation to cause large elastic deformation or plastic deformation, which often causes the film to be peeled at the interface between the film and the metal film surface for plating. That is, the plating mask layer which is made of a photoresist film can keep the state covering the metal film surface for plating as a flat surface, but cannot partly provide the desired function to cover the metal film surface for plating when the entire assembly including the backing board is subjected to bending deformation to be a surface having a curvature.

### Disclosure of the Invention

### Problems to be Solved by the Invention

A rigid circuit board in a hard plate form or a flexible circuit board in a film form which can be easily changed into various shapes can be provided with a conductive circuit formed thereon, by forming a circuit pattern formed of an electroless plated metal layer onto a surface of the board which is placed flat, using photoresist film as a plating mask layer. A flexible circuit board in a film form is used when it is in a bending state, taking advantage of the elastic deformability of itself.

Furthermore, a flex-rigid circuit board having a hybrid structure, which is composed of a rigid portion in a hard plate form and a flexible portion being suitable to bending deformation in combination with each other, has been proposed, with the aim of answering such a requirement that certain electronics are successfully mounted to the rigid portion in a hard plate form of the circuit board which is substantially free from bending deformation, and the entire circuit board having the desired bended portion is received into an apparatus to be fitted into its storage space. The flex-rigid circuit board, however, has a difficulty in being placed and secured in a bending state as intended when the board is inserted into a narrow gap, because the deformable and flexible portion is used as the bended part thereof. That is, the operation to place the flex-rigid circuit board to a narrow gap, with the bended part being adapted to shape of the narrow gap in advance, often involves considerable difficulty. Similar to the flexible circuit board, in the flex-rigid circuit board, such a hybrid type substrate composed of a rigid portion in a hard plate form and a deformable and flexible portion can be provided a conductive circuit formed thereon when the board is placed flat.

Instead of the flex-rigid board, a use of a forming-processed rigid circuit board has been studied, in which the circuit board itself is not substantially deformable, but the shape of the circuit board can be bended and formed as desired in advance for any purpose. For example, a deforming process to provide a desired bended portion to a circuit board has been studied so that certain electronics are mounted to a rigid portion in a hard plate form of the circuit board which is not substantially deformed and the entire shape of the circuit board is adapted to its storage space.

As described above, for example, the formation of a selective plated metal layer using a plating mask layer which is made of a photoresist film is effective means to a flat surface, but has several problems. First, in a patterning step of a photoresist film, in a step for removing the photoresist film using the plating mask layer after plating treatment, the material of the used non-conductive substrate needs to have a sufficient resistance to any of the used agents, which considerably restricts the limit of the application range. Under the circumstance where the entire assembly including a backing substrate is bended and deformed, a plating mask layer which is made of a photoresist film is partly peeled off from a metal film surface for plating and does not achieve its covering property as desired, which also considerably restricts the limit of the application range. Therefore, a development of a new approach is desired in which a selective plated metal layer can be formed in a pattern shape as intended even on a surface having a large curvature to which the use of a plating mask layer made of a photoresist film is difficult.

In addition, the adhesion property is significantly improved if a plated metal layer can be formed and fixedly attached to a surface of a non-conductive substrate having a desired curvature via an adhesive layer in a direct manner, compared to the case where the plated metal layer is fixedly attached to the adhesive layer in an indirect manner using a metal film for plating. That is, a development of a new approach is desired in which a selective plated metal layer can be formed in a pattern shape as intended on a curved surface in such a style that an adhesive layer and a plated metal layer to be formed can be directly and closely contacted with each other.

The present invention is made to solve the above problems, and an object of the present invention is to provide: a novel approach for forming a selective electroless plated metal layer in which a selective electroless plated metal layer is formed in a shape of the circuit pattern as intended on a surface of a non-conductive substrate, particularly, on a surface of a non-conductive substrate to which a bended portion and a curved region are formed by various deforming processes, without using a plating mask layer, in such a form that a surface of an adhesive layer and the formed plated metal layer is directly contacted to each other; and a conductive circuit manufacturing method using the approach.

### Means for Solving the Problems

The inventors of the present invention have been devoted their efforts to solve the above problems.

First, the inventors focused their attention on the fact that a selective plated metal layer can be formed using the nature of generated metal atoms, in an electroless plating treatment, that the metal atoms selectively precipitate onto a metal surface of nucleus, while preventing the precipitation of the metal atoms upon a surface of a plating mask layer which is made of a photoresist film, and enhancing the precipitation of the metal atoms upon the surface of a metal film for plating which is exposed at the openings formed therein. By carefully observing the surface of the metal film for plating, the inventors found that a plated metal layer was formed when the discretely distributed metal particles were closely coupled to each other and eventually made up a generally homogeneous particle aggregate layer. That is, the metal atoms do not uniformly precipitate upon the entire surface of a metal film for plating as a layer, but at the initial stage, fine metal clusters that function as discrete nuclei are formed, and then, the precipitation of metal atoms is enhanced to cover the clean surfaces of the metal clusters. At a certain stage when the surfaces of adjacent metal clusters contact with each other, metal atoms precipitate to surround the plurality of contacted metal clusters, which causes metal particles to be closely coupled in two dimensions to form a homogeneous particle aggregate layer.

In other words, the inventors found that, when fine metal surfaces that function as nuclei for precipitation of metal atom, are discretely arranged at a sufficiently high area density, fine metal clusters are closely formed by using the discrete nuclei as starting points, and eventually make up a homogeneous particle aggregate layer in which metal particles are closely coupled in two dimensions. The inventors also concluded that, except the fine metal surfaces which are discretely arranged at a sufficiently high area density, the regions between the fine metal surfaces are not directly involved in the precipitation of the metal atoms and may be the surfaces made of organic materials. That is, the inventors found that, when fine metal surfaces can be discretely arranged at a sufficiently high area density onto the surfaces made of organic materials, the fine metal surfaces substantially function equally with a uniform metal film surface. The inventors found that, an approach for achieving the above situation, the state where metal fine particles are closely arranged at a high area density onto a surface of an adhesive layer with the clean metal surfaces thereof being exposed onto the surface can be used for example. Specifically, the inventors found that an approach can be used in which metal fine particles having a covering molecule layer on the individual surface thereof are closely arranged at a high area density on a surface of an adhesive layer, and then an energy beam is irradiated from the surface to detach the covering molecule layer and form a metal oxide film on the outermost surfaces of the metal fine particles once, which is reduced in an electroless plating solution to obtain the nuclei having clean metal surfaces on the surfaces thereof.

That is, when a predetermined energy beam is irradiated to the state where metal fine particles are closely arranged at a high area density on a surface of an adhesive layer, the nuclei having clean metal surfaces on the surfaces thereof are selectively formed to the energy beam irradiated region, and in corresponding to the formation, the precipitation of an electroless plated metal layer is enhanced only at the region. In addition, the inventors confirmed that a resin mixture which comprises metal fine particles uniformly dispersed in a curable binder resin composition can be coated in a flat shape and a film thickness as desired to form a coating layer, and if the contained curable binder resin are not subjected to a curing treatment, the coating layer itself plastically deforms by following deformation of a substrate when the substrate itself is subjected to a deforming process such as bending deformation. It was also confirmed that, the film thickness of the coating layer is changed by the plastic deformation of the coating layer itself, but the area density of the metal fine particles arranged on the surface can be almost the same as that before the deformation. That is, it was also confirmed that even after a substrate itself is subjected to a deforming process such as bending deformation, the coating layer of a resin mixture which is formed on the surface of the substrate remains closely adhered to the board surface after the deforming process, and that both in the flat region and the deformed region, the coating layer surface comprises metal fine particles which are closely arranged at a high area density thereto.

Based on the above described findings, the inventors of the present invention have come to complete the present invention, particularly, an invention of a conductive circuit manufacturing method according to a first approach as one of the approaches that use a mechanism in which metal fine particles having a covering molecule layer to the individual surface thereof are closely arranged at a high area density on a surface of an adhesive layer, and then an energy beam is irradiated from the surface to detach the covering molecule layer and form a metal oxide film on the outermost surfaces of the metal fine particles once, which is reduced in an electroless plating solution to obtain the nuclei having clean metal surfaces on the surfaces thereof.

That is, a conductive circuit manufacturing method according to a first approach of the present invention is a method for forming a conductive circuit on a surface of a three dimensionally deformed non-conductive substrate, which method comprises:
a step for coating a resin mixture comprising metal fine particles of an average particle size of 1 to 200 nm uniformly which are dispersed in a curable binder resin composition on a surface of the non-conductive substrate having a flat shape to form a coating layer of the resin mixture;
a step for heating the coating layer at a low temperature for prebaking; a step for irradiating an energy beam to the surface of the resin mixture coating layer;
a step for performing a deforming operation in three dimensions to the non-conductive substrate having the flat shape, on and the surface of which the resin mixture coating layer is formed;
a step for selectively forming an electroless plated layer only to the surface portion where the energy beam is irradiated in the resin mixture coating layer formed on the surface of the non-conductive substrate, by applying electroless plating to the surface of the non-conductive substrate to which the deforming operation in three dimensions is performed; and
a step for heating the non-conductive substrate having the electroless plated layer conductive layer for curing of the resin mixture coating layer, and
thereby, a conductive circuit having a predetermined pattern which is made of the electroless plated layer is formed onto the surface of the three dimensionally deformed non-conductive substrate.

For example, a conductive circuit manufacturing method according to a first approach of the present invention can be preferably used when the deforming operation in three dimensions is performed to form a curved surface. In the operation, the curved non-conductive substrate surface formed by the curved surface formation preferably has a radius of curvature in a range of 5 mm to 1 m.

Also, preferably, the non-conductive substrate to which the deforming operation in three dimensions is performed has a thickness in a range of 0.1 mm to 1 cm, and the curved non-conductive substrate surface formed by the curved surface formation is selected so that the ratio of a radius of curvature of the non-conductive substrate surface to a thickness of the non-conductive substrate is 10 or more.

The conductive circuit manufacturing method according to the first approach of the present invention can be preferably used when the deforming operation in three dimensions is performed to form a bended shape at a predetermined angle between surfaces. In the operation, the bended shape has an angle between surfaces at the corners thereof which is preferably selected to be in a range of 60 to 160 ° or from 200 to 300 °.

In the conductive circuit manufacturing method according to the first approach of the present invention, the material of the non-conductive substrate is desirably selected from the group consisting of polyimide, polycarbonate, polyacetal, polyphenylene ether (PPE), polybutylene terephthalate (PPB), polyamide imide, fluorocarbon polymer, polyalylate, polysulfone, polyphenylene sulfide, and polyether ether ketone.

Also, the inventors of the present invention found that the mechanism described below can be used as well as the above described mechanism, that is, in which metal fine particles having a covering molecule layer to the individual surface thereof are closely arranged at a high area density on a surface of an adhesive layer, and then an energy beam is irradiated from the surface to detach the covering molecule layer and form a metal oxide film on the outermost surfaces of the metal fine particles once, which are reduced in an electroless plating solution to obtain the nuclei having clean metal surfaces on the surfaces thereof.

The inventors found that an approach can be used in which, without using the metal fine particles having a covering molecule layer to the individual surface thereof, a organic metal compound in fine powder form is closely arranged at a high area density on a surface of an adhesive layer, and the metal ion species contained in the organic metal compound are once converted to fine particles of metal oxides, which are reduced in an electroless plating solution to obtain the nuclei having clean metal surfaces on the surfaces thereof. The process for once converting the metal ion species contained in the organic metal compound to fine particles of metal oxides is performed by irradiating an energy beam from the surface to detach the organic material component of the organic metal compound and convert the remained metal ion species to metal oxides to be aggregated as fine particles of the metal oxides. The fine particles of the metal oxides are fixedly attached to the surface of an adhesive layer once, but the metal oxide fine particles are reduced in an electroless plating solution to be the nuclei having clean metal surfaces.

It was confirmed that the above described two steps for the induction by an energy beam irradiation and the conversion to metal oxides are performed using a transition to an excited electronic state which is caused by the energy beam irradiation, and the energy of the energy beam, when photoexcitation is used, is an energy of an ultraviolet ray region within a wavelength range from 180 nm or more to 400 nm or less, or an energy of a visible light region within a wavelength range from 400 nm to 600 nm, and when excitation by particle beam bombardment is used, an electron beam of 40 keV or more can be used.

That is, when a predetermined energy beam is irradiated to the state where metal fine particles are closely arranged at a high area density on a surface of an adhesive layer or a organic metal compound in fine power form is closely arranged at a high area density on a surface of an adhesive layer, the nuclei having clean metal surfaces on the surfaces thereof are selectively formed to the energy beam irradiated region, and in corresponding to the formation, the precipitation of an electroless plated metal layer is actually enhanced only at the region. Based on the above finding, the inventors of the present invention have come to complete the present invention, particularly, an invention of a conductive circuit manufacturing method according to a second approach.

The invention of a conductive circuit manufacturing method according to the second approach of the present invention can be divided into the following four types of embodiments.

That is, a first embodiment of the conductive circuit manufacturing method according to the second approach of the present invention is a method for forming a conductive circuit on a surface of a non-conductive substrate, which method comprises:
a step for coating a resin mixture comprising metal fine particles of an average particle size of 1 to 200 nm uniformly which are dispersed in a curable binder resin composition on a surface of the non-conductive substrate to form a coating layer of the resin mixture;
a step for irradiating an energy beam to the surface of the resin mixture coating layer;
a step for performing a deforming operation in three dimensions to the non-conductive substrate, on the surface of which the resin mixture coating layer is formed; and
a step for applying electroless plating to the surface of the non-conductive substrate to which the deforming operation in three dimensions is performed, and
an electroless plated layer is selectively formed by applying the electroless plating onto the surface portion where the energy beam is irradiated in the resin mixture coating layer which is formed on the surface of the non-conductive substrate, so that the conductive circuit is formed in a predetermined pattern using the electroless plated layer as a conductive layer. The metal composing the metal fine particles is desirably a metal species or an alloy consisting of two or more metal species which is selected from the group consisting of Pd, Ag, Cu, Au, Pt, Zn, Cr, Fe, and Ni. Particularly, the metal fine particles are preferably those which are selected to have an average particle size within a range of 1 to 70 nm.

Meanwhile, the curable binder resin may be a thermosetting resin or a photo-curable resin. For example, the curable binder resin may be preferably an epoxy resin or an alkyd resin.

The energy beam used in the energy beam irradiation step is desirably an electron beam or an ultraviolet ray.

The metal species used in the electroless plated layer is preferably a metal selected from the group consisting of Pd, Ag, Cu, Au, Pt, Zn, Cr, Fe, and Ni.

A second embodiment of the conductive circuit manufacturing method according to the second approach of the present invention is a method for forming a conductive circuit on a surface of a non-conductive substrate, which method comprises:
a step for coating a resin mixture comprising an organic metal compound which is uniformly dispersed in a curable binder resin composition on a surface of the non-conductive substrate to form a coating layer of the resin mixture;
a step for irradiating an energy beam to the surface of the resin mixture coating layer;
a step for performing a deforming operation in three dimensions to the non-conductive substrate, on the surface of which the resin mixture coating layer is formed; and
a step for applying electroless plating to the surface of the non-conductive substrate to which the deforming operation in three dimensions is performed, and
an electroless plated layer is selectively formed by applying the electroless plating onto the surface portion where the energy beam is irradiated in the resin mixture coating layer which is formed on the surface of the non-conductive substrate, so that the conductive circuit is formed in a predetermined pattern using the electroless plated layer as a conductive layer. As the organic metal compound, a metal salt of organic acid or an organometallic complex may be preferably used. The metal species contained in the organic metal compound is preferably a metal selected from the group consisting of Pd, Ag, Cu, Au, Pt, Zn, Cr, Fe, and Ni.

As the curable binder resin, a thermosetting resin or a photo-curable resin may be used. For example, an epoxy resin or an alkyd resin may be preferably used as the curable binder resin.

The energy beam used in the energy beam irradiation step is desirably an electron beam or an ultraviolet ray.

The metal species used in the electroless plated layer is preferably a metal selected from the group consisting of Pd, Ag, Cu, Au, Pt, Zn, Cr, Fe, and Ni.

Furthermore, a third embodiment of the conductive circuit manufacturing method according to the second approach of the present invention which has a similar constitution to that of the first embodiment of the second approach of the present invention is a method for forming a conductive circuit on a surface of a non-conductive substrate, which method comprises:
a step for coating a resin mixture comprising metal fine particles of an average particle size of 1 to 200 nm uniformly which are dispersed in a curable binder resin composition on a surface of the non-conductive substrate to form a coating layer of the resin mixture;
a step for irradiating an energy beam to the surface of the resin mixture coating layer; and
a step for applying electroless plating to the surface of the non-conductive substrate, and
an electroless plated layer is selectively formed by applying the electroless plating onto the surface portion where the energy beam is irradiated in the resin mixture coating layer which is formed on the surface of the non-conductive substrate, so that the conductive circuit is formed in a predetermined pattern using the electroless plated layer as a conductive layer. The metal composing the metal fine particles is desirably a metal species or an alloy consisting of two or more metal species selected from the group consisting of Pd, Ag, Cu, Au, Pt, Zn, Cr, Fe, and Ni. Particularly, the metal fine particles are preferably those which are selected to have an average particle size in a range of 1 to 70 nm.

Meanwhile, as the curable binder resin, a thermosetting resin or a photo-curable resin may be used. For example, an epoxy resin or an alkyd resin may be preferably used as the curable binder resin.

The energy beam used in the energy beam irradiation step is desirably an electron beam or an ultraviolet ray.

The metal species used in the electroless plated layer is preferably a metal selected from the group consisting of Pd, Ag, Cu, Au, Pt, Zn, Cr, Fe, and Ni.

When a coating layer of the resin mixture is formed, the shape of the coating layer may be formed by drawing in the predetermined pattern, and used as the drawing method may be such a printing method selected from the group consisting of screen printing, inkjet printing, and transfer printing.

In addition, a fourth embodiment of the conductive circuit manufacturing method according to the second approach of the present invention which has a similar constitution to that of the second embodiment of the second approach of the present invention is a method for forming a conductive circuit on a surface of a non-conductive substrate, which method comprises:
a step for coating a resin mixture comprising an organic metal compound which is uniformly dispersed in a curable binder resin composition on a surface of the non-conductive substrate to form a coating layer of the resin mixture;
a step for irradiating an energy beam to the surface of the resin mixture coating layer; and
a step for applying electroless plating to the surface of the non-conductive substrate, and
an electroless plated layer is selectively formed by applying the electroless plating onto the surface portion where the energy beam is irradiated in the resin mixture coating layer which is formed on the surface of the non-conductive substrate, so that the conductive circuit is formed in a predetermined pattern using the electroless plated layer as a conductive layer. As the organic metal compound, a metal salt of organic acid or an organometallic complex may be preferably used. The metal species contained in the organic metal compound is preferably a metal selected from the group consisting of Pd, Ag, Cu, Au, Pt, Zn, Cr, Fe, and Ni.

As the curable binder resin, a thermosetting resin or a photo-curable resin may be used. For example, an epoxy resin or an alkyd resin may be preferably used as the curable binder resin.

The energy beam used in the energy beam irradiation step is desirably an electron beam or an ultraviolet ray.

The metal species used in the electroless plated layer is preferably a metal selected from the group consisting of Pd, Ag, Cu, Au, Pt, Zn, Cr, Fe, and Ni.

When a coating layer of the resin mixture is formed, the shape of the coating layer may be formed by drawing in the predetermined pattern, and used as the drawing method may be such a printing method selected from the group consisting of screen printing, inkjet printing and transfer printing.

Furthermore, the inventors of the present invention focused their attention on the fact that, instead of using an adhesive layer of a curable binder resin formed on a surface of non-conductive substrate so as to obtain the state where metal fine particles which have an average particle size of 1 to 200 nm or an organic metal compound in fine powder form are closely exposed at a high area density on the surface of the adhesive layer, which is used in the above second approach, even when a non-conductive substrate made of a non-conductive material is used which material comprises metal fine particles of an average particle size of 1 to 200 nm or fine particles of an organic metal compound uniformly dispersed in a non-conductive resin composition, a state where the metal fine particles which have an average particle size of 1 to 200 nm or the fine particles of an organic metal compound are closely exposed at a high area density on the surface of the non-conductive substrate can be obtained. It was found that when metal fine particles which have a covering molecule layer on the individual surface thereof are used as the metal fine particles of an average particle size of 1 to 200 nm which are dispersed in the non-conductive substrate itself to be exposed on the surface of the non-conductive substrate, an irradiation of an energy beam from the surface of the non-conductive substrate causes the covering molecule layer to be detached and a metal oxide film to be formed on the outermost surfaces of the metal fine particles once, and then the metal oxide film can be reduced in an electroless plating solution to obtain the nuclei having clean metal surfaces on the surfaces thereof.

Also, it was found that the fine particles of an organic metal compound which are exposed on the surface of the non-conductive substrate can be the nuclei having clean metal surfaces on the surfaces thereof by converting the metal ion species contained in the organic metal compound to the metal oxide fine particles once and reducing the metal oxide fine particles in an electroless plating solution. The step for once converting the metal ion species contained in the organic metal compound to fine particles of metal oxides is performed by irradiating an energy beam from the surface to detach the organic material component of the organic metal compound and convert the remained metal ion species to metal oxides to be aggregated as fine particles of the metal oxides. The fine particles of the metal oxides are fixedly attached to the surface of an adhesive layer once, but the metal oxide fine particles are reduced in an electroless plating solution to be the nuclei having clean metal surfaces.

It was confirmed that the above described two steps for the induction by an energy beam irradiation and the conversion to metal oxides are performed using a transition to an excited electronic state which is caused by the energy beam irradiation, and the energy of the energy beam, when photoexcitation is used, is an energy of an ultraviolet ray region within a wavelength range from 180 nm or more to 400 nm or less, or an energy of a visible light region within a wavelength range from 400 nm to 600 nm, and when excitation by particle beam bombardment is used, an electron beam of 40 keV or more can be used.

That is, when a non-conductive substrate formed of a non-conductive material which comprises metal fine particles of an average particle size of 1 to 200 nm or fine particles of an organic metal compound uniformly dispersed in a non-conductive resin composition is used, a state can be obtained where the metal fine particles are closely arranged at a high area density or fine particles of an organic metal compound are closely arranged at a high area density on a surface of the non-conductive substrate, and when a predetermined energy beam is irradiated to the state, the nuclei having clean metal surfaces on the surfaces thereof are selectively formed to the energy beam irradiated region, and in corresponding to the formation, the precipitation of an electroless plated metal layer is actually enhanced only at the region.

When a non-conductive resin which can be deformed in three dimensions is used as the non-conductive resin composition which is used in manufacturing a non-conductive substrate, after an the energy beam is irradiated at a desired region of a surface of the non-conductive substrate, a three dimensional deforming operation is performed, and then electroless plating is applied, an electroless plated layer can be selectively formed at the portion of the surface of the non-conductive substrate where the energy beam is irradiated.

Particularly, a non-conductive resin material which is used in manufacturing a non-conductive substrate itself is used as means for fixing the metal fine particles which have an average particle size of 1 to 200 nm or fine particles of an organic metal compound to a surface of the non-conductive substrate, while a curable binder resin having a small film thickness is adhesively bonded to a surface of a non-conductive substrate as an adhesive layer in the first approach and the second approach. Therefore, the metal fine particles or fine particles of an organic metal compound which are exposed on the surface of the non-conductive substrate remain fixed to the surface at a uniform area density when a deforming in three dimensions is performed.

Based on the above finding, the inventors of the present invention have come to complete the present invention, particularly, an invention of a conductive circuit manufacturing method according to a third approach.

The invention of a conductive circuit manufacturing method according to the third approach of the present invention can be divided into the following two types of forms.

That is, a first embodiment of a conductive circuit manufacturing method according to a third approach of the present invention is a method for forming a conductive circuit on a surface of a non-conductive substrate, which non-conductive substrate is a substrate formed of a non-conductive material that comprises metal fine particles of an average particle size of 1 to 200 nm or fine particles of an organic metal compound uniformly dispersed in a non-conductive resin composition, which method comprises:
a step for irradiating an energy beam only to a portion of the surface of the non-conductive substrate where the conductive circuit is formed;
a step for performing a deforming operation in three dimensions to the non-conductive substrate; and
a step for applying electroless plating to the surface of the non-conductive substrate to which the deforming operation in three dimensions is performed, and
the electroless plating is applied to selectively form an electroless plated layer at the portion of the surface of the non-conductive substrate where the energy beam is irradiated, so that the conductive circuit is formed in a predetermined pattern using the electroless plated layer as a conductive layer. The metal fine particles uniformly dispersed in the non-conductive resin composition are preferably fine particles of a metal species or fine particles of an alloy consisting of two or more metal species selected from the group consisting of gold, silver, copper, platinum, palladium, zinc, iron, chromium, and nickel. While, the non-conductive material used in forming the non-conductive substrate preferably comprises a polyimide resin as a main component among resin components of the non-conductive resin composition.

The energy beam used in the energy beam irradiation step is desirably an electron beam or an ultraviolet ray.

For example, an aspect in which the deforming operation in three dimensions to the non-conductive substrate is embossing may be selected.

The metal species used in forming the electroless plated layer is preferably a metal selected from the group consisting of gold, silver, copper, platinum, palladium, zinc, iron, chromium, and nickel.

A second embodiment of the conductive circuit manufacturing method according to the third approach of the present invention is a method for forming a conductive circuit on a surface of a non-conductive substrate, which non-conductive substrate is a substrate formed of a non-conductive material that comprises fine particles of an organic metal compound uniformly dispersed in a non-conductive resin composition, which method comprises:
a step for irradiating an energy beam only to a portion of the surface of the non-conductive substrate where the conductive circuit is formed;
a step for performing a deforming operation in three dimensions to the non-conductive substrate; and
a step for applying electroless plating to the surface of the non-conductive substrate to which the deforming operation in three dimensions is performed, and
the electroless plating is applied to selectively form an electroless plated layer at the portion of the surface of the non-conductive substrate where the energy beam is irradiated, so that the conductive circuit is formed in a predetermined pattern using the electroless plated layer as a conductive layer. The organic metal compound of the fine particles of an organic metal compound is preferably selected from a metal salt of organic acid or an organometallic complex. In addition, the metal species contained in the organic metal compound of the organic metal compound fine particles which are exposed on the surface of the non-conductive substrate are preferably fine particles of a metal species or two or more species selected from the group consisting of gold, silver, copper, platinum, palladium, zinc, iron, chromium, and nickel. While, the non-conductive material used in forming the non-conductive substrate preferably comprises a polyimide resin as a main component among resin components of the non-conductive resin composition.

The energy beam used in the energy beam irradiation step is desirably an electron beam or an ultraviolet ray.

For example, an aspect in which the deforming operation in three dimensions to the non-conductive substrate is embossing may be selected.

The metal species used in forming the electroless plated layer is preferably a metal selected from the group consisting of gold, silver, copper, platinum, palladium, zinc, iron, chromium, and nickel.

### Effect of the Invention

In a conductive circuit manufacturing method according to a first approach of the present invention, instead of forming a selective plated metal layer by means of a plating mask layer, an adhesive layer of a curable binder resin is provided on a surface of a non-conductive substrate to obtain a state where metal fine particles which have an average particle size of 1 to 200 nm are closely exposed on the surface at a high area density, and an energy beam is irradiated to a desired region corresponding to the shape of a circuit pattern to apply an electroless plating treatment, so that, only at the surface region of the adhesive layer where the energy beam is irradiated, the clean fine metal surfaces that function as nuclei for precipitation of metal atoms can be generated in an electroless plating solution. As a result, an electroless plating metal layer can be selectively formed only at the region where the energy beam is irradiated. The electroless plating metal layer selectively formed corresponding to the desired shape of the circuit pattern directly contacts with a surface of an adhesive layer of a curable binder resin, and is fixedly attached to a surface of a non-conductive substrate via the adhesive layer with a high adhesion. Particularly, a resin mixture comprising metal fine particles uniformly dispersed in a curable binder resin composition is coated on a surface of a non-conductive substrate, and an energy beam is irradiated in advance to a desired region of the coating film corresponding to the shape of a circuit pattern and the a deforming process is performed to the non-conductive substrate having the coating film formed thereon, so that the coating film is plastically deformed as the non-conductive substrate is deformed, which generates a state where metal fine particles which have an average particle size of 1 to 200 nm are closely exposed on the surface at a high area density. Therefore, an electroless plating metal layer can be selectively formed only to the region where an energy beam is irradiated by irradiating the energy beam in advance to a desired region of a surface of the non-flat non-conductive substrate corresponding to the shape of a circuit pattern.

Moreover, in a conductive circuit manufacturing method according to the second approach of the present invention, instead of forming a selective plated metal layer by means of a plating mask layer, an adhesive layer of a curable binder resin is provided on a surface of a non-conductive substrate to obtain a state where metal fine particles which have an average particle size of 1 to 200 nm or organic metal compound in fine powder form are closely exposed on the surface at a high area density, and an energy beam is irradiated from a desired region corresponding to the shape of a circuit pattern to apply an electroless plating treatment, so that, only at the surface region of the adhesive layer where the energy beam is irradiated, the clean fine metal surfaces that function as nuclei for precipitation of metal atoms can be generated in an electroless plating solution. As a result, an electroless plating metal layer can be selectively formed only at the region where the energy beam is irradiated. The electroless plating metal layer selectively formed corresponding to the desired shape of the circuit pattern directly contacts with a surface of an adhesive layer of a curable binder resin, and is fixedly attached to a surface of a non-conductive substrate via the adhesive layer with a high adhesion.

Furthermore, in a conductive circuit manufacturing method according to a third approach of the present invention, instead of forming a selective plated metal layer by means of a plating mask layer, a non-conductive substrate composed of a non-conductive material which comprises metal fine particles of an average particle size of 1 to 200 nm or fine particles of an organic metal compound uniformly dispersed in a non-conductive resin composition is used to obtain a state where the metal fine particles which have an average particle size of 1 to 200 nm or fine particles of an organic metal compound are closely exposed on the surface at a high area density, and an energy beam is irradiated to a desired region corresponding to the shape of a circuit pattern to apply an electroless plating treatment, so that, only at the surface region of the adhesive layer where the energy beam is irradiated, the clean fine metal surfaces that function as nuclei for precipitation of metal atoms can be generated in an electroless plating solution. As a result, an electroless plating metal layer can be selectively formed only at the region where the energy beam is irradiated.

### Brief Description of the Drawing

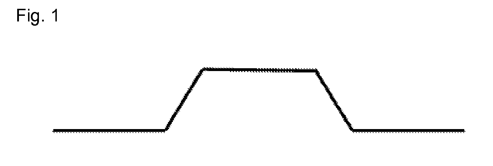

Figure 1 is a schematic view showing an outer shape of a non-conductive substrate after a deforming process is performed thereto, the substrate being used in the experiments for verification in Example 1-2, Examples 1-3 to 1-8, and Example 3-1.

### Best Mode for Carrying Out the Invention

Now, a conductive circuit manufacturing method according to the present invention will be explained in detail below.

First, the present invention also uses the nature of metal atoms that the generated metal atoms selectively precipitate onto metal surfaces that function as nuclei in an electroless plating treatment. In conventional approaches, a plated metal layer is formed by enhancing the precipitation of metal atoms on a surface of a metal film for plating which is exposed at an opening while avoiding the precipitation of metal atoms on the surface of the plating mask layer of a photoresist film.

The present invention was made by paying attention on the fact that, in a careful observation of a surface of a metal film for plating, a plated metal layer is formed when discretely distributed metal particles are closely coupled to each other and eventually make up a generally homogeneous particle aggregate layer. That is, metal atoms do not uniformly precipitate onto the entire surface of a metal film for plating to form a layer, but at an initial stage, fine metal clusters are formed to be discretely distributed nuclei, and then the precipitation of the metal atoms is enhanced to cover the clean surfaces of the formed metal clusters. At a certain stage, when the surfaces of the adjacent metal clusters contact with each other, the metal atoms precipitate to surround the plurality of contacted metal clusters, which causes metal particles to be closely coupled in two dimensions to form a homogeneous particle aggregate layer.

In other words, when fine metal surfaces that function as nuclei for the precipitation of metal atoms are arranged discretely but at a sufficient high area density, from the discrete nuclei working as starting points, fine metal clusters are closely generated, and eventually make up a generally homogeneous particle aggregate layer in which the metal particles are closely coupled in two dimensions. The present invention is also based on the idea that the regions between the fine metal surface portions which are discretely arranged at a sufficiently high area density may be made of organic materials because the surfaces are not involved in the precipitation of the metal atoms.

### I. First Approach

That is, in an approach of the present invention, instead of using a uniform metal film, fine metal surface portions are discretely arranged on a surface made of organic materials at a sufficiently high area density to obtain the substantially same function as that of a uniform metal film surface. As an approach to achieve the above situation, in a first approach of the present invention, a state is obtained where metal fine particles are closely arranged at a high area density on a surface of an adhesive layer, with the metal fine particles arranged on the surface exposing clean metal surfaces on the surfaces thereof. Specifically, in the first approach of the present invention, metal fine particles having a covering molecule layer to the individual surface thereof are closely arranged at a high area density on a surface of an adhesive layer, and then an energy beam is irradiated from the surface to detach covering molecule layers and individually form a metal oxide film on the outermost surface of the metal fine particles once. Then, when a deforming process is performed to the non-conductive substrate having an adhesive layer thereon which has a plastic deformability, the adhesive layer is plastically deformed as the board is deformed, but the state is maintained where the metal fine particles the outermost surface of which have metal oxide films formed thereon once are closely arranged at a high area density on the surface of the adhesive layer. The metal fine particles are reduced in an electroless plating solution to obtain the nuclei having clean metal surfaces on the surfaces thereof.

In addition, in the first approach of the present invention, the steps for the detachment of covering molecule layers which is induced by an energy beam irradiation and the generation of metal oxide films upon the outermost surface of metal fine particles are performed using a transition to an excited electronic state which is caused by the energy beam irradiation, and the energy of the energy beam, when photoexcitation is used, is an energy of an ultraviolet ray region within a wavelength range from 180 nm or more to 400 nm or less, or an energy of a visible light region within a wavelength range from 400 nm to 600 nm, and when excitation by particle beam bombardment is used, an electron beam of 40 keV or more can be used.

That is, in a state where metal fine particles are closely arranged on a surface of an adhesive layer at a high area density, when a predetermined energy beam is irradiated, the nuclei having clean metal surfaces on the surfaces thereof are selectively formed to the energy beam irradiated region, and in corresponding to the formation, the precipitation of an electroless plated metal layer is actually enhanced only at the region. In the present invention, the shape pattern of the region where the energy beam is irradiated is determined in advance, which allows the simple control of the formation of an electroless plated layer in an intended pattern shape.

That is, in a conductive circuit manufacturing method according to the first approach of the present invention, as means for selectively forming an electroless plated layer of a desired pattern shape on a surface of a non-conductive substrate, an approach is used in which a coating layer of a resin mixture comprising metal fine particles of an average particle size of 1 to 200 nm uniformly dispersed in a curable binder resin composition is formed, and an energy beam is irradiated from a region of the surface of the resin mixture coating layer corresponding to the pattern shape, which is immersed in an electroless plating solution to apply electroless plating so that an electroless plated layer is selectively formed on the surface portion where the energy beam is irradiated.

In a conductive circuit manufacturing method according to the first approach of the present invention, after a resin mixture coating layer is formed on a surface of a non-conductive substrate, an energy beam is irradiated to the surface of the resin mixture coating layer corresponding to a desired pattern. Subsequently, an operation is performed to deform the non-conductive substrate together with the resin mixture coating layer formed on the surface thereof in three dimensions to have an intended shape. That is, since the resin mixture coating layer formed on the surface is not subjected to a curing treatment yet at this point of time, a deforming of the non-conductive substrate in three dimensions causes the resin mixture coating layer to be similarly deformed in three dimensions. Specifically, the resin mixture coating layer which is formed on the surface of non-conductive substrate by coating a resin mixture at a uniform film thickness is subjected to heating at a low temperature and prebaking (drying treatment) for evaporating solvent components contained therein. The resin mixture coating film after the drying treatment contains a compound of resin raw materials before a polymerization treatment as its main component, which is in a state having a higher plastic deformability than that of the material of the non-conductive substrate. So, when the non-conductive substrate is subjected to an operation of deforming in three dimensions to be plastically deformed, the resin mixture coating layer on the surface follows the deformation to be plastically deformed, resulting in that the resin mixture coating layer is similarly deformed in three dimensions. For example, when a deforming process is performed for deforming a non-conductive substrate to have a curved shape having a desired curvature, the outer side of the curved surface is strechedly deformed and the inner side of the curved surface is compressedly deformed in inverse proportion to the radius of curvature. In the deformation, when a resin mixture coating layer is coated on the outer side of the curved surface, the resin mixture coating layer is strechedly deformed at the almost same ratio, which makes the thickness of the coating layer smaller. While, when a resin mixture coating layer is coated on the inner side of the curved surface, the resin mixture coating layer is compressedly deformed at the almost same ratio, which makes the thickness of the coating layer larger.

In the above described step for heating at a low temperature and prebaking (drying treatment), a conditions and a temperature are conveniently selected to enhance the evaporation of contained solvent components but not to enhance polymerization of the curable binder resin. Therefore, the temperature for drying treatment (prebaking) is selected to be significantly lower than that at which polymerization of the curable binder resin is carried out. Typically, the temperature which is lower by 10 °C or more than that at which polymerization of the curable binder resin is carried out is preferably selected.

In the resin mixture coating layer on the surface subjected to the treatment of the drying treatment (prebaking) after the coating of the resin mixture, the dispersoid metal fine particles which have an average particle size of 1 to 200 nm remained in the uniformly dispersed state in the dried curable binder resin composition. While, as the plastic deformations of the resin mixture coating layer which are caused by the deforming operation in three dimensions which is performed to the non-conductive substrate, for example, when a non-conductive substrate having a thickness t is bendingly deformed and the curved surface of the deformed portion has a radius of curvature R_{bend}, stretched deformation is formed on the convex surface side at a stretch ratio: 1 + (t/R_{bend}), while stretched deformation is formed on the concave surface side at a compression ratio: 1 - (t/R_{bend}). That is, the film thickness d of the resin mixture coating layer on the surface changes to be (d - Δd) or (d + Δd) in inverse proportion to the stretch ratio: 1 + (t/R_{bend}) or the compression ratio: 1 - (t/R_{bend}). The change rate (Δd/d) of the thickness d of the resin mixture coating layer film is calculated as (Δd/d) ≒ (t/R_{bend}). The change rate (Δd/d) of the thickness d of the resin mixture coating layer film is desirably at least 1 /10 or less and more preferably 1/50 or less. In other words, the ratio: t/R_{bend} between the thickness t of the non-conductive substrate and the radius of curvature R_{bend} of the curved surface of the deformed portion is desirably selected to be at least 1/10 or less, and more preferably 1/50 or less. However, an extremely small thickness t of the non-conductive substrate often reduces its actual mechanical strength, and so typically, the ratio: t/R_{bend} between the thickness t of the non-conductive substrate and the radius of curvature R_{bend} of the curved surface of the deformed portion is preferably selected to be 1/500 or more. For example, the thickness t is desirably selected to be in a range of 2 mm ≦ t ≦ 10 mm for the curvature R_{bend} = 1000 mm (1 m), while the thickness t is desirably selected to be in a range of 0.1 mm ≦ t ≦ 0.5 mm for the curvature R_{bend} = 5 mm.

One example of the operation for deforming a non-conductive substrate in three dimensions may be formation of curved surface in which a flat predetermined region of a surface is plastically deformed into a curved surface shape. The curved surface shape of the non-conductive substrate surface which is formed by the curved surface forming need not to have a constant radius of curvature, but the local radius of curvature at each portion on the curved surface is desirably in a range of 5 mm to 1 m. The local radius of curvature at each point corresponds to the radius of a sphere or cylinder, when the curved surface shape which is close to the point is approximated using a sphere or cylinder respectively.

Another example of the operation for deforming a non-conductive substrate in three dimensions may be a forming of a bended shape at a predetermined angle between surfaces. In the forming of a bended shape, the corner can be locally considered to have a shape having two crossing surfaces at a predetermined angle. Microscopically, the corner is configured with a curved surface having a predetermined curvature, and can be considered to be a corner subjected to a so-called round processing. The bended level of the corner can be expressed by an angle between the two surfaces, and is preferably selected to be in a range of 60 to 160 ° or from 200 to 300°. As for the microscopic radius of curvature at the corner having the angle between surfaces, the ratio: t/R_{bend} between the thickness t of the non-conductive substrate and the radius of curvature R_{bend} of the curved surface of the deformed portion is desirably selected to be at least 1/10 or less, and more preferably 1/50 or less.

In a conductive circuit manufacturing method according to the first approach of the present invention, the thickness t of a non-conductive substrate to which the deforming operation in three dimensions is performed is selected to be in a range which allows the non-conductive substrate to have a mechanical strength to keep an intended outer shape. Desirably, in the intended outer shape, the thickness t of a used non-conductive substrate is conveniently selected from a range of 0.1 mm to 1 cm so that the ratio t/R_{bend} to a local radius of curvature R_{bend} may be preferably in a range 1/10 or less or 1/50 or less.

Meanwhile, plastic deformation of the resin mixture coating layer is caused by the deforming operation in three dimensions which is performed to the non-conductive substrate, and the size of the resin mixture coating layer before the process is desirably adjusted so that the resin mixture coating layer may have a film thickness in a range of 0.1 µm to 20 µm after deforming process.

A resin mixture which is adjusted to have an appropriate solution viscosity by adding a solvent thereto is coated onto a surface of the non-conductive substrate having a flat surface using various printing means to form a resin mixture coating layer in an intended pattern shape, which is subjected to a prebaking treatment at a low temperature. While being heated at a low temperature, most of the solvent components contained in the resin mixture are evaporated. When the prebaking treatment (drying treatment) is completed, on a surface of the resin mixture coating layer after the drying treatment, the metal fine particles which have a covering molecule layer on the individual surface thereof are uniformly dispersed in the mixture which contains the compound of resin raw materials as a main component before a polymerization treatment, and the metal fine particles are exposed on the dried coating layer surface at a desired area density. It is desirable to use a mode for irradiating an energy beam to the entire surface of the resin mixture coating layer which is coated and formed in the intended pattern shape and is subjected to the drying treatment. In the present invention, it is most preferable to select a mode for performing the prebaking treatment (drying treatment) and the energy beam irradiation treatment after a resin mixture coating layer is formed in an intended pattern shape in advance.

Alternatively, depending on the kind of a compound of resin raw material used therein, a resin mixture is coated to cover the entire surface of a non-conductive substrate having a flat surface, and the coated resin mixture coating layer is subjected to a prebaking treatment at a low temperature. When the prebaking treatment (drying treatment) is completed, a mode can be used for performing an insolubilizing treatment to a certain solvent to the compound of resin raw materials before the polymerization treatment in the irradiated region by irradiating an energy beam to a surface of the resin mixture coating layer after the drying treatment corresponding to the intended pattern shape. As a result, the region of the resin mixture coating layer where the energy beam is not irradiated has solubility to the certain solvent, resulting in that a rinsing and removing treatment (developing treatment) using the solvent causes the resin mixture coating layer in the intended pattern shape to be remained. After the coating to the entire surface and the drying treatment, a mode for performing an insolubilizing treatment using an energy beam irradiation corresponding to an intended pattern shape (pattern exposure) and a subsequent treatment (developing treatment) for solving and removing the non-irradiated region (non-exposed region) using a solvent may be useful depending on the kind of a used compound of resin raw material.

When a resin mixture is used to which an insolubilizing treatment using an energy beam irradiation can be performed, a coating film which has an intended pattern shape and a substantially uniform film thickness can be formed by a similar procedure on a surface of a non-conductive substrate to which various deforming processes are performed to form various surface shapes in advance, as well as a non-conductive substrate having a flat surface. That is, a mode can be used in which, after the coating film of the resin mixture which is coated onto a surface of a non-conductive substrate having various surface shapes is subjected to a drying treatment (prebaking treatment), an energy beam is irradiated and an insolubilizing treatment is performed to the surface of the resin mixture coating layer corresponding to the desired pattern. Particularly, a mode can be used for writing a desired pattern by directly irradiating an energy beam to a surface of a resin mixture coating layer having various surface shapes corresponding to the pattern using an energy beam in a beam form. Since the region of the resin mixture coating layer where the energy beam is not irradiated has a solubility to the certain solvent, a rinsing treatment(developing treatment) using the solvent causes the resin mixture coating layer of the intended pattern shape to be remained.

Alternatively, a resin mixture coating film having a substantially uniform film thickness can be formed in an intended pattern shape by selectively coating a resin mixture corresponding to a desired pattern on a surface of a non-conductive substrate to which a deforming process is performed in advance to form various surface shapes as an application of an inkjet printing method for example. A mode for entirely irradiating an energy beam to the surface may be used to the resin mixture coating film to cover the entire surface thereof after a drying treatment.

The dispersion density of the metal fine particles of an average particle size of 1 to 200 nm which are dispersed in a resin mixture coating layer that is formed on a non-conductive substrate and subjected to a drying treatment is desirably selected to be in a range of 1.0 × 10¹²/mm³ to 3.5 × 10¹⁴/mm³, that is, in a range of 1.0 × 10³/µm³ to 3.5 × 10⁵/µm³, more preferably, in a range of 5.0 × 10¹²/mm³ to 1.0 × 10¹⁴/mm³, that is, in a range of 5.0 × 10³/µm³ to 1.0 × 10⁵/µm³. Accordingly, the area density of the metal fine particles which are exposed on the coating layer surface is preferably in a range of 1.0 × 10¹µm² to 4 × 10²/µm², more preferably in a range of 0.4 × 10²/µm² to 2 × 10²/µm². That is, assuming that the metal fine particles which are exposed on the coating layer surface are arranged in a square lattice, an average distance between adjacent metal fine particles is preferably from 0.20 µm to 0.07 µm. In the state, using the clean metal surface of the metal fine particles which are exposed on a surface of the coating layer as nuclei, fine metal clusters having an average particle size of 0.5 µm to 4 µm are produced in an electroless plating process, thereby a coating layer is formed by the fine metal clusters as a result of electroless plating to cover the almost entire surface of the resin mixture coating layer. Then, formation of an electroless plating metal layer is enhanced to further cover the coating layer that comprises the fine metal clusters closely distributed across the entire surface thereof, so that, when the electroless plating metal layer has a film thickness of 1 µm, a compact and uniform plated metal layer is formed which is comparable to an electroless plating metal layer which is formed on an underlayer of a metal film having a uniform surface texture.

In a conductive circuit manufacturing method according to the first approach of the present invention, in order to deform a non-conductive substrate in three dimensions, the non-conductive substrate is manufactured by using a material which enables desired plastic deformation of the substrate. Specifically, a non-conductive substrate can be selected from a group of insulation property materials consisting of polyimide, polycarbonate, polyacetal, polyphenylene ether (PPE), polybutylene terephthalate (PPB), polyamide imide, fluorocarbon polymer, polyalylate, polysulfone, polyphenylene sulfide, and polyether ether ketone.

The resin mixture coating layer itself is desirably flat and has a uniform film thickness except the regions of the metal fine particles exposed on the surface thereof. After the formation of a compact and uniform plated metal layer, a heat treatment is performed to the resin mixture coating layer to impart flowability, which allows the binder resin of the resin mixture coating layer to wet contact with the rear surface of the formed plated metal layer. Eventually, the binder resin layer which is formed of a flat resin mixture coating layer having a uniform film thickness has a function to make a plated metal layer fixedly attached to non-conductive substrate surface with a high adhesion.

Therefore, the curable binder resin composition which is blended in a resin mixture as a dispersion medium should be a curable binder resin which has an excellent adhesion property to both of a surface of a non-conductive substrate and a plated metal layer. Specifically, the curable binder resin is desirably a thermosetting resin or photo-curable resin.

When a thermosetting resin is used as the curable binder resin, after an electroless plating metal layer is formed, by performing a heat treatment to the assembly including the non-conductive substrate at a predetermined temperature, a heat curing is effected in a state where the non-conductive substrate surface and the rear surface of the plated metal layer wet contact with each other. In the heat curing treatment, the heat temperature is conveniently selected in consideration with a heat resistance of the material of the non-conductive substrate. Generally, it is desirable to complete a desired heat curing by heat at a temperature of 160 °C or less. Typically, the material of a non-conductive substrate is selected from those which exhibit a sufficient heat resistance at least at a temperature at which a solder material melts so that a conductive circuit enables an application of soldering connection to an electrical connection between wiring of the electroless plated layer and terminals of other electronic parts. The thermosetting resin for forming the binder resin layer is preferably a material which exhibits a sufficient heat resistance at least at a temperature at which a solder material melts.

Therefore, when a thermosetting resin is used as the curable binder resin, for example when a formed plated layer is used to a soldering connection, the resulting cured material desirably exhibits a sufficient heat resistance during heating at least at a temperature 80 °C. For such an application, generally, a thermosetting resin composition is more preferably used which contains an epoxy resin or an alkyd resin having a heat resistance at about 100 °C as a main resin component. Available epoxy resins include bisphenol A epoxy resin. Available alkyd resins include HARIFUTAL (manufactured by Harima Chemicals, Inc.).

The thermosetting resin composition containing an epoxy resin as a main resin component may be a composition which comprises an epoxy resin component, a curing agent or curing catalyst for the epoxy resin, and a curing accelerator as may be needed. The curing agent which can be used in a thermosetting resin composition for an epoxy resin may be an acid anhydride based curing agent, for example phthalic anhydride, and also may be an amine based curing agent, for example an amine adduct compound. In using a curing agent, imidazole or the like may be added as a curing accelerator as may be needed. As a curing catalyst for an epoxy resin, triphenylphosphine or the like may be used.

For example, as for the epoxy resin component, a blending ratio of an acid anhydride based curing agent to an epoxy resin is desirably selected to be the one having dibasic acid anhydride typically in a range of 0.8 to 1.2 molecules, preferably in a range of 0.9 to 1.1 molecules, relative to two epoxy groups in the epoxy resin component. Also, when a curing accelerator is added in addition to the acid anhydride based curing agent, it is desirable to blend the amine based curing accelerator in a range of 0.010 to 0.050 molecule, preferably in a range of 0.015 to 0.040 molecule, relative to two epoxy groups in the epoxy resin component.

As may be needed, an organic solvent for a dilution solvent may be added by an appropriate amount for viscosity adjustment in the thermosetting resin composition which contains an epoxy resin as a main resin component. The thermosetting resin composition which contains an epoxy resin as a main resin component is preferably a composition which retains metal fine particles having an average particle size of 1 to 200 nm, which are contained as dispersoid, in a uniformly dispersed state, and at the same time forms a heat cured material when the organic solvent contained therein is evaporated and removed and a drying treatment and then preferably a heat treatment at a temperature in a range of 50 to 160 °C for 5 to 30 minutes are performed to the thermosetting resin composition.

To the contrary, the thermosetting resin composition containing an alkyd resin as a main resin component may be a composition which comprises an alkyd resin component and a curing accelerator for the alkyd resin. The curing accelerator for the alkyd resin a thermosetting resin composition may be preferably cobalt naphthenate, zirconium naphthenate, or the like which are widely used as a dryer for coating materials. For example, as with the alkyd resin component, a blending ratio of a curing accelerator to an alkyd resin is preferably the one obtained by adding, for example, a compound for the curing accelerator containing cobalt naphthenate of 0.1 parts by mass and zirconium naphthenate of 0.05 parts by mass, to an alkyd resin of 100 parts by mass. In order to obtain a state in which the alkyd resin component and the curing accelerator for the alkyd resin are uniformly blended in the thermosetting resin composition, typically, the curing accelerator of a predetermined amount is added to a solution which contains an organic solvent of an appropriate amount for solving the alkyd resin component. In this case, the thermosetting resin composition which contains an alkyd resin as a main resin component is preferably a composition which retains metal fine particles having an average particle size of 1 to 200 nm, which are contained as dispersoid, in a uniformly dispersed state, and at the same time forms a heat cured material, when the organic solvent contained therein is evaporated and removed and a drying treatment and then preferably a heat treatment a at temperature in a range of 60 to 100 °C for 5 to 30 minutes are performed to the thermosetting resin composition.

Meanwhile when a photo-curable resin is used as the curable binder resin, a procedure for enhancing a photo-curing in advance is used in which, before an electroless plating metal layer is formed, a light having a predetermined energy is irradiated at least to the portion that corresponds to the region where is covered with the formed electroless plating metal layer. For the resin mixture coating layer, a photo-curing of the blended photo-curable resin composition is enhanced in advance, and then an electroless plating process is performed to the surface of the coating layer. After the electroless plating metal layer is formed, a heat treatment is performed to the assembly comprising the non-conductive substrate at a predetermined temperature to obtain a state where a wet contact between the non-conductive substrate surface and the rear surface of the plated metal layer by the photo-curable resin is achieved.

When a photo-curable resin is used as the curable binder resin also, for example when a formed plated layer is used to a soldering connection, the resulting cured material desirably exhibits a sufficient heat resistance in a heating at least at a temperature 80 °C. For such an application, generally, a photo-curable resin composition is preferably used which contains an epoxy acrylate resin having a heat resistance at about 100 °C, as a main resin component. The photo-curable resin which meets the heat resistance requirement may preferably be a radical polymerizable resin which produces a radical species by itself and causes a photo-induced radical polymerization upon a light irradiation, or a polymerization curable resin which causes a radical polymerization or photo-cation polymerization induced by a photo-radical polymerization initiator or photo-acid generator. For example, a combination of a reactive (radical polymerizable) oligomer: alkyd acrylate, polyesteracrylate, epoxyacrylate, urethane modified acrylate and the like; and a photo-radical polymerization initiator for the oligomer may be used as a photo-curable resin composition.

When the viscosity of a photo-curable resin composition needs to be adjusted, an organic solvent for a dilution solvent may be conveniently added. In this case, after a drying treatment is performed to the resin mixture coating layer which contains the photo-curable resin composition to evaporate and remove the added dilution solvent, a "light irradiation treatment" is performed to the coating layer surface already subjected to the drying treatment to induce a "photo-curing reaction" of the surface. In the "light irradiation treatment", an ultraviolet ray irradiation may be used because it can supply an energy required to generate a radical species from a used photo-radical polymerization initiator or a proton produced by a photo-acid generator for example, using photoexcitation. Instead of the "ultraviolet ray irradiation", an electron beam exposure may be used which enables excitation of a used photo-radical polymerization initiator or photo-acid generator.

The penetrating depth of an ultraviolet ray or electron beam which enters from the coating layer surface after a drying treatment is affected by photo-absorption by a photo-radical polymerization initiator or photo-acid generator, and also by the attenuation caused by the light scattering or reflection by the dispersed metal fine particles. In order to enhance the photo-curing through the entire film thickness of the coating layer surface after a drying treatment, it is desirable to select the film thickness of the coating layer surface after a drying treatment to be in a range of 0.5 µm to 60 µm, more preferably in a range of 1 µm to 30 µm, and then to set the intensity of an ultraviolet ray to be irradiated to the surface to have a light flux density in a range of 0.1 J/cm² to 2 J/cm² (wavelength 365 nm), more preferably in a range of 0.2 J/cm² to 1.2 J/cm² (wavelength 365 mm), for the excitation of a used photo-radical polymerization initiator or photo-acid generator.

Furthermore, in addition to the photo-radical polymerization initiator or photo-acid generator, a radical generator which generates radicals by heat decomposition may be added to a photo-curable resin composition, so that eventually after an electroless plating metal layer is formed, a heat treatment can be effected to the assembly including the non-conductive substrate at a predetermined temperature to enhance the heat curing by radical polymerization. That is, the heat treatment achieves a state of a uniform wettability both of the surfaces of the non-conductive substrate and the rear surface of the plated metal layer by the photo-curable resin, and also imparts a stronger binder property to both of them. The radical generator which generates radicals by heat decomposition may be for example, peroxide based radical generator: perbutyl Z (t-butyl peroxy benzoate: manufactured by NOF CORPORATION). In this case, it is desirable to add peroxide based radical generator: perbutyl Z (t-butyl peroxy benzoate: manufactured by NOF CORPORATION) by an amount in a range of 0.1 to 2 parts by mass, preferably in a range of 0.3 to 1 part by mass relative to the photo-curable resin main component of 100 parts by mass such as an epoxy acrylate resin. The heat curing by the radical which is generated by the heat decomposition can be achieved by a heating at a temperature in a range of 120 °C to 160 °C, preferably in a range of 130 °C to 150 °C.

In addition, in a conductive circuit manufacturing method according to the first approach of the present invention, in order to obtain a state in which the metal fine particles which have an average particle size of 1 to 200 nm are uniformly dispersed in a resin mixture coating layer after a drying treatment, covering molecule layers are provided onto the surfaces of metal fine particles to enhance the dispersibility. Specifically, the metal fine particles are covered with one or more organic compounds having a group containing a nitrogen, oxygen, or sulfur atom, which group can coordinately bind by using the lone pairs of the atoms, as a group that can coordinately bind with the metal element of the metal ultra fine particles, and thereby the organic compounds form the covering molecule layers on the surfaces. The compound for the covering molecule layer which maintains the dispersibility is preferably an organic compound which has an amino group (-NH₂), a hydroxy group (-OH), or a sulfanyl group (-SH) at the terminal thereof, or an ether (-O-) or sulfide (-S-) in the molecule, and has an excellent affinity with the binder resin component which is used as a dispersion medium in the curable binder resin composition.

Particularly, a selection of an average particle size of the used metal fine particles preferably in a range 1 to 70 nm, more preferably in a range of 1 to 20 nm is effective to keep the uniform dispersibility of the metal fine particles when a dispersion density of the dispersed metal fine particles in a resin mixture is increased.

The preferable dispersants are those which function to form the molecule layers that cover the surfaces of the metal fine particles and to enhance the dispersibility, and do not easily detach from the surfaces of the metal fine particles at a temperature around 100 °C during a drying treatment to the resin mixture coating layer to evaporate and remove the organic solvent therein. At the same time, the dispersants are required to be selectively detached upon an energy beam irradiation after the drying treatment to the resin mixture coating layer.

Such an alkylamine that does not detach from a metal element in a normal storage environment, specifically at a temperature of less than 40 °C, in a state where the alkylamine coordinately binds with the metal element is used suitably, and thus it is preferred to use such an alkylamine that has a boiling point at a temperature of 60 °C or more, preferably 100 °C or more. For example, as to alkylamine, C4 - C20 alkyl group is used, and more preferably C8 - C18 alkyl group is used, with an amino group at the terminal of the alkyl chain. For example, the C8 - C18 alkylamine is preferably used for its handling properties because it has a thermal stability and a vapor pressure which is not very high, and the content rate thereof can be easily maintained and controlled within a desired range at a room temperature and the like. Generally, from the view point of coordinately binding, a compound of primary amine type is preferable for the high binding property, but a compound of secondary amine or tertiary amine type also may be used. In addition, a compound in which adjacent two or more amino groups are involved in the binding, such as a compound of 1,2-diamine or 1,3-diamine type, also may be used. Polyoxyalkyleneamine also may be used. In addition to the above terminal amino groups, compounds also having a hydrophilic terminal-group, such as a hydroxyamine which has also a hydroxyl group, for example ethanolamine, may be used.

A typical example of available compounds having a sulfanyl group (-SH) is alkanethiol. Such an alkanethiol that does not detach from a metal element in a normal storage environment, specifically at a temperature of less than 40 °C, in a state where the alkanethiol coordinately binds with the metal element is used suitably, and thus it is preferred to use such an alkanethiol that has a boiling point at a temperature of 60 °C or more, preferably 100 °C or more. For example, as to alkanethiol, C4 - C20 alkyl group is used, and more preferably C8 - C18 alkyl group is used, with a sulfanyl group (-SH) at the terminal of the alkyl chain. For example, the C8 - C18 alkanethiol is preferably used for its handling properties because it has a thermal stability and a vapor pressure which is not very high, and the content rate thereof can be easily maintained and controlled within a desired range at a room temperature and the like. Generally, from the view point of coordinately binding, a compound of primary thiol type is preferable for the high binding property, but a compound of secondary thiol or tertiary thiol type also may be used. A compound in which two or more sulfanyl groups (-SH) are involved in the binding, such as a compound of 1,2-dithiol type, also may be used.

A typical example of available compounds having hydroxy groups is alkanediol. Such an alkanediol that does not detach from a metal element in a normal storage environment, specifically at a temperature of less than 40 °C, in a state where the alkanediol coordinately binds with the metal element is used suitably, and thus it is preferred to use such an alkanediol that has a boiling point at a temperature of 60 °C or more, typically 100 °C or more. For example, a compound in which two or more hydroxy groups are involved in the binding, such as a compound of 1,2-diol type, may be more preferably used.

That is, the metal fine particles dispersed in a resin mixture have surfaces which are covered with one or more compounds having a group containing nitrogen atom, oxygen atom, or sulfur atom, which group can coordinately bind by using the lone pairs of the atoms, as a group that can coordinately bind with the metal element of the metal ultra fine particles, and for example, the surfaces are preferably covered with one or more amine compounds having one or more terminal amino groups. For example, in the preparation of a resin mixture, a state should be obtained where one or more amine compounds of 5 to 60 parts by mass are contained in total relative to the metal fine particles of 100 parts by mass. Preferably, a state should be obtained where one or more amine compounds of 7 to 40 parts by mass, preferably 10 to 30 parts by mass are contained in total relative to the metal fine particles of 100 parts by mass.

The first function of the amine compound which forms the molecule layer covering the surfaces of metal fine particles dispersed in a resin mixture is to, in the preparation of the resin mixture, during a mixing and blending process, prevent the metal fine particles from directly contacting the clean surfaces thereof with each other to adhere and form clusters. Therefore, so long as the covering molecule layers over the surfaces of metal fine particles are formed, a desirable amine compound is, although not particularly limited to the type, such an amine compound that does not easily evaporate at a room temperature. Therefore, as described above, an amine compound having an amino group at the terminal thereof, for example alkylamine, is preferable. More specifically, as alkylamine, C4 - C20 alkyl group is used, and more preferably C8 - C18 alkyl group is used, with an amino group at the terminal of the alkyl chain. For example, the C8 - C18 alkylamine is preferably used for its handling properties because it has a thermal stability and a vapor pressure which is not very high, and the content rate thereof can be easily maintained and controlled within a desired range at a room temperature and the like. In order to achieve the first function to form covering molecule layers over the surfaces of metal fine particles, the content of the amine compound having an amino group at the terminal thereof, for example alkylamine, should be conveniently selected depending on the entire surface areas of the metal fine particles and in consideration of the type of the metal and the type of amine compound, for example alkylamine. Generally, when C8 - C18 alkylamine is used and the specific gravity of the metal itself is similar to that of silver, gold, and copper for example, and also an average particle size of the metal fine particles is not much less than 10 nm, although the used amount of alkylamine in the covering molecule layer depends on the type and particle size of the metal, the content of alkylamine is preferably selected to be in a range of 5 to 60 parts by mass, more preferably 7 to 40 parts by mass, most preferably 10 to 30 parts by mass relative to the metal fine particles of 100 parts by mass. When an amine compound other than alkylamine is used also, the total content of the amine compound is preferably selected to be in a range of 5 to 60 parts by mass, more preferably 7 to 40 parts by mass, most preferably 10 to 30 parts by mass relative to the metal fine particles of 100 parts by mass.

The layer thickness of the molecule layers covering metal fine particles needs to be uniform independently of an average particle size of the metal fine particles. Therefore, a smaller average particle size of the metal fine particles increases the total surface area of the metal fine particles per unit mass of the metal fine particles, resulting in the increase of the total amount of compounds which are used to form the molecule layer covering the metal fine particles and have a group containing one of nitrogen atom, oxygen atom, and sulfur atom, as a group that can coordinately bind with the metal element. That is, it is desirable to increase or decrease the total amount of compounds having the group containing one of nitrogen atom, oxygen atom, and sulfur atom, as a group that can coordinately bind with the metal element, in inverse proportion to the average particle size of the used metal fine particles.

The metal fine particles themselves in a state the surfaces thereof are protected by the covering molecule layers do not expose the metal surfaces even when they are immersed in an electroless plating solution, and so do not function as nuclei for the precipitation of metal clusters in electroless plating. To the contrary, in the first embodiment and the third embodiment of the present invention, an energy beam irradiation is performed to a desired fine region on a flat surface of the resin mixture coating layer corresponding to a pattern shape of a fine circuit, and then metal fine particles without the covering molecule layers are produced only to the surface portion subjected to the energy beam irradiation to be used as nuclei for the precipitation of metal clusters in electroless plating. The energy beam used for the energy beam irradiation which enhances the detachment of the covering molecule layer protecting the surfaces of the metal fine particles is desirably an electron beam or an ultraviolet ray. That is, it is preferable to use an ultraviolet ray irradiation using a photomask which has an opening of a desired pattern shape, or a highly directional electron beam exposure for a local scanning irradiation of an electron beam corresponding to a desired pattern shape. When an ultraviolet ray having a wavelength in a range of 180 nm or more to 400 nm or less, a visible light having a wavelength in a range of 400 nm to 600 nm, or an excitation by particle beam bombardment is used for the energy beam irradiation, an electron beam of 40 keV or more may be used.

Specifically, the covering molecule layers which protect the surfaces of the metal fine particles exposed on a flat surface of a resin mixture coating layer are selectively detached using an energy supplied from the energy beam to be locally irradiated. At first, the covering molecules in the covering molecule layer which protects a surface of a metal fine particle coordinately bind with the metal atoms contained in the surface. However, when the electrons in the metal which are involved in the coordinately binding are excited, the binding force of the coordinately binding of the molecules is reduced, which promotes the detachment of the covering molecules. While, the metal atoms contained in the surface of the metal fine particle are likely to be oxidized, and an oxide film of about one molecule thick layer is formed on the outermost surface thereof. The formation of the oxide film achieves a state in which the covering molecule that was once detached from the surface will not cover the surface again. However, being immersed in an electroless plating solution, the oxide film formed on the surface of the metal fine particle is quickly reduced, and the particle is converted to the metal fine particle having a clean metal surface. The metal fine particle having a clean metal surface functions as a nucleus for the precipitation of metal atoms which is generated in electroless plating. As a result, an energy beam irradiation to a desired fine region on the flat surface of the resin mixture coating layer enables formation of an electroless plating metal layer only on the fine region subjected to the energy beam irradiation.

When an ultraviolet ray having a wavelength in a range of 180 nm or more to 400 nm or less is used in the energy beam irradiation to the metal fine particles which are exposed on the flat surface of the resin mixture coating layer, it is desirable to set the intensity of the ultraviolet ray which is irradiated to the surface to be in a range of 0.1 J/cm² to 70 J/cm², preferably 0.5 J/cm² to 50 J/cm². Alternatively, when an electron beam of 40 keV or more is used in the energy beam irradiation to the metal fine particles, it is desirable to set the exposure dose of the electron beam to the surface to be in a range of 500 kGy to 6000 kGy.

Based on the condition that the surface of the metal fine particle is provided with an oxide film of about one molecule thick layer formed on the outermost surface thereof after the covering molecules coordinately bound with the surface of the metal fine particle are detached from the surface, and the oxide film is immersed in an electroless plating solution and is quickly reduced, the metal composing the metal fine particle is desirably a metal species or an alloy consisting of two or more metal species which is selected from the group consisting of Pd, Ag, Cu, Au, Pt, Zn, Cr, Fe, and Ni. That is, preferably, the metal fine particles are used which are formed of a precious metal such as Pd, Ag, Au, and Pt that is in an oxidized state to quickly oxidize the reductive compound blended in an electroless plating solution and to be reduced to metal, or a metal species that is generated from a metal oxide having a low oxidation number such as Cu₂O, Zn₂O, CrO, FeO, and NiO.

Meanwhile, the metal species of the electroless plating metal layer is preferably a metal species selected from the group consisting of Pd, Ag, Cu, Au, Pt, Zn, Cr, Fe, and Ni. For example, as the metal species which forms the electroless plating metal layer, a metal species which is less noble than that for the metal fine particles can be selected from the group described above. Of course, the metal species which forms the electroless plating metal layer and the metal species which forms the metal fine particles may be the same.

When the metal species of the fine metal fine particles which function as the nuclei for plating in electroless plating is a metal which is less noble than the metal species which is used in the plating, with being immersed in an electroless plating solution, the metal species may be partly displaced with the metal species used in the plating by a replacement plating process. After that, the formation of metal clusters in the electroless plating is enhanced using the metal fine particles the surfaces of which are formed of the same metal species as that of the particles, as the nuclei for plating.

In a conductive circuit manufacturing method according to the first approach of the present invention, the embodiment is generally desirable, in which after a uniform resin mixture coating layer is formed on a surface of a non-conductive substrate, an energy beam is irradiated to a desired fine region of the flat surface of the resin mixture coating layer corresponding to a pattern shape of a fine circuit, and metal clusters are selectively precipitated onto the surface region subjected to the energy beam irradiation by electroless plating, so that a plated metal layer having an intended pattern shape is formed to the region.

However, it is also possible to use such an embodiment in which a non-conductive substrate is deformed in three dimensions in advance, and a resin mixture coating layer having an intended pattern shape is formed on a surface of the non-conductive substrate in advance, and an energy beam irradiation is performed to the entire surface. In the formation of a coating layer of a resin mixture, screen printing, inkjet printing, or transfer printing may be used as an approach for writing and forming the shape of a coating layer in an intended pattern in advance.

Depending on the used printing means, the solution viscosity of the resin mixture comprising metal fine particles therein conveniently should be adjusted. For example, when screen printing is used in writing a fine coating pattern, the solution viscosity of the resin mixture is desirably selected to be in a range of 30 to 300 Pa·s (25 °C). And when transfer printing is used, the solution viscosity of the resin mixture is desirably selected to be in a range of 10 to 500 Pa·s (25 °C). When inkjet printing is used, the solution viscosity of the resin mixture is desirably selected to be in a range of 1 to 100 mPa·s (25 °C).

The solution viscosity of a resin mixture which comprises metal fine particles dispersed in a curable resin composition of a dispersion medium is determined depending on an average particle size of the used metal fine particles, a dispersion concentration in the resin mixture coating layer after a drying treatment, a type of the curable resin composition itself which is the dispersion medium, and a solution viscosity. After an average particle size of the used metal fine particles and a dispersion concentration in the resin mixture coating layer after a drying treatment are selected, a type of the curable resin composition itself which is the dispersion medium and a solution viscosity are conveniently selected to adjust a solution viscosity as intended. That is, depending on a type of the curable resin composition itself which is the dispersion medium, the type and amount of an organic solvent for dilution are conveniently adjusted, so that a solution viscosity of a resin mixture can be adjusted as intended.

An application of a conductive circuit manufacturing method according to a first approach of the present invention enables formation of a conductive circuit onto a curved surface having a radius of curvature in a range of 5 mm to 1 m. Actually, examples of the deformed product having a curved surface to which a circuit can be formed by application of a conductive circuit manufacturing method according to the present invention include the followings:
1) formation of a circuit on an outer surface of writing instrument such as ball point pen and fountain pen (radius of curvature: 5 mm to 2 cm);
2) formation of a circuit on an outer surface of a mechanical component such drum of printer and roll of copy machine (radius of curvature: 1 cm to 50 cm);
3) formation of a circuit on an outer surface of a test apparatus such as centrifugal separator and rotor (radius of curvature: 10 cm to 1 m);
4) formation of a circuit on an outer surface of an electrical appliance such as pot, jar, and mixer (radius of curvature: 5 cm to 1 m);
5) formation of a circuit into an inside of a hole of a board (radius of curvature: 5 mm to 1 cm);
6) formation of a circuit on an inner surface of a cylinder (radius of curvature: 5mm to 10cm);
7) formation of a circuit upon an outer surface of a liquid bottle and a can (radius of curvature: 3 cm to 1 m);
8) formation of a circuit on an outer or inner surface of a ball for ball game (radius of curvature: 2 cm to 50 cm); and
9) formation of a circuit on a surface of other sphere.
   Also, a conductive circuit manufacturing method according to the present invention can be preferably used to form a conductive circuit on a surface which has a bended shape and the angle between the surfaces at the corner thereof is in a range of 60 to 160 ° or from 200 to 300 °. Examples of the deformed product having such a corner to which a circuit can be formed include the followings:

1) formation of a circuit on a component of multi-layered board or electronic board;
2) formation of a circuit according to the shape of a mechanical part such as production facility;
3) formation of a circuit which is deformed according to the shape of a gap between electronic parts and is used to manufacture electronic parts having a compact shape;
4) formation of a circuit to follow the shape of a vehicle body or on-vehicle components;
5) formation of a circuit to follow the shape of a precision apparatus such as scale, clock, sensor, and the like;
6) formation of a circuit on an inner surface of an outer frame of a cellular, PDA, or the like;
7) formation of a circuit onto a stepped shape which is made by putting one structure to a top of another structure; and
8) formation of a circuit on a surface of a structure having a bended shape.

### II. Second Approach

Similar to the above described first approach, in a second approach of the present invention also, instead of using a uniform metal film, fine metal surface portions are discretely arranged on a surface made of organic materials at a sufficiently high area density to obtain the substantially same function as that of a uniform metal film surface. As the approach to achieve the above situation, in a second approach of the present invention, for example, metal fine particles are closely arranged on a surface of an adhesive layer at a high area density so that a state is established where the surfaces of the metal fine particles arranged on the surface expose clean metal surfaces. Specifically, in a first embodiment and a third embodiment according to the second approach of the present invention, an approach is used in which metal fine particles having a covering molecule layer to the individual surface thereof are closely arranged on a surface of an adhesive layer at a high area density, and then an energy beam is irradiated from the surface to detach the covering molecule layers and to form metal oxide films on the outermost surface of the metal fine particles once, which is reduced in an electroless plating solution to obtain the nuclei having clean metal surfaces on the surfaces thereof.

And in a second embodiment and a fourth embodiment according to the second approach of the present invention, an approach is used in which an organic metal compound of fine powder form is closely arranged on a surface of an adhesive layer at a high area density, and the metal ion species contained in the organic metal compound are once converted to the metal oxide fine particles, which are reduced in an electroless plating solution to obtain the nuclei having clean metal surfaces on the surfaces thereof. In the process for converting the metal ion species contained in the organic metal compound to the metal oxide fine particles once, an energy beam is irradiated from the surface so that the organic material components of the organic metal compound are detached and the remained metal ion species is converted to metal oxide to aggregate as particles of fine metal oxide. The fine metal oxide is fixedly attached to the surface of an adhesive layer once, but in an electroless plating solution, the metal oxide fine particles are reduced to be the nuclei having clean metal surfaces on the surfaces thereof.

In addition, in the second approach of the present invention, the above two steps for the induction by an energy beam irradiation and the conversion to metal oxides are performed using a transition to an excited electronic state which is caused by the energy beam irradiation, and the energy of the energy beam, when photoexcitation is used, is an energy of an ultraviolet ray region within a wavelength range from 180 nm or more to 400 nm or less, or an energy of a visible light region within a wavelength range from 400 nm to 600 nm, and when excitation by particle beam bombardment is used, an electron beam of 40 keV or more can be used.

That is, in a state where metal fine particles are closely arranged on a surface of an adhesive layer at a high area density or an organic metal compound of fine powder form are closely arranged on a surface of an adhesive layer at a high area density, when a predetermined energy beam is irradiated, the nuclei having clean metal surfaces on the surfaces thereof are selectively formed to the energy beam irradiated region, and in corresponding to the formation, the precipitation of an electroless plated metal layer is actually enhanced only at the region. In the present invention, the shape pattern of the region where the energy beam is irradiated is determined in advance, which allows the simple control of the formation of an electroless plated layer in an intended pattern shape.

In the second approach of the present invention, the conductive circuit manufacturing methods according to the first embodiment and the third embodiment have common constitutional features in using an approach, as means for selectively forming an electroless plated layer on a surface of a non-conductive substrate in a desired pattern shape, in which a coating layer of a resin mixture, which comprises metal fine particles of an average particle size of 1 to 200 nm uniformly dispersed in a curable binder resin composition, is formed, and an energy beam is irradiated from a region of the surface of the resin mixture coating layer corresponding to the pattern shape so that an electroless plated layer is selectively formed to the surface region subjected the energy beam irradiation when the resin mixture coating layer is immersed in an electroless plating solution for electroless plating.

In the second approach of the present invention, a conductive circuit manufacturing method according to the first embodiment comprises an operation, after a resin mixture coating layer is formed on a non-conductive substrate surface, for deforming the non-conductive substrate in three dimensions together with a resin mixture coating layer on the surface thereof. That is, since the resin mixture coating layer on the surface is not subjected to a curing treatment yet at this point of time, a deforming of the non-conductive substrate in three dimensions causes the resin mixture coating layer to be similarly deformed in three dimensions. Specifically, the resin mixture coating layer which is formed on the surface of non-conductive substrate by coating a resin mixture at a uniform film thickness is subjected to heating at a low temperature and prebaking (drying treatment) for evaporating solvent components contained therein, but the resin mixture coating film after the drying treatment still contains a compound of resin raw materials before a polymerization treatment as its main component, which is in a state having a much higher plastic deformability than that of the material of the non-conductive substrate. So, when the non-conductive substrate is subjected to an operation of deforming in three dimensions to be plastically deformed, the resin mixture coating layer on the surface follows the deformation to be plastically deformed, resulting in that the resin mixture coating layer is similarly deformed in three dimensions. For example, when the non-conductive substrate is uniaxially stretched for a "stretching process" in the longitudinal direction, the thickness of the board is decreased in inverse proportion to the uniaxial stretch ratio. In the process, the resin mixture coating layer on the surface is also subjected to the "stretching process" in the longitudinal direction at the same uniaxial stretch ratio, and the thickness of the coating layer is decreased in inverse proportion to the uniaxial stretch ratio. In the surface of the resin mixture coating layer after the drying treatment, the dispersoid metal fine particles of an average particle size 1 to 200 nm still remained uniformly dispersed in the dried curable binder resin composition. While, the uniaxial stretch ratio of the resin mixture coating layer in the deforming operation in three dimensions to the non-conductive substrate may be in a range of 100% to 600% relative to the original size. The size of the resin mixture coating layer before the process is desirably adjusted so that the resin mixture coating layer may have a film thickness in a range of 0.1 µm to 20 µm after the uniaxially stretching process.

In the second approach of the present invention, in a conductive circuit manufacturing method of the first embodiment, a material which has a desired plastic deformability is used for a non-conductive substrate to enable a deforming of the non-conductive substrate in three dimensions. Specifically, polycarbonate, PET, PEN, or the like may be used for a non-conductive substrate to which is deformed in three dimensions.

In the second approach of the present invention, in a conductive circuit manufacturing method of the third embodiment, a material which has a desired plastic deformability and also a material which exhibits a lack of plastic deformability can be used because a non-conductive substrate is not deformed in three dimensions. A non-conductive substrate formed of polyimide, glass, epoxy, or the like which exhibits a lack of plastic deformability may be used.

The dispersion density of the metal fine particles of an average particle size of 1 to 200 nm which are dispersed in a resin mixture coating layer that is formed on a non-conductive substrate and subjected to a drying treatment is desirably selected to be in a range of 1.0 × 10¹²/mm³ to 3.5 × 10¹⁴/mm³, that is, in a range of 1.0 × 10³/µm³ to 3.5 × 10⁵/µm³, more preferably in a range of 5.0 × 10¹²/mm³ to 1.0 × 10¹⁴/mm³, that is, in a range of 5.0 × 10³/µm³ to 1.0 × 10⁵/µm³. Accordingly, the area density of the metal fine particles which are exposed on the coating layer surface is preferably in a range of 1.0 × 10¹/µm² to 4 × 10²/µm², more preferably in a range of 0.4 × 10²/µm² to 2 × 10²/µm². That is, assuming that the metal fine particles which are exposed on the coating layer surface are arranged in a square lattice, an average distance between adjacent metal fine particles is preferably from 0.20 µm to 0.07 µm. In the state, using the clean metal surface of the metal fine particles which are exposed on a surface of the coating layer as nuclei, fine metal clusters having an average particle size of 0.5 µm to 4 µm are produced in an electroless plating process, thereby a coating layer is formed by the fine metal clusters produced in the electroless plating to cover the almost entire surface of the resin mixture coating layer. Then, formation of an electroless plating metal layer is enhanced to further cover the coating layer having the fine metal clusters closely distributed across the entire surface thereof, so that, when the electroless plating metal layer has a film thickness of 1 µm, a compact and uniform plated metal layer is formed which is comparable to an electroless plating metal layer which is formed on an underlayer of a metal film having a uniform surface texture.

The resin mixture coating layer itself desirably is flat and has a uniform film thickness except the regions of the metal fine particles exposed on the surface thereof. After the formation of a compact and uniform plated metal layer, a heat treatment is performed to the resin mixture coating layer to impart flowability, which allows the binder resin of the resin mixture coating layer to wet contact with the rear surface of the formed plated metal layer. Eventually, the binder resin layer which is formed of a flat resin mixture coating layer having a uniform film thickness has a function to make a plated metal layer fixedly attached to non-conductive substrate surface with a high adhesion.

Therefore, the curable binder resin composition which is blended in a resin mixture as a dispersion medium should be a curable binder resin which has an excellent adhesion property to both of a surface of a non-conductive substrate and a plated metal layer. Specifically, the curable binder resin is desirably a thermosetting resin or photo-curable resin.

When a thermosetting resin is used as the curable binder resin, after an electroless plating metal layer is formed, by performing a heat treatment to the assembly including the non-conductive substrate at a predetermined temperature, a heat curing is effected in a state where the non-conductive substrate surface and the rear surface of the plated metal layer wet contact with each other. In the heat curing treatment, the heat temperature is conveniently selected in consideration with a heat resistance of the material of the non-conductive substrate. Generally, it is desirable to complete a desired heat curing by heat at a temperature of 160 °C or less. Typically, the material of a non-conductive substrate exhibits a sufficient heat resistance at least at a temperature at which a solder material melts so that a conductive circuit enables an application of soldering connection to an electrical connection between wiring of the electroless plated layer and terminals of other electronic parts. The thermosetting resin for forming the binder resin layer is preferably a material which exhibits a sufficient heat resistance at least at a temperature at which a solder material melts.

Therefore, when a thermosetting resin is used as the curable binder resin, for example when a formed plated layer is used to a soldering connection, the resulting cured material desirably exhibits a sufficient heat resistance during heating at least at a temperature 80 °C. For such an application, generally, a thermosetting resin composition is more preferably used which contains an epoxy resin or an alkyd resin having a heat resistance at about 100 °C as a main resin component. Available epoxy resins include bisphenol A epoxy resin. Available alkyd resins include HARIFUTAL (manufactured by Harima Chemicals, Inc.).

The thermosetting resin composition containing an epoxy resin as a main resin component may be a composition which comprises an epoxy resin component, a curing agent or curing catalyst for the epoxy resin, and a curing accelerator as may be needed. The curing agent which can be used in a thermosetting resin composition for an epoxy resin may be an acid anhydride based curing agent, for example phthalic anhydride, and also may be an amine based curing agent, for example an amine adduct compound. In using a curing agent, imidazole or the like may be added as a curing accelerator as may be needed. As a curing catalyst for an epoxy resin, triphenylphosphine or the like may be used.

For example, as with the epoxy resin component, a blending ratio of an acid anhydride based curing agent to an epoxy resin is desirably selected to be the one having dibasic acid anhydride typically in a range of 0.8 to 1.2 molecules, preferably in a range of 0.9 to 1.1 molecules, relative to two epoxy groups in the epoxy resin component. Also, when a curing accelerator is added in addition to the acid anhydride based curing agent, it is desirable to blend the amine based curing accelerator in a range of 0.010 to 0.050 molecule, preferably in a range of 0.015 to 0.040 molecule, relative to two epoxy groups in the epoxy resin component.

As may be needed, an organic solvent for a dilution solvent may be added by an appropriate amount for viscosity adjustment in the thermosetting resin composition which contains an epoxy resin as a main resin component. The thermosetting resin composition which contains an epoxy resin as a main resin component is preferably a composition which retains metal fine particles having an average particle size of 1 to 200 nm, which are contained as dispersoid, in a uniformly dispersed state, and at the same time forms a heat cured material when the organic solvent contained therein is evaporated and removed and a drying treatment and then preferably a heat treatment at a temperature in a range of 50 to 160 °C for 5 to 30 minutes are performed to the thermosetting resin composition.

To the contrary, the thermosetting resin composition containing an alkyd resin as a main resin component may be a composition which comprises an alkyd resin component and a curing accelerator for the alkyd resin. The curing accelerator for the alkyd resin a thermosetting resin composition may be preferably cobalt naphthenate, zirconium naphthenate, or the like which are widely used as a dryer for coating materials. For example, as with the alkyd resin component, a blending ratio of a curing accelerator to an alkyd resin is preferably the one obtained by adding, for example, a compound for the curing accelerator containing cobalt naphthenate of 0.1 parts by mass and zirconium naphthenate of 0.05 parts by mass, to an alkyd resin of 100 parts by mass. In order to obtain a state in which the alkyd resin component and the curing accelerator for the alkyd resin are uniformly blended in the thermosetting resin composition, typically, the curing accelerator of a predetermined amount is added to a solution which contains an organic solvent of an appropriate amount for solving the alkyd resin component. In this case, the thermosetting resin composition which contains an alkyd resin as a main resin component is preferably a composition which retains metal fine particles having an average particle size of 1 to 200 nm, which are contained as dispersoid, in a uniformly dispersed state, and at the same time forms a heat cured material, when the organic solvent contained therein is evaporated and removed and a drying treatment and then preferably a heat treatment a at temperature in a range of 60 to 100 °C for 5 to 30 minutes are performed to the thermosetting resin composition.

Meanwhile when a photo-curable resin is used as the curable binder resin, a procedure for enhancing a photo-curing in advance is used in which, before an electroless plating metal layer is formed, a light having a predetermined energy is irradiated at least to the portion that corresponds to the region where is covered with the formed electroless plating metal layer. For the resin mixture coating layer, a photo-curing of the blended photo-curable resin composition is enhanced in advance, and then an electroless plating process is performed to the surface of the coating layer. After the electroless plating metal layer is formed, a heat treatment is effected to the assembly comprising the non-conductive substrate at a predetermined temperature to obtain a state where a wet contact between the non-conductive substrate surface and the rear surface of the plated metal layer by the photo-curable resin is achieved.

When a photo-curable curable resin is used as the curable binder resin also, for example when a formed plated layer is used to a soldering connection, the resulting cured material desirably exhibits a sufficient heat resistance during heating at least at a temperature 80 °C. For such an application, generally, a photo-curable resin composition is preferably used which contains an epoxy acrylate resin having a heat resistance at about 100 °C as a main resin component. The photo-curable resins which meet the heat resistance requirement may preferably be a radical polymerizable resin which produces a radical species by itself and causes a photo-induced radical polymerization upon a light irradiation, or a polymerization curable resin which causes a radical polymerization or photocation polymerization induced by a photoradical polymerization initiator or photoacid generator. For example, a combination of a reactive (radical polymerizable) oligomer; alkyd acrylate, polyesteracrylate, epoxyacrylate, urethane modified acrylate and the like and a photoradical polymerization initiator for the oligomer may be used as a photo-curable resin composition.

When the viscosity of a photo-curable resin composition needs to be adjusted, an organic solvent for a dilution solvent may be conveniently added. In this case, after a drying treatment is performed to the resin mixture coating layer which contains the photo-curable resin composition to evaporate and remove the added dilution solvent, a "light irradiation treatment" is performed to the coating layer surface already subjected to the drying treatment to induce a "photocuring reaction" of the surface. In the "light irradiation treatment", an ultraviolet ray irradiation may be used because it can supply an energy required to generate a radical species from a used photoradical polymerization initiator or a proton produced by a photoacid generator for example, using photoexcitation. Instead of the "ultraviolet ray irradiation", an electron beam exposure may be used which enables excitation of a used photoradical polymerization initiator or photoacid generator.

The penetrating depth of an ultraviolet ray or electron beam which enters from the coating layer surface after a drying treatment is affected by photo-absorption by a photo-radical polymerization initiator or photo-acid generator, and also by the attenuation caused by the light scattering or reflection by the dispersed metal fine particles. In order to enhance the photo-curing through the entire film thickness of the coating layer surface after a drying treatment, it is desirable to select the film thickness of the coating layer surface after a drying treatment to be in a range of 0.5 µm to 60 µm, more preferably in a range of 1 µm to 30 µm, and then to set the intensity of an ultraviolet ray to be irradiated to the surface to have a light flux density in a range of 0.1 J/cm² to 2 J/cm² (at wavelength 365 nm), more preferably in a range of 0.2 J/cm² to 1.2 J/cm² (at wavelength 365 mm), for the excitation of a used photo-radical polymerization initiator or photo-acid generator.

Furthermore, in addition to the photo-radical polymerization initiator or photo-acid generator, a radical generator which generates radicals by heat decomposition may be added to a photo-curable resin composition, so that eventually after an electroless plating metal layer is formed, a heat treatment can be effected to the assembly including the non-conductive substrate at a predetermined temperature to enhance the heat curing by radical polymerization. That is, the heat treatment achieves a state of a uniform wet both of the surface of the non-conductive substrate and the rear surface of the plated metal layer by the photo-curable resin, and also imparts a stronger binder property to both of them. The radical generator which generates radicals by heat decomposition may be for example, peroxide based radical generator: perbutyl Z (t-butyl peroxy benzoate: manufactured by NOF CORPORATION). In this case, it is desirable to add peroxide based radical generator: perbutyl Z (t-butyl peroxy benzoate: manufactured by NOF CORPORATION) by in a range of 0.1 to 2 parts by mass, preferably in a range of 0.3 to 1 part by mass relative to the photo-curable resin main component of 100 parts by mass such as an epoxy acrylate resin. The heat curing by the radical which is generated by the heat decomposition can be achieved by a heating at a temperature in a range of 120 °C to 160 °C, preferably in a range of 130 °C to 150 °C.

In addition, in the second approach of the present invention, in the conductive circuit manufacturing methods according to the first embodiment and the third rmbodiment, in order to obtain a state in which the metal fine particles which have an average particle size of 1 to 200 nm are uniformly dispersed in a resin mixture coating layer after a drying treatment, covering molecule layers are provided onto the surfaces of metal fine particles to enhance the dispersibility. Specifically, the metal fine particles are covered with one or more organic compounds which have a group containing nitrogen, oxygen, or sulfur atom, which group can coordinately bind by using the lone pairs of the atoms, as groups that can coordinately bind with the metal element of the metal ultra fine particles, and thereby, the organic compounds form the covering molecule layers on the surfaces. The compound for the covering molecule layer which maintains the dispersibility is preferably an organic compound which has an amino group (-NH₂), a hydroxy group (-OH), or a sulfanyl group (-SH) at the terminal thereof, or an ether (-O-) or sulfide (-S-) in the molecule, and has an excellent affinity with the binder resin component which is used as a dispersion medium in the curable binder resin composition.

Particularly, a selection of an average particle size of the used metal fine particles preferably in a range 1 to 70 nm, more preferably in a range of 1 to 20 nm is effective to keep the uniform dispersibility of the metal fine particles when a dispersion density of the dispersed metal fine particles in a resin mixture is increased.

The preferable dispersants are those which function to form the molecule layers that cover the surfaces of the metal fine particles and to enhance the dispersibility, and do not easily detach from the surfaces of the metal fine particles at a temperature around 100 °C during a drying treatment to the resin mixture coating layer to evaporate and remove the organic solvent therein. At the same time, the dispersants are required to be selectively detached upon an energy beam irradiation after the drying treatment to the resin mixture coating layer.

A typical example of available compounds having an amino group is alkylamine. Such an alkylamine that does not detach from a metal element in a normal storage environment, specifically at a temperature of less than 40 °C, in a state where the alkylamine coordinately binds with the metal element is used suitably, and thus it is preferred to use such an alkylamine that has a boiling point at a temperature of 60 °C or more, preferably 100 °C or more. For example, as to alkylamine, C4 - C20 alkyl group is used, and more preferably C8 - C18 alkyl group is used, with an amino group at the terminal of the alkyl chain. For example, the C8 - C18 alkylamine is preferably used for its handling properties because it has a thermal stability and a vapor pressure which is not very high, and the content rate thereof can be easily maintained and controlled within a desired range at a room temperature and the like. Generally, from the view point of coordinately binding, a compound of primary amine type is preferable for the high binding property, but a compound of secondary amine or tertiary amine type also may be used. In addition, a compound in which adjacent two or more amino groups are involved in the binding, such as a compound of 1,2-diamine or 1,3-diamine type, also may be used. Polyoxyalkyleneamine also may be used. In addition to the above terminal amino groups, compounds also having a hydrophilic terminal-group, such as hydroxyamine which has also a hydroxyl group, for example ethanolamine, may be used.

A typical example of available compounds having a sulfanyl group (-SH) is alkanethiol. Such an alkanethiol that does not detach from a metal element in a normal storage environment, specifically at a temperature of less than 40 °C, in a state where the alkanethiol coordinately binds with the metal element is used suitably, and thus it is preferred to use such an alkanethiol that has a boiling point at a temperature of 60 °C or more, preferably 100 °C or more. For example, as to alkanethiol, C4 - C20 alkyl group is used, and more preferably C8 - C18 alkyl group is used, with a sulfanyl group (-SH) at the terminal of the alkyl chain. For example, the C8 - C18 alkanethiol is preferably used for its handling properties because it has a thermal stability and a vapor pressure which is not very high, and the content rate thereof can be easily maintained and controlled within a desired range at a room temperature and the like. Generally, from the view point of coordinately binding, a compound of primary thiol type is preferable for the high binding property, but a compound of secondary thiol or tertiary thiol type also may be used. A compound in which two or more sulfanyl groups (-SH) are involved in the binding, such as a compound of 1,2-dithiol type, also may be used.

A typical example of available compounds having a hydroxy group is alkanediol. Such an alkanediol that does not detach from a metal element in a normal storage environment, specifically at a temperature of less than 40 °C, in a state where the alkanediol coordinately binds with the metal element is used suitably, and thus it is preferred to use such an alkanediol that has a boiling point at a temperature of 60 °C or more, typically 100 °C or more. For example, a compound in which two or more hydroxy groups are involved in the binding, such as a compound of 1,2-diol type, may be more preferably used.

That is, the metal fine particles dispersed in a resin mixture have surfaces which are covered with one or more compounds having a group containing nitrogen atom, oxygen atom, or sulfur atom, which group can coordinately bind by using the lone pairs of the atoms, as a group that can coordinately bind with the metal element of the metal ultra fine particles, and for example, the surfaces are preferably covered with one or more amine compounds having one or more terminal amino groups. For example, in the preparation of a resin mixture, a state should be obtained where one or more amine compounds of 5 to 60 parts by mass are contained in total relative to the metal fine particles of 100 parts by mass. Preferably, a state should be obtained where one or more amine compounds of 7 to 40 parts by mass, preferably 10 to 30 parts by mass are contained in total relative to the metal fine particles of 100 parts by mass.

The first function of the amine compound which forms the molecule layers covering the surfaces of metal fine particles dispersed in a resin mixture is to, in the preparation of the resin mixture, during a mixing and blending process, prevent the metal fine particles from directly contacting the clean surfaces thereof with each other to adhere and form clusters. Therefore, so long as the covering molecule layers are formed over the surfaces of metal fine particles, a desirable amine compound is, although not particularly limited to the type, such an amine compound that does not easily evaporate at a room temperature. Therefore, as described above, an amine compound having an amino group at the terminal thereof, for example alkylamine, is preferable. More specifically, as to alkylamine, C4 - C20 alkyl group is used, and more preferably C8 - C18 alkyl group is used, with an amino group at the terminal of the alkyl chain. For example, the C8 - C18 alkylamine is preferably used for its handling properties because it has a thermal stability and a vapor pressure which is not very high, and the content rate thereof can be easily maintained and controlled within a desired range at a room temperature and the like. In order to achieve the first function to form covering molecule layers over the surfaces of metal fine particles, the content of the amine compound having an amino group at the terminal thereof, for example alkylamine, should be conveniently selected depending on the entire surface areas of the metal fine particles and in consideration of the type of the metal and the type of amine compound, for example alkylamine. Generally, when C8 - C18 alkylamine is used and the specific gravity of the metal itself is similar to that of silver, gold, and copper for example, and also an average particle size of the metal fine particles is not much less than 10 nm, although the used amount of alkylamine in the covering molecule layer depends on the type and particle size of the metal, the content of alkylamine is preferably selected to be in a range of 5 to 60 parts by mass, more preferably 7 to 40 parts by mass, most preferably 10 to 30 parts by mass relative to the metal fine particles of 100 parts by mass. When an amine compound other than alkylamine is used also, the total content of the amine compound is preferably selected to be in a range of 5 to 60 parts by mass, more preferably 7 to 40 parts by mass, most preferably 10 to 30 parts by mass relative to the metal fine particles of 100 parts by mass.

The layer thickness of the molecule layers covering metal fine particles needs to be uniform independently of an average particle size of the metal fine particles. Therefore, a smaller average particle size of the metal fine particles increases the total surface area of the metal fine particles per unit mass of the metal fine particles, resulting in the increase of the total amount of compounds which are used to form the molecule layer covering the metal fine particles and have a group containing one of nitrogen atom, oxygen atom, and sulfur atom, as a group that can coordinately bind with the metal element. That is, it is desirable to increase or decrease the total amount of compounds having a group containing one of nitrogen atom, oxygen atom, and sulfur atom, as a group that can coordinately bind with the metal element, in inverse proportion to the average particle size of the used metal fine particles.

The metal fine particles themselves in a state the surfaces thereof are protected by the covering molecule layers do not expose the metal surfaces even when they are immersed in an electroless plating solution, and so do not function as nuclei for the precipitation of metal clusters in electroless plating. To the contrary, in the first embodiment and the third embodiment of the present invention, an energy beam irradiation is performed to a desired fine region on a flat surface of the resin mixture coating layer corresponding to a pattern shape of a fine circuit, and then metal fine particles without the covering molecule layers are produced only to the surface portion subjected to the energy beam irradiation to be used as nuclei for the precipitation of metal clusters in electroless plating. The energy beam used for the energy beam irradiation which enhances the detachment of the covering molecule layer protecting the surfaces of the metal fine particles is desirably an electron beam or an ultraviolet ray. That is, it is preferable to use an ultraviolet ray irradiation using a photomask which has an opening of a desired pattern shape, or a highly directional electron beam exposure for a local scanning irradiation of an electron beam corresponding to a desired pattern shape. When an ultraviolet ray having a wavelength in a range of 180 nm or more to 400 nm or less, a visible light having a wavelength in a range of 400 nm to 600 nm, or an excitation by particle beam bombardment is used for the energy beam irradiation, an electron beam of 40 keV or more may be used.

Specifically, the covering molecule layers which protect the surfaces of the metal fine particles exposed on a flat surface of a resin mixture coating layer are selectively detached using an energy supplied from the energy beam to be locally irradiated. At first, the covering molecules in the covering molecule layer which protects a surface of a metal fine particle coordinately bind with the metal atoms contained in the surface. However, when the electrons in the metal which are involved in the coordinately binding are excited, the binding force of the coordinately binding of the molecules is reduced, which promotes the detachment of the covering molecules. While, the metal atoms contained in the surface of the metal fine particle are likely to be oxidized, and an oxide film of about one molecule thick layer is formed on the outermost surface thereof. The formation of the oxide film achieves a state in which the covering molecule that was once detached from the surface will not cover the surface again. However, being immersed in an electroless plating solution, the oxide film formed on the surface of the metal fine particle is quickly reduced, and the particle is converted to the metal fine particle having a clean metal surface. The metal fine particle having a clean metal surface functions as a nucleus for the precipitation of metal atoms which is generated in electroless plating. As a result, an energy beam irradiation to a desired fine region on the flat surface of the resin mixture coating layer enables formation of an electroless plating metal layer only on the fine region subjected to the energy beam irradiation.

When an ultraviolet ray having a wavelength in a range of 180 nm or more to 400 nm or less is used in the energy beam irradiation to the metal fine particles which are exposed on the flat surface of the resin mixture coating layer, it is desirable to set the intensity of the ultraviolet ray which is irradiated to the surface to be in a range of 0.1 J/cm² to 70 J/cm², preferably 0.5 J/cm² to 50 J/cm². Alternatively, when an electron beam of 40 keV or more is used in the energy beam irradiation to the metal fine particles, it is desirable to set the exposure dose of the electron beam to the surface to be in a range of 500 kGy to 6000 kGy.

Based on the condition that the surface of the metal fine particle is provided with an oxide film of about one molecule thick layer formed on the outermost surface thereof after the covering molecules coordinately bound with the surface of the metal fine particle are detached from the surface, and the oxide film is immersed in an electroless plating solution and is quickly reduced, the metal composing the metal fine particle is desirably a metal species or an alloy consisting of two or more metal species which is selected from the group consisting of Pd, Ag, Cu, Au, Pt, Zn, Cr, Fe, and Ni. That is, a precious metal such as Pd, Ag, Au, and Pt that is in an oxidized state to quickly oxidize the reductive compound blended in an electroless plating solution and to be reduced to metal, or a metal species such as Cu₂O, Zn₂O, CrO, FeO, and NiO that generates a metal oxide having a low oxidation number is preferably used.

Meanwhile, the metal species of the electroless plating metal layer is preferably a metal species selected from the group consisting of Pd, Ag, Cu, Au, Pt, Zn, Cr, Fe, and Ni.

When the metal species of the fine metal fine particles which function as the nuclei for plating in electroless plating is a metal which is less noble than the metal species which is used in the plating, with being immersed in an electroless plating solution, the metal species may be partly displaced with the metal species used in the plating by a replacement plating process. After that, the formation of metal clusters in the electroless plating is enhanced using the metal fine particles the surfaces of which are formed of the same metal species as that of the particles, as the nuclei for plating.

In the second approach of the present invention, in conductive circuit manufacturing methods according to the first embodiment and the third embodiment, the embodiment is generally desirable, in which after a uniform resin mixture coating layer is formed on a surface of a non-conductive substrate, an energy beam is irradiated from a desired fine region of the flat surface of the resin mixture coating layer corresponding to a pattern shape of a fine circuit, and metal clusters are selectively precipitated onto the surface region subjected to the energy beam irradiation by electroless plating, so that a plated metal layer having an intended pattern shape is formed to the region.

However, in a conductive circuit manufacturing methods according to the third embodiment in which a non-conductive substrate is not deformed in three dimensions, it is also possible to use such an embodiment in which a resin mixture coating layer having an intended pattern shape is formed on a surface of a non-conductive substrate in advance, and an energy beam irradiation is performed to the entire surface. In the formation of a coating layer of a resin mixture, screen printing, inkjet printing, or transfer printing may be used as an approach for writing and forming the shape of a coating layer in an intended pattern in advance.

Depending on the used printing means, the solution viscosity of the resin mixture comprising metal fine particles therein conveniently should be adjusted. For example, when screen printing is used in writing a fine coating pattern, the solution viscosity of the resin mixture is desirably selected to be in a range of 30 to 300 Pa·s (25 °C). And when transfer printing is used, the solution viscosity of the resin mixture is desirably selected to be in a range of 10 to 500 Pa·s (25 °C). When inkjet printing is used, the solution viscosity of the resin mixture is desirably selected to be in a range of 1 to 100 mPa·s (25 °C).

The solution viscosity of a resin mixture which comprises metal fine particles dispersed in a curable resin composition of a dispersion medium is determined depending on an average particle size of the used metal fine particles, a dispersion concentration in the resin mixture coating layer after a drying treatment, a type of the curable resin composition itself which is the dispersion medium, and a solution viscosity. After an average particle size of the used metal fine particles and a dispersion concentration in the resin mixture coating layer after a drying treatment are selected, a type of the curable resin composition itself which is the dispersion medium and a solution viscosity are conveniently selected to adjust a solution viscosity as intended. That is, depending on a type of the curable resin composition itself which is the dispersion medium, the type and amount of an organic solvent for dilution are conveniently adjusted, so that a solution viscosity of a resin mixture can be adjusted as intended.

In the second approach of the present invention, the conductive circuit manufacturing methods according to the second embodiment and the fourth embodiment have common constitutional features in using an approach, as means for selectively forming an electroless plated layer on a surface of a non-conductive substrate in a desired pattern shape, in which a coating layer of a resin mixture, which comprises metal fine particles uniformly dispersed in a curable binder resin composition, is formed, and an energy beam is irradiated from a region of the surface of the resin mixture coating layer corresponding to the pattern shape so that an electroless plated layer is selectively formed to the surface region subjected to the energy beam irradiation when the resin mixture coating layer is immersed in an electroless plating solution for electroless plating.

An approach is used in which an organic metal compound of fine powder form is closely arranged on a surface of an resin mixture coating layer at a high area density, and the metal ion species contained in the organic metal compound are once converted to the metal oxide fine particles, which are reduced in an electroless plating solution to obtain the nuclei having clean metal surfaces on the surfaces thereof. In the process for converting the metal ion species contained in the organic metal compound to the metal oxide fine particles once, an energy beam is irradiated from the surface so that the organic material components of the organic metal compound are detached and the remained metal ion species is converted to a metal oxide to aggregate as particles of the fine metal oxide. The fine metal oxide is fixedly attached to the surface of an adhesive layer once, but in an electroless plating solution, the metal oxide fine particles are reduced to be the nuclei having clean metal surfaces on the surfaces thereof.

In the second approach of the present invention, in a conductive circuit manufacturing method according to the second embodiment also comprises an operation, after a resin mixture coating layer is formed on a non-conductive substrate surface, for deforming the non-conductive substrate in three dimensions together with a resin mixture coating layer on the surface thereof, as with in the above first embodiment. That is, since the resin mixture coating layer on the surface is not subjected to a curing treatment yet at this point of time, a deforming of the non-conductive substrate in three dimensions causes the resin mixture coating layer to be similarly deformed in three dimensions. Specifically, the resin mixture coating layer which is formed on the surface of non-conductive substrate by coating a resin mixture at a uniform film thickness is subjected to heating at a low temperature and prebaking (drying treatment) for evaporating solvent components contained therein, but the resin mixture coating film after the drying treatment still contains a compound of resin raw materials before a polymerization treatment as its main component, which is in a state having a much higher plastic deformability than that of the material of the non-conductive substrate. So, when the non-conductive substrate is subjected to an operation of deforming in three dimensions to be plastically deformed, the resin mixture coating layer on the surface follows the deformation to be plastically deformed, resulting in that the resin mixture coating layer is similarly deformed in three dimensions. For example, when the non-conductive substrate is uniaxially stretched for a "stretching process" in the longitudinal direction, the thickness of the board is decreased in inverse proportion to the uniaxial stretch ratio. In the process, the resin mixture coating layer on the surface is also subjected to the "stretching process" in the longitudinal direction at the same uniaxial stretch ratio, and the thickness of the coating layer is decreased in inverse proportion to the uniaxial stretch ratio. In the surface of the resin mixture coating layer after the drying treatment, the dispersoid organic metal compound in fine powder form still remained uniformly dispersed in the dried curable binder resin composition. While, the uniaxial stretch ratio of the resin mixture coating layer in the deforming operation in three dimensions to the non-conductive substrate may be in a range of 100% to 600% relative to the original size. The size before the process of the resin mixture coating layer is desirably adjusted so that the resin mixture coating layer may have a film thickness in a range of 0.1 µm to 20 µm, preferably 0.2 µm to 10 µm after the uniaxially stretching process.

The organic metal compound in fine powder form which is dispersed in a resin mixture is preferably selected to be in a range of 0.01 µm to 5 µm, more preferably 0.02 µm to 0.5 µm. The organic metal compound used in the second embodiment and the fourth embodiment of the present invention is preferably a metal salt of organic acid or an organometallic complex. The metal species contained in the organic metal compound is preferably a metal species selected from the group consisting of Pd, Ag, Cu, Au, Pt, Zn, Cr, Fe, and Ni. For example, as a metal salt of organic acid, the one which contains various carboxylic acid anions is preferably used, and as an organometallic complex, the one which contains acetylacetonate ([CH₃-CO-CH-CO-CH₃]⁻) as a ligand for the complex is preferably used. As the precious metal cation species of Pd, Pt, Au, and Ag in an organic metal compound, a cation which has the next oxidation number such as Pd(II)²⁺ and Ag(I)⁺ is preferable, and as a transition metal cation species of Cu, Zn, Cr, Fe, and Ni, a cation which has the next oxidation number such as Cu(II)²⁺ is preferable.

The dispersion density of the organic metal compound in fine powder form which is dispersed in a resin mixture coating layer that is formed on a non-conductive substrate and subjected to a drying treatment is desirably selected to be in a range of 1.0 × 10¹²/mm³ to 3.5 × 10¹⁴/mm³, that is, in a range of 1.0 × 10³/µm3 to 3.5 × 10⁵/µm³, more preferably in a range of 5.0 × 10¹²/mm³ to 1.0 × 10¹⁴/mm³, that is, in a range of 5.0 × 10³/µm³ to 1.0 × 10⁵/µm³. Accordingly, the area density of the organic metal compound fine powders which are exposed on the coating layer surface is preferably in a range of 1.0 × 10¹/µm² to 4 × 10²/µm², more preferably in a range of 0.4 × 10¹/µm² to 2 × 10²/µm². That is, assuming that the organic metal compound fine powders exposed on the coating layer surface is arranged in a square lattice, an average distance between adjacent organic metal compound fine powders are preferably from 0.20 µm to 0.07 µm.

In the state, an energy beam is irradiated to the organic metal compound fine powders exposed on a surface of a coating layer to detach the organic material component, so that the remained metal cation species is converted to a metal oxide which aggregates as particles of the fine metal oxide. The generated particles of the fine metal oxide are exposed on the surface of the coating layer, and then are immersed in an electroless plating solution to be quickly reduced to form particles having clean metal surfaces. The clean metal surfaces of the particles which are arranged on surface of the coating layer at the above area density function as nuclei in an electroless plating process, and produce fine metal clusters having an average particle size in a range of 0.5 µm to 4 µm, resulting in that a coating layer of fine metal clusters produced in the electroless plating is formed covering the almost entire surface of the resin mixture coating layer surface. Then, formation of an electroless plating metal layer is enhanced to further cover the coating layer having the fine metal clusters closely distributed across the entire surface thereof, so that, when the electroless plating metal layer has a film thickness of 1 µm, a compact and uniform plated metal layer is formed which is comparable to an electroless plating metal layer which is formed on an underlayer of a metal film having a uniform surface texture.

The organic metal compound fine powders themselves do not produce metal fine particles by a direct reduction when they are immersed in an electroless plating solution, and so do not function as nuclei for the precipitation of metal clusters in electroless plating. To the contrary, in the second approach of the present invention, in the second embodiment and the fourth embodiment of the present invention, an energy beam irradiation is performed to a desired fine region on a flat surface of the resin mixture coating layer corresponding to a pattern shape of a fine circuit, and then fine particles having clean metal surfaces are produced from the organic metal compound fine powders only to the surface portion subjected to the energy beam irradiation, which are used as nuclei for the precipitation of metal clusters in electroless plating. The energy beam used for the energy beam irradiation which enhances the detachment of the covering molecule layer protecting the surfaces of the metal fine particles is desirably an electron beam or an ultraviolet ray. That is, it is preferable to use an ultraviolet ray irradiation using a photomask which has an opening of a desired pattern shape, or a highly directional electron beam exposure for a local scanning irradiation of an electron beam corresponding to a desired pattern shape. When an ultraviolet ray having a wavelength in a range of 180 nm or more to 400 nm or less, a visible light having a wavelength in a range of 400 nm to 600 nm, or an excitation by particle beam bombardment is used for the energy beam irradiation, an electron beam of 40 keV or more may be used.

Specifically, the organic material component of the organic metal compound are selectively detached from the organic metal compound fine powders exposed on a flat surface of a resin mixture coating layer using an energy supplied from the energy beam to be locally irradiated. At first, in the organic metal compound, the organic material component forms ion binding or ligand binding to the metal cation species. However, when the electrons of the metal cation species in the organic metal compound are excited, the binding force of the ion binding or ligand binding is reduced, which promotes the detachment of the organic material component. While, the metal atoms contained in the surface of the metal fine particle are likely to be oxidized, and an oxide film of about one molecule thick layer is formed on the outermost surface thereof. The excited metal cation species make the oxidized state non-uniform, and forms metal cation species having a higher oxidation number with the metal atoms. The produced metal cation species having a higher oxidation number oxidizes the organic material which exists in the surrounding environment, and the species itself is partly reduced to have the initial oxidation number. As a result, metal atoms are aggregated, and are converted to fine particles having metal oxide films covering the surfaces thereof. The fine particles have an oxide film of about one molecule thick layer formed on the outermost surface individually. When the oxide film is formed, the organic material component that was once detached from the surface cannot easily form ion binding or ligand binding again to form an organic metal compound. However, being immersed in an electroless plating solution, the oxide film formed on the surface of the fine particle is quickly reduced, and the fine particle is converted to a particle having a clean metal surface. The metal fine particle having a clean metal surface functions as a nucleus for the precipitation of metal atoms which are generated in electroless plating. As a result, an energy beam irradiation to a desired fine region on the flat surface of the resin mixture coating layer enables formation of an electroless plating metal layer only on the fine region subjected to the energy beam irradiation.

When an ultraviolet ray having a wavelength in a range of 180 nm or more to 400 nm or less is used in the energy beam irradiation to the organic metal compound fine powders which are exposed on the flat surface of the resin mixture coating layer, it is desirable to set the intensity of the ultraviolet ray which is irradiated to the surface to be in a range of 0.1 J/cm² to 70 J/cm², preferably 0.5 J/cm² to 50 J/cm². Alternatively, when an electron beam of 40 keV or more is used in the energy beam irradiation to the organic metal compound fine powders, it is desirable to set the exposure dose of the electron beam to the surface to be in a range of 500 kGy to 6000 kGy.

Based on the condition that the oxide film of about one molecule thick layer which is formed on the outermost surface of particles from the organic metal compound fine powders is immersed in an electroless plating solution and is quickly reduced, the metal species of the organic metal compound is desirably a metal species selected from the group consisting of Pd, Ag, Cu, Au, Pt, Zn, Cr, Fe, and Ni. That is, a precious metal such as Pd, Ag, Au, and Pt that is in an oxidized state to quickly oxidize the reductive compound blended in an electroless plating solution and to be reduced to metal, or a metal species that generates a metal oxide having a low oxidation number such as Cu₂O, Zn₂O, CrO, FeO, and NiO is preferably used.

While, in the second approach of the present invention, in both of the second embodiment and the fourth embodiment, the metal species of the electroless plating metal layer is preferably a metal species selected from the group consisting of Pd, Ag, Cu, Au, Pt, Zn, Cr, Fe, and Ni.

In the second approach of the present invention, in the conductive circuit manufacturing methods according to the second embodiment and the fourth embodiment, the embodiment is generally desirable, in which after a uniform resin mixture coating layer is formed on a surface of a non-conductive substrate, an energy beam is irradiated from a desired fine region of the flat surface of the resin mixture coating layer corresponding to a pattern shape of a fine circuit, and metal clusters are selectively precipitated onto the surface region subjected to the energy beam irradiation in electroless plating, so that a plated metal layer having an intended pattern shape is formed to the region.

While, in the second approach of the present invention, in a conductive circuit manufacturing method of the fourth embodiment in which a non-conductive substrate is not deformed in three dimensions, it is also possible to use such an embodiment in which a resin mixture coating layer having an intended pattern shape is formed on a surface of a non-conductive substrate in advance, and an energy beam irradiation is performed to the entire surface. In the formation of a coating layer of a resin mixture, screen printing, inkjet printing, or transfer printing may be used as an approach for writing and forming the shape of a coating layer in an intended pattern in advance.

Depending on the used printing means, the solution viscosity of the resin mixture comprising metal fine particles therein conveniently should be adjusted. For example, when screen printing is used in writing a fine coating pattern, the solution viscosity of the resin mixture is desirably selected to be in a range of 30 to 300 Pa·s (25 °C). And when transfer printing is used, the solution viscosity of the resin mixture is desirably selected to be in a range of 10 to 500 Pa·s (25 °C). When inkjet printing is used, the solution viscosity of the resin mixture is desirably selected to be in a range of 1 to 100 mPa·s (25 °C).

The solution viscosity of a resin mixture which comprises fine powders of the organic metal compound dispersed in a curable binder resin composition of a dispersion medium is determined depending on a size of the used organic metal compound fine powders, a dispersion concentration in the resin mixture coating layer after a drying treatment, a type of the curable resin composition itself which is the dispersion medium, and a solution viscosity. After a size of the used organic metal compound fine powders and a dispersion concentration in the resin mixture coating layer after a drying treatment are selected, a type of the curable resin composition itself which is the dispersion medium and a solution viscosity are conveniently selected to adjust a solution viscosity as intended. That is, depending on a type of the curable resin composition itself which is the dispersion medium, the type and amount to be blended of an organic solvent for dilution are conveniently adjusted, so that a solution viscosity of a resin mixture can be adjusted as intended.

As the curable binder resin composition of the dispersion medium, those which are preferably used in the first embodiment and the third embodiment according to the second approach of the present invention are also preferably used in the second embodiment and the fourth embodiment according to the second approach of the present invention. Other than the curable binder resin composition, as the curing conditions of the curable binder resin composition for example, those which are preferably used in the first embodiment and the third embodiment according to the second approach of the present invention are also preferably used in the second embodiment and the fourth embodiment according to the second approach of the present invention.

### III. Third Approach

Similar to the first approach, in a third approach of the present invention also, fine metal surface portions are discretely arranged on a surface made of organic materials at a sufficiently high area density to obtain a function which is substantially the same as that of a uniform metal film surface. As the approach to achieve the above situation, in a third approach of the present invention, for example, a non-conductive substrate itself is formed of a non-conductive material which comprises metal fine particles of an average particle size of 1 to 200 nm uniformly dispersed in a non-conductive resin composition so that a state is established where the metal fine particles are closely arranged on the surface at a high area density with clean metal surfaces being exposed on the surfaces thereof. Specifically, in the first embodiment according to the third approach of the present invention, an approach is used in which metal fine particles having a covering molecule layer to the individual surface thereof are closely arranged on a surface of non-conductive substrate itself at a high area density, and then an energy beam is irradiated from the surface to detach the covering molecule layers and to form metal oxide films on the outermost surface of the metal fine particles once, which are reduced in an electroless plating solution to obtain the nuclei having clean metal surfaces on the surfaces thereof.

And in the second embodiment according to the third approach of the present invention, an approach is used in which a non-conductive substrate itself is formed of a non-conductive material which comprises metal fine particles of an average particle size of 1 to 10 nm uniformly dispersed in a non-conductive resin composition, so that fine particles of an organic metal compound are closely arranged on a surface of the non-conductive substrate at a high area density and metal ion species contained in the organic metal compound is converted to the metal oxide fine particles once, which are reduced in an electroless plating solution to obtain the nuclei having clean metal surfaces on the surfaces thereof. In the process for converting the metal ion species contained in the organic metal compound which form the fine particles of an organic metal compound to the metal oxide fine particles once, an energy beam is irradiated from the surface so that the organic material components of the organic metal compound are detached and the remained metal ion species is converted to metal oxide to aggregate as particles of fine metal oxide. The fine metal oxide is fixedly attached to the surface of the non-conductive substrate once, but in an electroless plating solution, the metal oxide fine particles are reduced to be the nuclei having clean metal surfaces on the surfaces thereof.

In addition, in the third approach of the present invention, the above two steps for the induction by an energy beam irradiation and the conversion to metal oxides are performed using a transition to an excited electronic state which is caused by the energy beam irradiation, and the energy of the energy beam, when photoexcitation is used, is an energy of an ultraviolet ray region within a wavelength range from 180 nm or more to 400 nm or less, or an energy of a visible light region within a wavelength range from 400 nm to 600 nm, and when excitation by particle beam bombardment is used, an electron beam of 40 keV or more can be used.

That is, in a state where metal fine particles are closely arranged at a high area density or fine particles of an organic metal compound are exposed at a high area density on a surface of a non-conductive substrate, when a predetermined energy beam is irradiated, the nuclei having clean metal surfaces on the surfaces thereof are selectively formed to the energy beam irradiated region, and in corresponding to the formation, the precipitation of an electroless plated metal layer is actually enhanced only at the region. In the present invention, the shape pattern of the region where the energy beam is irradiated is determined in advance, which allows the simple control of the formation of an electroless plated layer in an intended pattern shape.

In the third approach of the present invention, a conductive circuit manufacturing method according to the first embodiment uses an approach in which a non-conductive substrate itself is formed of a non-conductive material which comprises metal fine particles of an average particle size of 1 to 200 nm uniformly dispersed in a non-conductive resin composition, thereby the non-conductive resin composition itself causes the metal fine particles to be electrically insulated and separated from each other. And since the non-conductive substrate itself which comprises the uniformly dispersed metal fine particles is deformed in three dimensions, at least the non-conductive resin composition which is used as a binder resin component of the non-conductive material should be a resin which can be plastically deformed as desired. That is, a resin composed of such a material that is excellent in insulation property and can be plastically deformed as desired is desirably selected. Specifically, a resin component to be blended in a non-conductive resin composition may be selected from a group of insulating materials consisting of polyimide, polycarbonate, polyacetal, polyphenylene ether (PPE), polybutylene terephthalate (PPB), polyamide imide, fluorocarbon polymer, polyalylate, polysulfone, polyphenylene sulfide, and polyether ether ketone.

In the third approach of the present invention, in a conductive circuit manufacturing method according to a second embodiment, a non-conductive substrate itself is formed of a non-conductive material which comprises fine particles of an organic metal compound uniformly dispersed in a non-conductive resin composition, and the fine particles of an organic metal compound which are exposed on the surface are eventually converted to metal fine particles to be used. For example, fine particles of an organic metal compound having an average particle size in a range of 1 to 100 nm, particularly an average particle size in a range of 1 to 10 nm are eventually converted to metal fine particles to be used. In the second embodiment also, when the fine particles of an organic metal compound are eventually converted to metal fine particles in the non-conductive substrate, the non-conductive resin composition itself causes the metal fine particles to be electrically insulated and separated from each other. Therefore, a resin composed of such a material that is excellent in insulation property and can be plastically deformed as desired is desirably selected as the non-conductive resin composition. Specifically, a resin component to be blended in a non-conductive resin composition may be selected from a group of insulating materials consisting of polyimide, polycarbonate, polyacetal, polyphenylene ether (PPE), polybutylene terephthalate (PPB), polyamide imide, fluorocarbon polymer, polyalylate, polysulfone, polyphenylene sulfide, and polyether ether ketone.

The dispersion density of the metal fine particles of an average particle size of 1 to 200 nm which is dispersed in a non-conductive resin composition of the non-conductive material that composes the non-conductive substrate is desirably selected to be in a range of 1.0 × 10¹²/mm³ to 3.5 × 10¹⁴/mm³, that is, in a range of 1.0 × 10³/µm³ to 3.5 × 10⁵/µm³, more preferably in a range of 5.0 × 10¹²/mm³ to 1.0 × 10¹⁴/mm³, that is, in a range of 5.0 × 10³/µm³ to 1.0 × 10⁵/µm³. Accordingly, the area density of the metal fine particles which are exposed on a surface of the non-conductive substrate is preferably in a range of 1.0 × 10¹/µm² to 4 × 10²/µm², more preferably in a range of 0.4 × 10²/µm² to 2 × 10²/µm². That is, assuming that the metal fine particles exposed on the non-conductive substrate surface are arranged in a square lattice, an average distance between adjacent metal fine particles are preferably from 0.20 µm to 0.07 µm. In the state, using the clean metal surface of the metal fine particles which are exposed on a surface of the non-conductive substrate as nuclei, fine metal clusters having an average particle size of 0.5 µm to 4 µm are produced in an electroless plating process, thereby a coating layer is formed by the fine metal clusters produced in the electroless plating to cover the almost entire surface of the resin mixture coating layer. Then, formation of an electroless plating metal layer is enhanced to further cover the coating layer having the fine metal clusters closely distributed across the entire surface thereof, so that, when the electroless plating metal layer has a film thickness of 1 µm, a compact and uniform plated metal layer is formed which is comparable to an electroless plating metal layer which is formed on an underlayer of a metal film having a uniform surface texture.

In addition, in the third approach of the present invention, in a conductive circuit manufacturing method according to the first embodiment, in order to obtain a state in which the metal fine particles which have an average particle size of 1 to 200 nm are uniformly dispersed in a non-conductive resin composition, covering molecule layers are provided onto the surfaces of metal fine particles to enhance the dispersibility. Specifically, the metal fine particles are covered with one or more organic compounds which have a group containing nitrogen, oxygen, or sulfur atom, which group can coordinately bind by using the lone pairs of the atoms, as a group that can coordinately bind with the metal element of the metal ultra fine particles, and thereby, the organic compounds form the covering molecule layers on the surfaces. The compound for the covering molecule layer which maintains the dispersibility is preferably an organic compound which has an amino group (-NH₂), a hydroxy group (-OH), or a sulfanyl group (-SH) at the terminal thereof, or an ether (-O-) or sulfide (-S-) in the molecule, and has an excellent affinity with the binder resin component which is used as a dispersion medium in the curable binder resin composition.

Particularly, a selection of an average particle size of the used metal fine particles preferably in a range 1 to 70 nm, more preferably in a range of 1 to 20 nm is effective to keep the uniform dispersibility of the metal fine particles when a dispersion density of the dispersed metal fine particles in the non-conductive resin composition is increased.

The preferable dispersants are those which function to form the molecule layers that cover the surfaces of the metal fine particles and to enhance the dispersibility, and do not easily detach from the surfaces of the metal fine particles at a temperature around 100 °C during a drying treatment to the resin mixture coating layer to evaporate and remove the organic solvent therein. At the same time, the dispersants are required to be selectively detached upon an energy beam irradiation to the surface of the non-conductive substrate after the non-conductive substrate is prepared to have the predetermined initial shape.

A typical example of available compounds having an amino group is alkylamine. Such an alkylamine that does not detach from a metal element in a normal storage environment, specifically at a temperature of less than 40 °C, in a state where the alkylamine coordinately binds with the metal element is used suitably, and thus it is preferred to use such an alkylamine that has a boiling point at a temperature of 60 °C or more, preferably 100 °C or more. For example, as to alkylamine, C4 - C20 alkyl group is used, and more preferably C8 - C18 alkyl group is used, with an amino group at the terminal of the alkyl chain. For example, the C8 - C18 alkylamine is preferably used for its handling properties because it has a thermal stability and a vapor pressure which is not very high, and the content rate thereof can be easily maintained and controlled within a desired range at a room temperature and the like. Generally, from the view point of coordinately binding, a compound of primary amine type is preferable for the high binding property, but a compound of secondary amine or tertiary amine type also may be used. In addition, a compound in which adjacent two or more amino groups are involved in the binding, such as a molecule of 1,2-diamine or 1,3-diamine type, also may be used. Polyoxyalkyleneamine also may be used. In addition to the above terminal amino groups, compounds also having hydrophilic terminal-groups, such as hydroxyamine which has also a hydroxyl group, for example ethanolamine, may be used.

A typical example of available compounds having a sulfanyl group (-SH) is alkanethiol. Such an alkanethiol that does not detach from a metal element in a normal storage environment, specifically at a temperature of less than 40 °C, in a state where the alkanethiol coordinately binds with the metal element is used suitably, and thus it is preferred to use such an alkanethiol that has a boiling point at a temperature of 60 °C or more, preferably 100 °C or more. For example, as to alkanethiol, C4 - C20 alkyl group is used, and more preferably C8 - C18 alkyl group is used, with a sulfanyl group (-SH) at the terminal of the alkyl chain. For example, the C8 - C18 alkanethiol is preferably used for its handling properties because it has a thermal stability and a vapor pressure which is not very high, and the content rate thereof can be easily maintained and controlled within a desired range at a room temperature and the like. Generally, from the view point of coordinately binding, a compound of primary thiol type is preferable for the high binding property, but a compound of secondary thiol or tertiary thiol type also may be used. A compound in which two or more sulfanyl groups (-SH) are involved in the binding, such as a compound of 1,2-dithiol type, also may be used.

A typical example of available compounds having hydroxy groups is alkanediol. Such an alkanediol that does not detach from a metal element in a normal storage environment, specifically at a temperature of less than 40 °C, in a state where the alkanediol coordinately binds with the metal element is used suitably, and thus it is preferred to us such an alkanediol that has a boiling point at a temperature of 60 °C or more, typically 100 °C or more. For example, a compound in which two or more hydroxy groups, such as a compound of 1,2-diol type, are involved in the binding may be more preferably used.

That is, the metal fine particles dispersed in a non-conductive substrate have surfaces which are covered with one or more compounds having a group containing nitrogen atom, oxygen atom, or sulfur atom, which group can coordinately bind by using the lone pairs of the atoms, as a group that can coordinately bind with the metal element of the metal ultra fine particles, and for example, the surfaces are preferably covered with one or more amine compounds having one or more terminal amino groups. For example, in the preparation of a resin mixture, a state should be obtained where one or more amine compounds of 5 to 60 parts by mass are contained in total relative to the metal fine particles of 100 parts by mass. Preferably, a state should be obtained where one or more amine compounds of 7 to 40 parts by mass, preferably 10 to 30 parts by mass are contained in total relative to the metal fine particles of 100 parts by mass.

The first function of the amine compound which forms the molecule layers covering the surfaces of metal fine particles dispersed in a non-conductive substrate is to, in the preparation of the non-conductive resin material, during a process for mixing and blending metal fine particles, prevent the metal fine particles from directly contacting the clean surfaces thereof with each other to adhere and form clusters in the non-conductive resin composition. Therefore, so long as the covering molecule layers are formed over the surfaces of metal fine particles, a desirable amine compound is, although not particularly limited to the type, such an amine compound that does not easily evaporate at a room temperature. Therefore, as described above, an amine compound having an amino group at the terminal thereof, for example alkylamine, is preferable. More specifically, as to alkylamine, C4 - C20 alkyl group is used, and more preferably C8 - C18 alkyl group is used, with an amino group at the terminal of the alkyl chain. For example, the C8 - C18 alkylamine is preferably used for its handling properties because it has a thermal stability and a vapor pressure which is not very high, and the content rate thereof can be easily maintained and controlled within a desired range at a room temperature and the like. In order to achieve the first function to form covering molecule layers over the surfaces of metal fine particles, the content of the amine compound having an amino group at the terminal thereof, for example alkylamine, should be conveniently selected depending on the entire surface areas of the metal fine particles and in consideration of the type of the metal and the type of amine compound, for example alkylamine. Generally, when C8 - C18 alkylamine is used and the specific gravity of the metal itself is similar to that of silver, gold, and copper for example, and also an average particle size of the metal fine particles is not much less than 10 nm, although the used amount of alkylamine in the covering molecule layer depends on the type and particle size of the metal, the content of alkylamine is preferably selected to be in a range of 5 to 60 parts by mass, more preferably 7 to 40 parts by mass, most preferably 10 to 30 parts by mass relative to the metal fine particles of 100 parts by mass. When an amine compound other than alkylamine is used also, the total content of the amine compound is preferably selected to be in a range of 5 to 60 parts by mass, more preferably 7 to 40 parts by mass, most preferably 10 to 30 parts by mass relative to the metal fine particles of 100 parts by mass.

The layer thickness of the molecule layers covering metal fine particles needs to be uniform independently of an average particle size of the metal fine particles. Therefore, a smaller average particle size of the metal fine particles increases the total surface area of the metal fine particles per unit mass of the metal fine particles, resulting in the increase of the total amount of compounds which are used to form the molecule layer covering the metal fine particles and have a group containing one of nitrogen atom, oxygen atom, and sulfur atom, as a group that can coordinately bind with the metal element. That is, it is desirable to increase or decrease the total amount of compounds having the group containing one of nitrogen atom, oxygen atom, and sulfur atom, as a group that can coordinately bind with the metal element, in inverse proportion to the average particle size of the used metal fine particles.

The metal fine particles themselves in a state the surfaces thereof are protected by the covering molecule layers do not expose the metal surfaces even when they are immersed in an electroless plating solution, and so do not function as nuclei for the precipitation of metal clusters in electroless plating. To the contrary, in the first embodiment of the present invention, an energy beam irradiation is performed to a desired fine region on a flat surface of the resin mixture coating layer corresponding to a pattern shape of a fine circuit, and then metal fine particles without the covering molecule layers are produced only to the surface portion subjected to the energy beam irradiation to be used as nuclei for the precipitation of metal clusters in electroless plating. The energy beam used for the energy beam irradiation which enhances the detachment of the covering molecule layer protecting the surfaces of the metal fine particles is desirably an electron beam or an ultraviolet ray. That is, it is preferable to use an ultraviolet ray irradiation using a photomask which has an opening of a desired pattern shape, or a highly directional electron beam exposure for a local scanning irradiation of an electron beam corresponding to a desired pattern shape. When an ultraviolet ray having a wavelength in a range of 180 nm or more to 400 nm or less, a visible light having a wavelength in a range of 400 nm to 600 nm, or an excitation by particle beam bombardment is used for the energy beam irradiation, an electron beam of 40 keV or more may be used.

Specifically, the covering molecule layers which protect the surfaces of the metal fine particles exposed on a flat surface of a non-conductive substrate in the initial shape are selectively detached using an energy supplied from the energy beam to be locally irradiated. At first, the covering molecules in the covering molecule layer which protects a surface of a metal fine particle coordinately bind with the metal atoms contained in the surface. However, when the electrons in the metal which are involved in the coordinately binding are excited, the binding force of the coordinately binding of the molecules is reduced, which promotes the detachment of the covering molecules. While, the metal atoms contained in the surface of the metal fine particle are likely to be oxidized, and an oxide film of about one molecule thick layer is formed on the outermost surface thereof. The formation of the oxide film achieves a state in which the covering molecule that was once detached from the surface will not cover the surface again. However, being immersed in an electroless plating solution, the oxide film formed on the surface of the metal fine particle is quickly reduced, and the particle is converted to the metal fine particle having a clean metal surface. The metal fine particle having a clean metal surface functions as a nucleus for the precipitation of metal atoms which is generated in electroless plating. As a result, an energy beam irradiation to a desired fine region on the flat surface of the non-conductive substrate enables formation of an electroless plating metal layer only on the fine region subjected to the energy beam irradiation.

When an ultraviolet ray having a wavelength in a range of 180 nm or more to 400 nm or less is used in the energy beam irradiation to the metal fine particles which are exposed on the flat surface of the non-conductive substrate, it is desirable to set the intensity of the ultraviolet ray which is irradiated to the surface to be in a range of 0.1 J/cm² to 70 J/cm², preferably 0.5 J/cm² to 50 J/cm². Alternatively, when an electron beam of 40 keV or more is used in the energy beam irradiation to the metal fine particles, it is desirable to set the exposure dose of the electron beam to the surface to be in a range of 500 kGy to 6000 kGy.

Based on the condition that, after the covering molecules which coordinately bound with the surface of the metal fine particle are detached from the surface, the oxide film of about one molecule thick layer formed on the outermost surface thereof is immersed in an electroless plating solution and is quickly reduced, the metal composing the metal fine particles is preferably a metal species or an alloy consisting of two or more metal species which is selected from the group consisting of gold, silver, copper, platinum, palladium, zinc, iron, chromium, and nickel. That is, a precious metal such as Pd, Ag, Au, and Pt that is in an oxidized state to quickly oxidize the reductive compound blended in an electroless plating solution and to be reduced to metal, or a metal species such as Cu₂O, Zn₂O, CrO, FeO, and NiO that generates a metal oxide having a low oxidation number is preferably used.

While, the metal species which forms the electroless plating metal layer is also preferably a metal species selected from the group consisting of gold, silver, copper, platinum, palladium, zinc, iron, chromium, and nickel.

When the metal species of the fine metal fine particles which function as the nuclei for plating in electroless plating is a metal which is less noble than the metal species which is used in the plating, with being immersed in an electroless plating solution, the metal species may be partly displaced with the metal species used in the plating by a replacement plating process. After that, the formation of metal clusters in the electroless plating is enhanced using the metal fine particles the surfaces of which are formed of the same metal species as that of the particles, as the nuclei for plating.

In the third approach of the present invention, in a conductive circuit manufacturing method according to the second embodiment, an approach is used as means for selectively forming an electroless plated layer on a surface of a non-conductive substrate in a desired pattern shape, in which after a non-conductive substrate itself is formed of a non-conductive material comprising fine particles of an organic metal compound uniformly dispersed in a non-conductive resin composition, fine particles of the organic metal compound are closely arranged on a surface of the non-conductive substrate at a high area density, and the metal ion species contained in the organic metal compound is converted to the metal oxide fine particles once, which are reduced in an electroless plating solution to obtain the nuclei having clean metal surfaces on the surfaces thereof. For example, an average particle size of the fine particles of an organic metal compound may be selected to be in a range of 1 to 100 nm, especially 1 to 10 nm. In the process for converting the metal ion species contained in the organic metal compound which form the fine particles of an organic metal compound to the metal oxide fine particles once, an energy beam is irradiated from the surface so that the organic material components of the organic metal compound are detached and the remained metal ion species is converted to metal oxide to aggregate as particles of fine metal oxide. The fine metal oxide is fixedly attached to the surface of the non-conductive substrate once, but in an electroless plating solution, the metal oxide fine particles are reduced to be the nuclei having clean metal surfaces on the surfaces thereof.

Desirably the fine particles of an organic metal compound which is dispersed in the non-conductive resin composition are retained in a uniformly dispersed state, with the organic metal compound of the fine particles itself being not dissolved in the non-conductive resin composition. For example, an organic metal compound in fine powder form which id formed of fine particles of an organic metal compound having an average particle size in a range of 1 to 100 nm, particularly an average particle size in a range of 1 to 10 nm is desirably retained in a uniformly dispersed state. That is, in the process for blending the fine particles of an organic metal compound which is prepared to have the above average particle size in to a non-conductive resin composition to be uniformly dispersed, desirably, as the dissolution is developed, the decrease of the number or reprecipitation of the fine particles will not cause the increase of particles size of the remained fine particles. In the second embodiment of the third method of the present invention, as the organic metal compound of the used fine particles of an organic metal compound, a metal salt of organic acid or an organometallic complex is preferable. In this case, the metal species contained in the organic metal compound is preferably a metal species selected from the group consisting of gold, silver, copper, platinum, palladium, zinc, iron, chromium, and nickel. For example, as a metal salt of organic acid, the one which contains various carboxylic acid anions is preferably used, and as an organometallic complex, the one which contains acetylacetonate ([CH₃-CO-CH-CO-CH₃]⁻) as a ligand for the complex is preferably used. As the precious metal cation species of Pd, Pt, Au, and Ag in an organic metal compound, a cation which has the next oxidation number such as Pd(II)²⁺ and Ag(l)⁺ is preferable, and as a transition metal cation species of Cu, Zn, Cr, Fe, and Ni, a cation which has the next oxidation number such as Cu(II)²⁺ is preferable.

The dispersion density of fine particles of an organic metal compound which is dispersed in a non-conductive substrate is desirably selected to be in a range of 1.0 × 10¹²/mm³ to 3.5 × 10¹⁴/mm³, that is, in a range of 1.0 × 103/µm³ to 3.5 × 10⁵/µm³, more preferably in a range of 5.0 × 10¹²/mm³ to 1.0 × 10¹⁴/mm³, that is, in a range of 5.0 × 10³/µm³ to 1.0 × 10⁵/µm³. Accordingly, the area density of the fine particles of the organic metal compound which are exposed on a surface of the non-conductive substrate is preferably in a range of 1.0 × 10¹/µm² to 4 × 10²/µm², more preferably in a range of 0.4 × 10¹/µm² to 2 × 10²/µm². That is, assuming that the fine particles of the organic metal compound exposed on the non-conductive substrate surface are arranged in a square lattice, an average distance between adjacent fine particles of the organic metal compound are preferably from 0.20 µm to 0.07 µm.

In the state, an energy beam is irradiated to the fine particles of the organic metal compound exposed on a surface of the non-conductive substrate to detach the organic material component, so that the remained metal cation species is converted to a metal oxide which aggregates as particles of the fine metal oxide. The generated particles of the fine metal oxide are exposed on the surface of the non-conductive substrate, and then are immersed in an electroless plating solution to be quickly reduced to form particles having clean metal surfaces. The clean metal surfaces of the particles which are arranged on the surface of the non-conductive substrate at the above area density function as nuclei in an electroless plating process, and produce fine metal clusters having an average particle size in a range of 0.5 µm to 4 µm, resulting in that a coating layer of fine metal clusters produced in the electroless plating is formed covering only the region of the surface subjected to the energy beam irradiation. Then, formation of an electroless plating metal layer is enhanced to further cover the coating layer having the fine metal clusters closely distributed across the entire surface thereof, so that, when the electroless plating metal layer has a film thickness of 1 µm, a compact and uniform plated metal layer is formed which is comparable to an electroless plating metal layer which is formed on an underlayer of a metal film having a uniform surface texture.

The fine particles of an organic metal compound themselves do not produce metal fine particles by a direct reduction when they are immersed in an electroless plating solution, and so do not function as nuclei for the precipitation of metal clusters in electroless plating. To the contrary, in the third approach of the present invention, in the second embodiment, an energy beam irradiation is performed to a desired fine region on a flat surface of a non-conductive substrate corresponding to a pattern shape of a fine circuit before a deforming operation in three dimensions, and then fine particles having clean metal surfaces are produced from fine particles of the organic metal compound only to the surface portion subjected to the energy beam irradiation, which are used as nuclei for the precipitation of metal clusters in electroless plating. The energy beam used for the energy beam irradiation which enhances the detachment of the organic material component of the organic metal compound is desirably an electron beam or an ultraviolet ray. That is, it is preferable to use an ultraviolet ray irradiation using a photomask which has an opening of a desired pattern shape, or a highly directional electron beam exposure for a local scanning irradiation of an electron beam corresponding to a desired pattern shape. When an ultraviolet ray having a wavelength in a range of 180 nm or more to 400 nm or less, a visible light having a wavelength in a range of 400 nm to 600 nm, or an excitation by particle beam bombardment is used for the energy beam irradiation, an electron beam of 40 keV or more may be used.

Specifically, from the fine particles of an organic metal compound exposed on a flat surface of a non-conductive substrate, the organic material component of the organic metal compound are selectively detached using an energy supplied from the energy beam to be locally irradiated. At first, in the organic metal compound, the organic material component forms ion binding or ligand binding to the metal cation species. However, when the electrons of the metal cation species in the organic metal compound are excited, the binding force of the ion binding or ligand binding is reduced, which promotes the detachment of the organic material component. While, the excited metal cation species make the oxidized state non-uniform, and forms metal cation species having a higher oxidation number with the metal atoms. The produced metal cation species having a higher oxidation number oxidizes the organic material which exists in the surrounding environment, and the species itself is partly reduced to have the initial oxidation number. As a result, metal atoms are aggregated, and are converted to fine particles having metal oxide films covering the surfaces thereof. The fine particles have an oxide film of about one molecule thick layer formed on the outermost surface individually. When the oxide film is formed, the organic material component that was once detached from the surface cannot easily form ion binding or ligand binding again to form an organic metal compound. However, being immersed in an electroless plating solution, the oxide film formed on the surface of the fine particle is quickly reduced, and the fine particle is converted to a particle having a clean metal surface. The metal fine particle having a clean metal surface functions as a nucleus for the precipitation of metal atoms which are generated in electroless plating. As a result, before a deforming operation in three dimensions, an energy beam irradiation to a desired fine region on the flat surface of the non-conductive substrate enables formation of an electroless plating metal layer only on the fine region subjected to the energy beam irradiation.

When an ultraviolet ray having a wavelength in a range of 180 nm or more to 400 nm or less is used in the energy beam irradiation to fine particles of the organic metal compound which are exposed on the flat surface of the non-conductive substrate, it is desirable to set the intensity of the ultraviolet ray which is irradiated to the surface to be in a range of 0.1 J/cm² to 70 J/cm², preferably 0.5 J/cm² to 50 J/cm². Alternatively, when an electron beam of 40 keV or more is used in the energy beam irradiation to the fine particles of the organic metal compound, it is desirable to set the exposure dose of the electron beam to the surface to be in a range of 500 kGy to 6000 kGy.

Based on the condition that that the oxide film of about one molecule thick layer which is formed on the outermost surface of particles from the fine particles of the organic metal compound is immersed in an electroless plating solution and is quickly reduced, the metal species of the organic metal compound is preferably a metal species selected from the group consisting of gold, silver, copper, platinum, palladium, zinc, iron, chromium, and nickel. That is, a precious metal such as Pd, Ag, Au, and Pt that is in an oxidized state to quickly oxidize the reductive compound blended in an electroless plating solution and to be reduced to metal, or a metal species that generates a metal oxide having a low oxidation number such as Cu₂O, Zn₂O, CrO, FeO, and NiO is preferably used.

In the third approach of the present invention, in the second embodiment also, the metal species which forms the electroless plating metal layer is also preferably a metal species selected from the group consisting of gold, silver, copper, platinum, palladium, zinc, iron, chromium, and nickel.

In performing a deforming operation in three dimensions to a non-conductive substrate, independently of the shape after the deforming in three dimensions, the area density of the metal fine particles or fine particles of an organic metal compound which are exposed on a region of a surface subjected to an energy beam irradiation in advance is substantially the same. In other words, independently of the shape after the deforming in three dimensions, in the regions of a surface where an energy beam is irradiated in advance, the nuclei having clean metal surfaces on the surfaces thereof are produced at the substantially the same area densities when fine particles having covering films of a metal oxide on the surfaces thereof which are produced from the metal fine particles or fine particles of an organic metal compound are immersed in an electroless plating solution. Therefore, in the third approach of the present invention, in performing a deforming operation in three dimensions to a non-conductive substrate, the shape after the deforming in three dimensions may be arbitrarily selected. For example, as with the shape after the deforming in three dimensions, an embossed surface may be deformed as a microscopic shape of a surface, independently of the entire shape of the surface. The embossed surface has a relatively large pattern shape compared to that of a plated film in the contact surface area between the plated film and the non-conductive substrate. As a result, the adhesion between non-conductive substrate and the plated film is enhanced.

In the above described first approach and the second approach of the present invention, a non-conductive substrate and a plated film which is formed in a desired shape pattern are adhesively bonded to each other through a curable binder resin as an adhesive layer. Therefore, the adhesion at the interface between the curable binder resin and the non-conductive substrate depends on the material used in the non-conductive substrate and the type of the curable binder resin. If there is a difference between the thermal expansion coefficient of the non-conductive substrate and that of the curable binder resin, due to the repeated changes of the ambient temperature, distortion stress is concentrated on the interface between the curable binder resin and the non-conductive substrate, which may lead to a peeling or removing in a prolonged use. In order to avoid the problems which affect a long-term reliability, preferably the material used in the non-conductive substrate and the type of the curable binder resin should be properly selected.

While, in the third approach of the present invention, since metal fine particles or fine particles of an organic metal compound are dispersed onto a non-conductive substrate itself, as described above, an advantage is obtained that essentially there is not a problem of peeling or removing at the interface between a curable binder resin and the non-conductive substrate when a shape after the deforming in three dimensions are arbitrarily selected. However, the weight of a non-conductive substrate per unit thickness is increased since metal fine particles or fine particles of an organic metal compound are dispersed to the non-conductive substrate itself. To improve this, a non-conductive substrate of a core structure which has a central part formed of only a non-conductive resin composition and a surface part having metal fine particles or fine particles of an organic metal compound uniformly dispersed therein may be used.

### Examples

Now, the present invention will be further explained in detail by way of examples.

### I. First Approach

First, a conductive circuit manufacturing method according to a first approach of the present invention will be explained in detail with reference to Examples.

The following Examples 1-1 to 1-8 are the examples of the best mode of the first approach of the present invention, but the first approach of the present invention is not limited to the Examples.

In the Examples 1-1 to 1-8 described below, as an "ultraviolet ray irradiation treatment", the following operation is used. And a resulting electroless plated layer is evaluated using the following conditions and criteria for each evaluation item.

### 1. "Ultraviolet Ray Irradiation Treatment"

An ultraviolet ray exposure apparatus which uses an ultra-highpressure mercury lamp of 2 kW is used as a source of ultraviolet ray so that a surface is exposed to an ultraviolet ray in a perpendicular direction to the surface. In the exposure, the exposure dose of the ultraviolet ray (irradiation intensity of light) is adjusted based on the intensity of light which is measured at a wavelength of 365 nm.

### 2. Evaluation of Electroless Plated Layer

"Volume Resistivity": In accordance with the test method of volume resistivity which is described in JIS-H-8646, a width (W), a length (L) of a forming rectangular electroless plated layer, and a mean thickness (T) of the cross-section of the electroless plated layer are measured, and a resistance value is measured using a 4 terminal method, thereby a volume resistivity is calculated for an assumed homogeneous conductor having the mean thickness (T).

An electroless plated layer of copper having a measured volume resistivity of 10 µΩ·cm or less is considered to be a quality product.

"Adhesion Strength": In accordance with the tape test described in JIS-H-8504, a tape is pressed against a surface of a forming electroless plated layer for 10 seconds to adhere without air bubbles at the interface between the surface and the tape, and the adhesion tape is quickly removed. The adhesion force of the adhesion tape corresponds to 120 gf/cm.

An electroless plated layer on which no removed portion is observed on the tape-removed adhesion surface thereof is considered to be a quality product.

### (Example 1-1)

A resin mixture (adhesive for plating) having the following composition was prepared as a resin mixture which comprises metal fine particles of an average particle size of 1 to 200 nm uniformly dispersed in a curable binder resin composition.

The curable binder resin composition used as a dispersion medium was a thermosetting epoxy resin composition having the following composition. The thermosetting epoxy resin composition comprised: 1,6-dihydroxy naphthalene diglycidyl ether, EPICLON HP-4032 (epoxy equivalent weight 142) of 7 parts by mass, and bisphenol A epoxy resin, EPICOAT 828EL (epoxy equivalent weight 187) of 3 parts by mass, as epoxy resin components; acid anhydride, YH-307 (molecular weight 235) of 13.8 parts by mass, as a curing agent component; an amine based curing catalyst, Amicure PN-23 of 0.3 parts by mass, as a curing accelerator; and KBM-403 of 0.1 parts by mass as a coupling agent component. These components were sufficiently mixed and blended to prepare a resin composition.

To the resin composition of 70 parts by mass, a dispersion containing Ag ultra fine particles having an average particle size of 5 nm (product name: Perfect Silver, dispersed ultra fine particles manufactured by Vacuum Metallurgical Co., Ltd.) of 30 parts by mass as dispersoid metal fine particles in a toluene dispersion solvent component of 55.7 parts by mass was added, and the particles were uniformly dispersed using three rollers to prepare a resin mixture in paste form. The Ag ultra fine particles having an average particle size of 5 nm comprised Ag ultra fine particles having a metal surface individually on which a covering layer of covering molecule dodecylamine was formed, and the covering molecule dodecylamine was contained by 15 parts by mass relative to the Ag ultra fine particles of 100 parts by mass. Eventually, the mixed toluene was distilled off in a reduced pressure to obtain an intended resin mixture (adhesive for plating) in paste form.

The obtained resin mixture in paste form had a liquid viscosity of 40 Pa·s (25 °C). When the curable binder resin composition used as a dispersion medium was subjected to a heat curing treatment at a temperature in a range of 100 °C to 160 °C, the coating layer of a resin mixture in paste form functioned as an adhesive layer having a high adhesion strength to a non-conductive substrate to which a conductive circuit is manufactured, for example various polymeric film (sheet) surfaces.

A rectangular coating film of the resin mixture in paste form having a width 5 mm, a length 20 mm, and a mean coating film thickness of 19 µm was formed on a surface of polycarbonate non-conductive substrate in sheet form having a thickness of a 0.5 mm (LEXAN 8010: manufactured by Piedomont Plastic, Inc) by mask printing using a metal mask having a thickness of 20 µm. Then, the film was dried for 10 minutes at a temperature of 110 °C to form a covering film layer (coating layer) having a mean film thickness of 18 µm without a tuck on the surface.

As an "ultraviolet ray irradiation treatment" to the resin mixture coating layer on the polycarbonate film after the drying treatment, the surface was irradiated with an ultraviolet ray in an exposure dose of 45 J/cm² (wavelength 365 nm) using the above described ultraviolet ray exposure apparatus.

After the ultraviolet ray irradiation, the board before a deforming operation in three dimensions is set to be Sample A.

Also after the ultraviolet ray irradiation, the polycarbonate substrate was rolled up with the coating layer out to form a cylinder having a radius of about 3 cm and the two ends of the rolled substrate are adhesively fixed, which is set to be Sample B. That is, the ratio of radius of curvature/substrate thickness corresponds to 30/0.5, and the entire coating layer was stretchedly deformed at a ratio of 1 + (0.5/30).

Furthermore, after the ultraviolet ray irradiation, the polycarbonate substrate was rolled up with the coating layer in to form a cylinder having a radius of about 3 cm and the two ends of the rolled substrate are adhesively fixed, which is set to be Sample C. That is, the ratio of radius of curvature/substrate thickness corresponds to 30/0.5, and the entire coating layer was compressed deformed at a ratio of 1 - (0.5/30).

To the obtained three samples, three commercially available plating solutions, MK-421A, MK-421 B, MK-421 M (manufactured by Muromachi Technos Co., Ltd.) each of which was diluted with water at the above ratio and had the following composition are used for an electroless plating process:
MK-421A (copper component + HCHO) 0.035 L
MK-421 B (sodium hydroxide) 0.035 L
MK-421 M (sodium hydroxide) 0.100 L
Water 0.830 L

The polycarbonate substrate was immersed in an electroless plating solution (MK-421, manufactured by Muromachi Technos Co., Ltd.) at 40 °C for three hours to perform a treatment of electroless plating of copper to the surface of the substrate. During the immersion, the precipitation of the electroless plating copper covering layer was selectively enhanced on the surface of the resin mixture coating layer after the "ultraviolet ray irradiation treatment" which was formed on each non-conductive substrate surface, while no precipitation of the electroless plating copper covering layer was observed on the surface where each non-conductive substrate surface itself was exposed.

After non-conductive substrates were recovered from the electroless plating solution and the remained plating solution were rinsed, each of the non-conductive substrates was heated at 130 °C for three hours in a constant temperature furnace in an inert atmosphere to thermally cure the thermosetting epoxy resin composition contained in the resin mixture coating layer. Finally, the electroless plating copper layer fixedly attached to the surface of each non-conductive substrate via the cured layer of the thermosetting epoxy resin as an adhesive layer was evaluated with respect to a "volume resistivity" and an "adhesion strength" in accordance with the above described evaluation methods.

All of the electroless plating copper layers formed had the average layer thickness of 7 µm, and no removed portion was observed in the above described tape removing test. And Sample A had a volume resistivity of 4.3 µΩ·cm, Sample B had a volume resistivity of 4.2 µΩ·cm, and Sample C had a volume resistivity of 4.6 µΩ·cm, which means all of the Samples meet the criteria for "quality product" to have a volume resistivity of 10 µΩ·cm or less.

### (Example 1-2)

Using the resin mixture in paste form (adhesive for plating) which was formed in a similar manner to that in Example 1-1, a rectangular coating film of the resin mixture in paste form having a width 5 mm, a length 30 mm, and a mean coating film thickness of 19 µm was formed on a surface of polycarbonate non-conductive substrate in sheet form having a thickness of 0.5 mm (LEXAN 8010: manufactured by Piedomont Plastic, Inc) by mask printing using a metal mask having a thickness of 20 µm. Then, the film was dried for 10 minutes at a temperature of 110 °C to form a covering film layer (coating layer) having a mean film thickness of 18 µm without a tuck on the surface.

After the drying treatment, as an "ultraviolet ray irradiation treatment" to the resin mixture coating layer on the polycarbonate substrate, the surface was irradiated with an ultraviolet ray in an exposure dose of 45 J/cm² (wavelength 365 nm) using the above described ultraviolet ray exposure apparatus.

After the ultraviolet ray irradiation, the board before a deforming operation in three dimensions is set to be Sample D.

After the "ultraviolet ray irradiation treatment", the polycarbonate substrate is subjected to a deforming operation in three dimensions to have a shape with a bended portion, which is set to be Sample E. In the bended portion, the formed corner was configured to have an angle between surfaces of 120 °/240 °, and the local radius of curvature at the corner corresponds to 10 mm. That is, the value of radius of curvature/substrate thickness corresponded to 10/0.5, which means the coating layer was locally deformed in a stretched manner at a ratio of 1 + (0.5/10) at the convex side of the corner, and was locally deformed in a compressed manner at a ratio of 1 - (0.5/10) at the concave side of the corner.

The obtained two samples were subjected to an electroless plating process in a similar manner to that in Example 1-1, each of the non-conductive substrates after the plating treatment was heated at 130 °C for three hours in a constant temperature furnace in an inert atmosphere to thermally cure the thermosetting epoxy resin composition contained in the resin mixture coating layer. Finally, the electroless copper plating layers fixedly attached to the surface of each non-conductive substrate via the cured layer of the thermosetting epoxy resin as an adhesive layer was evaluated with respect to a "volume resistivity" and "adhesion strength" in accordance with the above described evaluation methods.

All of the electroless plating copper layers formed had the average layer thickness of 7 µm, and no removed portion was observed in the above described tape removing test. And Sample D had a volume resistivity of 4.5 µΩ·cm and Sample E had a volume resistivity of 5.4 µΩ·cm, which means both of Samples meet the criteria for "quality product" to have a volume resistivity of 10 µΩ·cm or less.

### (Examples 1-3 to 1-8)

Using the paste-form resin mixture (adhesive for plating) which was prepared in a similar manner to that in Example 1-1, a rectangular coating film of the resin mixture in paste form having a width 5 mm, a length 30 mm, and a mean coating film thickness of 19 µm was formed to surfaces of the various non-conductive substrates in sheet form shown in Table 1 by mask printing using a metal mask having a thickness of 20 µm. Then, the film was dried for 10 minutes at a temperature of 110 °C to form a covering film layer (coating layer) having a mean film thickness of 18 µm without a tuck on the surface.

As an "ultraviolet ray irradiation treatment" to the resin mixture coating layer on the substrate, the surface was irradiated with an ultraviolet ray in an exposure dose of 45 J/cm² (wavelength 365 nm) using the above described ultraviolet ray exposure apparatus.

The substrates after the ultraviolet ray irradiation treatment are deformed to have a shape with a bended portion, which is set to be Sample F. All of the substrates had a thickness of 0.5 mm, and in the bended portion, the formed corner was configured to have an angle between surfaces of 120 °/240 °, and the local radius of curvature at the corner corresponded to 10 mm. Therefore, the value of radius of curvature/substrate thickness corresponded to 10/0.5, which means the coating layer was locally deformed in a stretched manner at a ratio of 1 + (0.5/10) at the convex side of the corner, and was locally deformed in a compressed manner at a ratio of 1 - (0.5/10) at the concave side of the corner.

Each of the obtained samples was subjected to an electroless plating process in a similar manner to that in Example 1-1, each of the non-conductive substrates after the plating treatment was heated at 130 °C for three hours in a constant temperature furnace in an inert atmosphere to thermally cure the thermosetting epoxy resin composition contained in the resin mixture coating layer. Finally, the electroless plating copper layer fixedly attached to the surface of each non-conductive substrate via the cured layer of the thermosetting epoxy resin as an adhesive layer was evaluated with respect to a "volume resistivity" and "adhesion strength" in accordance with the above described evaluation methods.

The average layer thickness and volume resistivity of each of the electroless plating copper layers formed are shown in Table 1.

**[Table 1]**

| Example | Material of Substrate (Manufacturer and Product Name) | Deforming | Mean layer thickness µm | Volume Resistivity µΩ·cm |
|---|---|---|---|---|
| 1-3 | Polyimide (manufactured by DuPont) Vespel TP-8005 | No | 7 | 3.6 |
| | | Yes | 7 | 4.3 |
| 1-4 | Polyacetal (manufactured by Asahi Kasei Corp.) TENAC-C HC450 | No | 7 | 5.7 |
| | | Yes | 7 | 6.0 |
| 1-5 | Polyphenylenether (manufactured by Asahi Kasei Corp.) Xyron 340V | No | 7 | 7.0 |
| | | Yes | 7 | 7.1 |
| 1-6 | Polybutylene Terephthalate (manufactured by WinTech Polymer Ltd.) DURANEX 2002 | No | 7 | 4.9 |
| | | Yes | 7 | 4.5 |
| 1-7 | Fluorinated Resin (manufactured by Asahi Glass Corp.) Fluon LM-730AP | No | 7 | 7.3 |
| | | Yes | 7 | 6.6 |
| 1-8 | Polyether ether ketone (manufactured by Sumitomo Chemical Co., Ltd.) SumiproyK TK3420 | No | 7 | 5.8 |
| | | Yes | 7 | 6.8 |

No removed portion was observed in the above electroless plating copper layers in the above described tape removing test. And all of the electroless plated layers had a volume resistivity, which means all layers meet the criteria for "good quality product" to have a volume resistivity of 10 µΩ·cm or less.

### II. Second Approach

Next, a conductive circuit manufacturing method according to a second approach of the present invention will be explained in detail with reference to Examples.

The following Examples 2-1 to 2-8 are the examples of the best mode of the second approach of the present invention, but the second approach of the present invention is not limited to the Examples.

In Example 2-1 to 2 -10 and Comparative Examples 2-1 to 2-2, as a "stretching process" and an "ultraviolet ray irradiation treatment", the following operation is used. And a resulting electroless plated layer is evaluated using the following conditions and criteria for each evaluation item.

### 1. "Stretching Process"

In a "stretching process" of a polycarbonate sheet, a tensile test apparatus is used to uniaxially stretch the sheet at a stretching rate of 10 mm per minute up to 170% of the original sheet length.

### 2. "Ultraviolet Ray Irradiation Treatment"

An ultraviolet ray exposure apparatus which uses an ultra-highpressure mercury lamp of 2 kW is used as a source of ultraviolet ray so that a surface is exposed to an ultraviolet ray in a perpendicular direction to the surface. In the exposure, the exposure dose of the ultraviolet ray (irradiation intensity of light) is adjusted based on the intensity of light which is measured at a wavelength of 365 nm.

### 3. Evaluation of Electroless Plated Layer

"Volume Resistivity": In accordance with the test method of volume resistivity which is described in JIS-H-8646, a width (W), a length (L) of a forming rectangular electroless plated layer, and a mean thickness (T) of the cross-section of the electroless plated layer are measured, and a resistance value is measured using a 4 terminal method, thereby a volume resistivity is calculated for an assumed homogeneous conductor having the mean thickness (T).

An electroless plated layer of copper having a measured volume resistivity of 10 µΩ·cm or less is considered to be a good quality product.

"Adhesion Strength": In accordance with the tape test described in JIS-H-8504, a tape is pressed against a surface of an electroless plated layer formed for 10 seconds to adhere without air bubbles at the interface between the surface and the tape, and the adhesion tape is quickly removed. The adhesion force of the adhesion tape corresponds to 120 gf/cm.

An electroless plated layer on which no removed portion is observed on the tape-removed adhesion surface thereof is considered to be a good quality product.

### (Example 2-1)

A resin mixture (adhesive for plating) having the following composition was prepared as a resin mixture comprising metal fine particles of an average particle size of 1 to 200 nm uniformly dispersed in a curable binder resin composition.

The curable binder resin composition used as a dispersion medium was a thermosetting epoxy resin composition having the following composition. The thermosetting epoxy resin composition comprised: 1,6-dihydroxy naphthalene diglycidyl ether, EPICLON HP-4032 (epoxy equivalent weight 142) of 7 parts by mass, and bisphenol A epoxy resin, EPICOAT 828EL (epoxy equivalent weight 187) of 3 parts by mass, as epoxy resin components; acid anhydride, YH-307 (molecular weight 235) of 13.8 parts by mass, as a curing agent component; an amine based curing catalyst, Amicure PN-23 of 0.3 parts by mass, as a curing accelerator; and KBM-403 of 0.1 parts by mass as a coupling agent component. These components were sufficiently mixed and blended to prepare a resin composition.

To the resin composition of 70 parts by mass, a dispersion containing Ag ultra fine particles having an average particle size of 5 nm (product name: Perfect Silver, dispersed ultra fine particles manufactured by Vacuum Metallurgical Co., Ltd.) of 30 parts by mass as dispersoid metal fine particles in a toluene dispersion solvent component of 55.7 parts by mass was added, and the particles were uniformly dispersed using three rollers to prepare a resin mixture in paste form. The Ag ultra fine particles having an average particle size of 5 nm comprised Ag ultra fine particles having a metal surface individually on which a covering layer of covering molecule dodecylamine was formed, and the covering molecule dodecylamine was contained by 15 parts by mass relative to the Ag ultra fine particles of 100 parts by mass. Eventually, the mixed toluene was distilled off in a reduced pressure to obtain an intended resin mixture (adhesive for plating) in paste form.

The obtained resin mixture in paste form had a liquid viscosity of 40 Pa·s (25 °C). When the curable binder resin composition used as a dispersion medium was subjected to a heat curing treatment at a temperature in a range of 100 °C to 160 °C, the coating layer of a resin mixture in paste form functioned as an adhesive layer having a high adhesion strength to a non-conductive substrate to which a conductive circuit is manufactured, for example various polymeric film (sheet) surfaces.

A rectangular coating film of the resin mixture in paste form having a width 5 mm, a length 20 mm, and a mean coating film thickness of 19 µm was formed to the surfaces of a polyimide non-conductive substrate in sheet form (Kapton 500H, manufactured by DuPont) and a polycarbonate non-conductive substrate in sheet form (LEXAN 8010, manufactured by Piedomont Plastic, Inc) by mask printing using a metal mask having of a 20 µm thickness. Then, the film was dried for 10 minutes at a temperature of 110 °C to form a covering film layer (coating layer) having a mean film thickness of 18 µm without a tuck on the surface.

The above described "stretching process" over the entire polycarbonate film caused the coating layer of the resin mixture in paste form which was formed on the polycarbonate film by mask printing to be uniaxially stretched up to 170% of the original size in length, and the resin mixture coating layer to be stretched up to 170% of the original size in length. While, after the stretching process, the resin mixture coating layer had a mean film thickness of 10 µm, which corresponds to 10/17 of the original size.

As an "ultraviolet ray irradiation treatment" to the resin mixture coating layer on the polycarbonate film after the "stretching process", the surface was irradiated with an ultraviolet ray in an exposure dose of 45 J/cm² (wavelength 365 nm) using the above described ultraviolet ray exposure apparatus. While, to the resin mixture coating layer on the polyimide substrate, an ultraviolet ray irradiation in an exposure dose of 27 J/cm² (wavelength 365 nm) was performed using the above described ultraviolet ray exposure apparatus.

In a process for electroless plating of copper, three commercially available plating solutions, MK-421A, MK-421 B, MK-421 M (manufactured by Muromachi Technos Co., Ltd.) each of which was diluted with water at the above ratio and had the following composition are used:
MK-421A (copper component + HCHO) 0.035 L
MK-421 B (sodium hydroxide) 0.035 L
MK-421 M (sodium hydroxide) 0.100 L
Water 0.830 L

Next, after the "ultraviolet ray irradiation treatment", the polyimide substrate and the polycarbonate film after the "stretching process" were immersed in an electroless plating solution (MK-421, manufactured by Muromachi Technos Co., Ltd.) at 40 °C for three hours to perform a treatment of electroless plating of copper to the surface of the substrate. During the immersion, the precipitation of the electroless plating copper covering layer was selectively enhanced on the surface of the resin mixture coating layer after the "ultraviolet ray irradiation treatment" which was formed on each non-conductive substrate surface, while no precipitation of the electroless plating copper covering layer was observed on the surface where each non-conductive substrate surface itself was exposed.

After non-conductive substrates were recovered from the electroless plating solution and the remained plating solution were rinsed, each of the non-conductive substrates was heated at 130 °C for three hours in a constant temperature furnace in an inert atmosphere to thermally cure the thermosetting epoxy resin composition contained in the resin mixture coating layer. Finally, the electroless plating copper layer fixedly attached to the surface of each non-conductive substrate via the cured layer of the thermosetting epoxy resin as an adhesive layer was evaluated with respect to a "volume resistivity" and "adhesion strength" in accordance with the above described evaluation methods.

The electroless plating copper layer formed had an average layer thickness of 7 µm, and no removed portion was observed in the above described tape removing test. The layer had a volume resistivity of 3.8 µΩ·cm, which meets the criteria for "good quality product" to have a volume resistivity of 10 µΩ·cm or less.

Separately, a coating film of the resin mixture in paste form having an average coating film thickness of 19µm was formed across the polycarbonate film. Then, the film was dried for 10 minutes at a temperature of 110 °C to form a covering film layer (coating layer) having a mean film thickness of 18 µm without a tuck on the surface. When subjected to the above described "stretching process" to the entire polycarbonate film, the coating layer of the resin mixture in paste form formed across the polycarbonate film was uniaxially stretched up to 170% of the original size in length, and stretched in the longitudinal direction of the resin mixture coating layer up to 170% of the original size. While, after the stretching process, the resin mixture coating layer had a mean film thickness of 10 µm, which corresponds to 10/17 of the original size.

The coating layer of the resin mixture formed on the polycarbonate film after the "stretching process" was subjected to contact exposure of a parallel wiring pattern having a line width of 60 µm, a space gap of 60 µm, and a length of 5 mm in an exposure dose of 45 J/cm² (wavelength 365 nm) using the above described ultraviolet ray exposure apparatus.

Next, after the contact exposure of the wiring pattern, the polycarbonate film after the "stretching process" was immersed in electroless plating solution (MK-421, manufactured by Muromachi Technos Co., Ltd.) at 40 °C for three hours to perform a treatment of electroless plating of copper to the surface. During the immersion, the precipitation of the electroless plating copper covering layer was selectively enhanced only the wiring pattern region subjected to the "ultraviolet ray irradiation treatment" which was formed on the polycarbonate film surface after the "stretching process", and while no precipitation of the electroless plating copper covering layer was observed on the surface where the non-conductive substrate surface itself was exposed and the region of the resin mixture coating layer surface without the "ultraviolet ray irradiation treatment".

After non-conductive substrates were recovered from the electroless plating solution and the remained plating solution were rinsed, the substrate was heated at 130 °C for three hours in a constant temperature furnace in an inert atmosphere to thermally cure the thermosetting epoxy resin composition contained in the resin mixture coating layer. Finally, the electroless plating copper layer fixedly attached to the surface of each non-conductive substrate via the cured layer of the thermosetting epoxy resin as an adhesive layer was evaluated with respect to "adhesion strength" in accordance with the above described evaluation methods.

The electroless plating copper layer which was formed to have the same shape as that of the wiring pattern had an average layer thickness of 6 µm, an average line width of 52 µm, and an average space gap of 5 µm. After the above described tape removing test was performed to the electroless plating copper layer having the parallel wiring pattern of a length of 5 mm, no removed portion was observed in the electroless plating copper layer. A measurement of an insulation resistance value between the adjacent two electroless plating copper layer in the wiring pattern form was performed to find that the value at the interval region having a length 5 mm and an average space gap of 58 µm in the electroless plating copper layer formed was 10⁵ MΩ or more, which was out of the measurable range.

In addition, a coating film of the resin mixture in paste form was formed on a FR-4 substrate for printed board by screen printing to have comb-shaped wiring pattern shape with a line width of 165 µm, a space gap of 165 µm, and an average coating film thickness of 20 µm. Then, the film was dried for 10 minutes at a temperature of 110 °C to form a covering film layer (coating layer) having a mean film thickness of 19 µm without a tuck on the surface. The entire resin mixture coating layer having the comb-shaped wiring pattern shape, which was print formed on the FR-4 substrate for printed board, was irradiated with an ultraviolet ray in an exposure dose of 27 J/cm² (wavelength 365 nm) using the above described ultraviolet ray exposure apparatus.

Next, after the exposure of the entire resin mixture coating layer having the comb-shaped wiring pattern shape, the FR-4 substrate for printed board was immersed in an electroless plating solution (MK-421, manufactured by Muromachi Technos Co., Ltd.) at 40 °C for three hours to perform a treatment of electroless plating of copper to the surface of the substrate. During the immersion, the precipitation of the electroless plating copper covering layer was selectively enhanced only the wiring pattern region on the resin mixture coating layer which was formed on the substrate surface and subjected to the "ultraviolet ray irradiation treatment", and no precipitation of the electroless plating copper covering layer was observed on the surface where the non-conductive substrate surface itself was exposed.

After the non-conductive substrates were recovered from the electroless plating solution and the remained plating solution were rinsed, the substrates were heated at 130 °C for three hours in a constant temperature furnace in an inert atmosphere to thermally cure the thermosetting epoxy resin composition contained in the resin mixture coating layer. Finally, the electroless plating copper layer fixedly attached to the surface of each non-conductive substrate via the cured layer of the thermosetting epoxy resin as an adhesive layer was evaluated with respect to "adhesion strength" in accordance with the above described evaluation method.

The electroless plating copper layer which was formed to have the same shape as that of the comb-shaped wiring pattern had an average layer thickness of 6 µm, an average line width of 167 µm, and an average space gap of 163 µm. The electroless copper plating layer having the comb-shaped wiring pattern form was subjected to the above described tape removing test and no removed portion was found in the electroless plating copper layer.

### (Example 2-2)

A resin mixture (adhesive for plating) having the following composition was prepared as a resin mixture comprising metal fine particles of an average particle size of 1 to 200 nm uniformly dispersed in a curable binder resin composition.

The curable binder resin composition used as a dispersion medium was a thermosetting epoxy resin composition having the following composition. The thermosetting epoxy resin composition comprised: EPICLON EXA-835LV (epoxy equivalent weight 165) of 10 parts by mass, as an epoxy resin component; acid anhydride, dodecenyl succinic anhydride (molecular weight 226) of 12.3 parts by mass, as a curing agent component; an amine based curing catalyst, Amicure PN-23 of 0.3 parts by mass, as a curing accelerator; and KBM-403 of 0.1 parts by mass as a coupling agent component. These components were sufficiently mixed and blended to prepare a resin composition.

To the resin composition of 70 parts by mass, a dispersion containing Ag ultra fine particles having an average particle size of 5 nm (product name: Perfect Silver, dispersed ultra fine particles manufactured by Vacuum Metallurgical Co., Ltd.) of 30 parts by mass as dispersoid metal fine particles in a toluene dispersion solvent component of 55.7 parts by mass was added, and the particles were uniformly dispersed using three rollers to prepare a resin mixture in paste form. The Ag ultra fine particles having an average particle size of 5 nm comprised Ag ultra fine particles having a metal surface individually on which a covering layer of covering molecule dodecylamine was formed, and the covering molecule dodecylamine was contained by 15 parts by mass relative to the Ag ultra fine particles of 100 parts by mass. Eventually, the mixed toluene was distilled off in a reduced pressure to obtain an intended resin mixture (adhesive for plating) in paste form.

The obtained resin mixture in paste form had a liquid viscosity of 24 Pa·s (25 °C). When the curable binder resin composition used as a dispersion medium was subjected to a heat curing treatment at a temperature in a range of 100 °C to 160 °C, the coating layer of a resin mixture in paste form functioned as an adhesive layer having a high adhesion strength to a non-conductive substrate to which a conductive circuit is manufactured, for example various polymeric film (sheet) surfaces.

A rectangular coating film of the resin mixture in paste form having a width 5 mm, a length 20 mm, and a mean coating film thickness of 19 µm was formed on a surface of polyimide non-conductive substrate in sheet form (Kapton 500H, manufactured by DuPont) and a surface of polycarbonate non-conductive substrate in sheet form (LEXAN 8010: manufactured by Piedomont Plastic, Inc) by mask printing using a metal mask having a thickness of 20 µm. Then, the film was dried for 10 minutes at a temperature of 110 °C to form a covering film layer (coating layer) having a mean film thickness of 18 µm without a tuck on the surface.

The above described "stretching process" over the entire polycarbonate film caused the coating layer of the resin mixture in paste form which was formed on the polycarbonate film substrate by mask printing to be uniaxially stretched up to 170% of the original size in length, and the resin mixture coating layer to be stretched up to 170% of the original size in length. While, after the stretching process, the resin mixture coating layer had a mean film thickness of 10 µm, which corresponds to 10/17 of the original size.

As an "ultraviolet ray irradiation treatment" to the resin mixture coating layer on the polycarbonate film after the "stretching process", the surface was irradiated with an ultraviolet ray in an exposure dose of 45 J/cm² (wavelength 365 nm) using the above described ultraviolet ray exposure apparatus. While, to the resin mixture coating layer on the polyimide substrate, an ultraviolet ray irradiation in an exposure dose of 27 J/cm² (wavelength 365 nm) was performed using the above described ultraviolet ray exposure apparatus.

Next, the polyimide substrate after the "ultraviolet ray irradiation treatment" and the polycarbonate film after the "stretching process" were immersed in an electroless plating solution (MK-421, manufactured by Muromachi Technos Co., Ltd.) at 40 °C for three hours to perform a treatment of electroless plating of copper to the surface of the substrate. During the immersion, the precipitation of the electroless plating copper covering layer was selectively enhanced on the surface of the resin mixture coating layer after the "ultraviolet ray irradiation treatment" which was formed on each non-conductive substrate, while no precipitation of the electroless plating copper covering layer was observed on the surface where each non-conductive substrate surface itself was exposed.

After non-conductive substrates were recovered from the electroless plating solution and the remained plating solution were rinsed, each of the non-conductive substrates was heated at 130 °C for three hours in a constant temperature furnace in an inert gas atmosphere to thermally cure the thermosetting epoxy resin composition contained in the resin mixture coating layer. Finally, the electroless plating copper layer fixedly attached to the surface of each non-conductive substrate via the cured layer of the thermosetting epoxy resin as an adhesive layer was evaluated with respect to a "volume resistivity" and "adhesion strength" in accordance with the above described evaluation methods.

The formed electroless plating copper layer had an average layer thickness of 9 µm, and no removed portion was observed in the above described tape removing test. The layer had a volume resistivity of 2.7 µΩ·cm, which meets the criteria for "good quality product" to have a volume resistivity of 10 µΩ·cm or less.

### (Example 2-3)

A resin mixture (adhesive for plating) having the following composition was prepared as a resin mixture comprising metal fine particles of an average particle size of 1 to 200 nm uniformly dispersed in a curable binder resin composition.

The curable binder resin composition used as a dispersion medium was a thermosetting epoxy resin composition having the following composition. The thermosetting epoxy resin composition comprised: EPICLON EXA-7015 (epoxy equivalent weight 100) of 10 parts by mass, as an epoxy resin component; acid anhydride, dodecenyl succinic anhydride (molecular weight 226) of 97 parts by mass, as a curing agent component; an amine based curing catalyst, Amicure PN-23 of 0.3 parts by mass, as a curing accelerator; and KBM-403 of 0.1 parts by mass as a coupling agent component. These components were sufficiently mixed and blended to prepare a resin composition.

To the resin composition of 70 parts by mass, a dispersion containing Ag ultra fine particles having an average particle size of 5 nm (product name: Perfect Silver, dispersed ultra fine particles manufactured by Vacuum Metallurgical Co., Ltd.) of 30 parts by mass as dispersoid metal fine particles in a toluene dispersion solvent component of 55.7 parts by mass was added, and the particles were uniformly dispersed using three rollers to prepare a resin mixture in paste form. The Ag ultra fine particles having an average particle size of 5 nm comprised Ag ultra fine particles having a metal surface individually on which a covering layer of covering molecule dodecylamine was formed, and the covering molecule dodecylamine was contained by 15 parts by mass relative to the Ag ultra fine particles of 100 parts by mass. Eventually, the mixed toluene was distilled off in a reduced pressure to obtain an intended resin mixture (adhesive for plating) in paste form.

The obtained resin mixture in paste form had a liquid viscosity of 70 Pa·s (25 °C). When the curable binder resin composition used as a dispersion medium was subjected to a heat curing treatment at a temperature in a range of 100 °C to 160 °C, the coating layer of a resin mixture in paste form functioned as an adhesive layer having a high adhesion strength to a non-conductive substrate to which a conductive circuit is manufactured, for example various polymeric film (sheet) surfaces.

A rectangular coating film of the resin mixture in paste form having a width 5 mm, a length 20 mm, and a mean coating film thickness of 19µm was formed on a surface of polyimide non-conductive substrate in sheet form (Kapton 500H, manufactured by DuPont) and a surface of polycarbonate non-conductive substrate in sheet form (LEXAN 8010: manufactured by Piedomont Plastic, Inc) by mask printing using a metal mask having a thickness of 20 µm. Then, the film was dried for 10 minutes at a temperature of 110 °C to form a covering film layer (coating layer) having a mean film thickness of 18 µm without a tuck on the surface.

The above described "stretching process" over the entire polycarbonate film caused the coating layer of the resin mixture in paste form which was formed on the polycarbonate film substrate by mask printing to be uniaxially stretched up to 170% of the original size in length, and the resin mixture coating layer to be stretched up to 170% of the original size in length. While, after the stretching process, the resin mixture coating layer had a mean film thickness of 10 µm, which corresponds to 10/17 of the original size.

As an "ultraviolet ray irradiation treatment" to the resin mixture coating layer on the polycarbonate film after the "stretching process", the surface was irradiated with an ultraviolet ray in an exposure dose of 45 J/cm² (wavelength 365 nm) using the above described ultraviolet ray exposure apparatus. While, to the resin mixture coating layer on the polyimide substrate, an ultraviolet ray irradiation in an exposure dose of 27 J/cm² (wavelength 365 nm) was performed using the above described ultraviolet ray exposure apparatus.

Next, after the "ultraviolet ray irradiation treatment", the polyimide substrate and the polycarbonate film after the "stretching process" were immersed in an electroless plating solution (MK-421, manufactured by Muromachi Technos Co., Ltd.) at 40 °C for three hours to perform a treatment of electroless plating of copper to the surface of the substrate. During the immersion, the precipitation of the electroless plating copper covering layer was selectively enhanced on the surface of the resin mixture coating layer after the "ultraviolet ray irradiation treatment" which was formed on each non-conductive substrate, while no precipitation of the electroless plating copper covering layer was observed on the surface where each non-conductive substrate surface itself was exposed.

After non-conductive substrates were recovered from the electroless plating solution and the remained plating solution were rinsed, each of the non-conductive substrates was heated at 130 °C for three hours in a constant temperature furnace in an inert gas atmosphere to thermally cure the thermosetting epoxy resin composition contained in the resin mixture coating layer. Finally, the electroless plating copper layer fixedly attached to the surface of each non-conductive substrate via the cured layer of the thermosetting epoxy resin as an adhesive layer was evaluated with respect to a "volume resistivity" and "adhesion strength" in accordance with the above described evaluation methods.

The electroless plating copper layer formed had an average layer thickness of 7 µm, and no removed portion was observed in the above described tape removing test. The layer had a volume resistivity of 3.8 µΩ·cm, which meets the criteria for "good quality product" to have a volume resistivity of 10 µΩ·cm or less.

### (Example 2-4)

A resin mixture (adhesive for plating) having the following composition was prepared as a resin mixture comprising metal fine particles of an average particle size of 1 to 200 nm uniformly dispersed in a curable binder resin composition.

The curable binder resin composition used as a dispersion medium is a thermosetting alkyd resin composition having the following composition. The thermosetting alkyd resin composition comprises: alkyd resin 8710-55X of 14.3 parts by mass (solid content 70%: xylene solvent) as an alkyd resin component, curing accelerator; and cobalt naphthenate of 0.05 parts by mass. These components were sufficiently mixed and blended to prepare a resin composition.

To the resin composition of 70 parts by mass, a dispersion containing Ag ultra fine particles having an average particle size of 5 nm (product name: Perfect Silver, dispersed ultra fine particles manufactured by Vacuum Metallurgical Co., Ltd.) of 30 parts by mass as dispersoid metal fine particles in a toluene dispersion solvent component of 55.7 parts by mass was added, and the particles were uniformly dispersed using three rollers to prepare a resin mixture in paste form. The Ag ultra fine particles having an average particle size of 5 nm comprised Ag ultra fine particles having a metal surface individually on which a covering layer of covering molecule dodecylamine was formed, and the covering molecule dodecylamine was contained by 15 parts by mass relative to the Ag ultra fine particles of 100 parts by mass. Eventually, the mixed toluene was distilled off in a reduced pressure, and the xylene solvent which was decreased due to the distillation in the reduced pressure was readjusted to the amount at the initial blend ratio relative to the alkyd resin to obtain an intended resin mixture (adhesive for plating) in paste form.

The obtained resin mixture in paste form had a liquid viscosity of 120 Pa·s (25 °C). When the curable binder resin composition used as a dispersion medium was subjected to a heat curing treatment at a temperature in a range of 100 °C to 160 °C, the coating layer of a resin mixture in paste form functioned as an adhesive layer having a high adhesion strength to a non-conductive substrate to which a conductive circuit is manufactured, for example various polymeric film (sheet) surfaces.

A rectangular coating film of the resin mixture in paste form having a width 5 mm, a length 20 mm, and a mean coating film thickness of 19µm was formed on a surface of polyimide non-conductive substrate in sheet form (Kapton 500H, manufactured by DuPont) and a surface of polycarbonate non-conductive substrate in sheet form (LEXAN 8010: manufactured by Piedomont Plastic, Inc) by mask printing using a metal mask having a thickness of 20 µm. Then, in order to evaporate the xylene solvent, the film was dried for 5 hours at a room temperature to form a covering film layer (coating layer) having a mean film thickness of 15 µm without a tuck on the surface.

The above described "stretching process" over the entire polycarbonate film caused the coating layer of the resin mixture in paste form which was formed on the polycarbonate film substrate by mask printing to be uniaxially stretched up to 170% of the original size in length, and the resin mixture coating layer to be stretched up to 170% of the original size in length. While, after the stretching process, the resin mixture coating layer had a mean film thickness of 10 µm, which corresponds to 10/17 of the original size.

As an "ultraviolet ray irradiation treatment" to the resin mixture coating layer on the polycarbonate film after the "stretching process", the surface was irradiated with an ultraviolet ray in an exposure dose of 45 J/cm² (wavelength 365 nm) using the above described ultraviolet ray exposure apparatus. While, to the resin mixture coating layer on the polyimide substrate, an ultraviolet ray irradiation in an exposure dose of 27 J/cm² (wavelength 365 nm) was performed using the above described ultraviolet ray exposure apparatus.

Next, after the "ultraviolet ray irradiation treatment", the polyimide substrate and the polycarbonate film after the "stretching process" were immersed in an electroless plating solution (MK-421, manufactured by Muromachi Technos Co., Ltd.) at 40 °C for three hours to perform a treatment of electroless plating of copper to the surface of the substrate. During the immersion, the precipitation of the electroless plating copper covering layer was selectively enhanced on the surface of the resin mixture coating layer after the "ultraviolet ray irradiation treatment" which was formed on each non-conductive substrate, while no precipitation of the electroless plating copper covering layer was observed on the surface where each non-conductive substrate surface itself was exposed.

After non-conductive substrates were recovered from the electroless plating solution and the remained plating solution were rinsed, each of the non-conductive substrates was heated at 130 °C for three hours in a constant temperature furnace in an inert gas atmosphere to thermally cure the thermosetting epoxy resin composition contained in the resin mixture coating layer. Finally, the electroless plating copper layer fixedly attached to the surface of each non-conductive substrate via the cured layer of the thermosetting epoxy resin as an adhesive layer was evaluated with respect to a "volume resistivity" and "adhesion strength" in accordance with the above described evaluation methods.

The electroless plating copper layer formed had an average layer thickness of 10 µm, and no removed portion was observed in the above described tape removing test. The layer had a volume resistivity of 2.5 µΩ·cm, which meets the criteria for "good quality product" to have a volume resistivity of 10µΩ·cm or less.

### (Example 2-5)

A resin mixture (adhesive for plating) having the following composition was prepared as a resin mixture comprising metal fine particles of an average particle size of 1 to 200 nm uniformly dispersed in a curable binder resin composition.

The curable binder resin composition used as a dispersion medium was a thermosetting epoxy resin composition having the following composition. The thermosetting epoxy resin composition comprised: 1,6-dihydroxy naphthalene diglycidyl ether, EPICLON HP-4032 (epoxy equivalent weight 142) of 7 parts by mass, and bisphenol A epoxy resin, EPICOAT 828EL (epoxy equivalent weight 187) of 3 parts by mass, as epoxy resin components; acid anhydride, YH-307 (molecular weight 235) of 13.8 parts by mass, as a curing agent component; an amine based curing catalyst, Amicure PN-23 of 0.3 parts by mass, as a curing accelerator; and KBM-403 of 0.1 parts by mass as a coupling agent component. These components were sufficiently mixed and blended to prepare a resin composition.

To the resin composition of 99 parts by mass, a dispersion containing Pd ultra fine particles having an average particle size of 8 nm (Vacuum Metallurgical Co., Ltd.) of 1 parts by mass as dispersoid metal fine particles in a terpineol dispersion solvent component of 49 parts by mass was added, and the particles were uniformly dispersed using three rollers to prepare a resin mixture in paste form. The Pd ultra fine particles having an average particle size of 8 nm comprised Pd ultra fine particles having a metal surface individually on which a covering layer of covering molecule dodecylamine was formed, and the covering molecule dodecylamine was contained by 15 parts by mass relative to the Pd ultra fine particles of 100 parts by mass. Eventually, the mixed terpineol was distilled off in a reduced pressure to obtain an intended resin mixture (adhesive for plating) in paste form.

The obtained resin mixture in paste form had a liquid viscosity of 21 Pa·s (25 °C). When the curable binder resin composition used as a dispersion medium was subjected to a heat curing treatment at a temperature in a range of 100 °C to 160 °C, the coating layer of a resin mixture in paste form functioned as an adhesive layer having a high adhesion strength to a non-conductive substrate to which a conductive circuit is manufactured, for example various polymeric film (sheet) surfaces.

A rectangular coating film of the resin mixture in paste form having a width 5 mm, a length 20 mm, and a mean coating film thickness of 19 µm was formed on a surface of polyimide non-conductive substrate in sheet form (Kapton 500H, manufactured by DuPont) and a surface of polycarbonate non-conductive substrate in sheet form (LEXAN 8010: manufactured by Piedomont Plastic, Inc) by mask printing using a metal mask having a thickness of 20 µm. Then, the film was dried for 10 minutes at a temperature of 110 °C to form a covering film layer (coating layer) having a mean film thickness of 16 µm without a tuck on the surface.

The above described "stretching process" over the entire polycarbonate film caused the coating layer of the resin mixture in paste form which was formed on the polycarbonate film substrate by mask printing to be uniaxially stretched up to 170% of the original size in length, and the resin mixture coating layer to be stretched up to 170% of the original size in length. While, after the stretching process, the resin mixture coating layer had a mean film thickness of 9 µm, which corresponds to 10/17 of the original size.

As an "ultraviolet ray irradiation treatment" to the resin mixture coating layer on the polycarbonate film after the "stretching process", the surface was irradiated with an ultraviolet ray in an exposure dose of 45 J/cm² (wavelength 365 nm) using the above described ultraviolet ray exposure apparatus. While, to the resin mixture coating layer on the polyimide substrate, an ultraviolet ray irradiation in an exposure dose of 27 J/cm² (wavelength 365 nm) was performed using the above described ultraviolet ray exposure apparatus.

Next, after the "ultraviolet ray irradiation treatment", the polyimide substrate and the polycarbonate film after the "stretching process" were immersed in an electroless plating solution (MK-421, manufactured by Muromachi Technos Co., Ltd.) at 40 °C for three hours to perform a treatment of electroless plating of copper to the surface of the substrate. During the immersion, the precipitation of the electroless plating copper covering layer was selectively enhanced on the surface of the resin mixture coating layer after the "ultraviolet ray irradiation treatment" which was formed on each non-conductive substrate, while no precipitation of the electroless plating copper covering layer was observed on the surface where each non-conductive substrate surface itself was exposed.

After non-conductive substrates were recovered from the electroless plating solution and the remained plating solution were rinsed, each of the non-conductive substrates was heated at 130 °C for three hours in a constant temperature furnace in an inert gas atmosphere to thermally cure the thermosetting epoxy resin composition contained in the resin mixture coating layer. Finally, the electroless plating copper layer fixedly attached to the surface of each non-conductive substrate via the cured layer of the thermosetting epoxy resin as an adhesive layer was evaluated with respect to a "volume resistivity" and "adhesion strength" in accordance with the above described evaluation methods.

The electroless plating copper layer formed had an average layer thickness of 13 µm, and no removed portion was observed in the above described tape removing test. The layer had a volume resistivity of 2 µΩ·cm, which meets the criteria for "quality product" to have a volume resistivity of 10 µΩ·cm or less.

### (Example 2-6)

A resin mixture (adhesive for plating) having the following composition was prepared as a resin mixture comprising an organic metal compound uniformly blended in a curable binder resin composition.

The curable binder resin composition used as a solvent to the organic metal compound was a thermosetting epoxy resin composition having the following composition. The thermosetting epoxy resin composition comprised: 1,6-dihydroxy naphthalene diglycidyl ether, EPICLON HP-4032 (epoxy equivalent weight 142) of 7 parts by mass, and bisphenol A epoxy resin, EPICOAT 828EL (epoxy equivalent weight 187) of 3 parts by mass, as epoxy resin components; acid anhydride, YH-307 (molecular weight 235) of 13.8 parts by mass, as a curing agent component; an amine based curing catalyst, Amicure PN-23 of 0.3 parts by mass, as a curing accelerator; and KBM-403 of 0.1 parts by mass as a coupling agent component. These components were sufficiently mixed and blended to prepare a resin composition.

To the resin composition of 93 parts by mass, silver salt of benzoic acid, which is one of silver salt of organic acids, (molecular weight 228.99) of 15 parts by mass as an organic metal compound was added, and the mixture was uniformly blended using three rollers to prepare a resin mixture in paste form. After the blending, the benzoic acid silver in fine powder form dispersed in the resin mixture in paste form had an average particle size on the order of 0.5 to 1 µm. The formed resin mixture in paste form had a solution viscosity of 150 Pa·s (25 °C). When the curable binder resin composition used as a dispersion medium was subjected to a heat curing treatment at a temperature in a range of 100 °C to 160 °C, the coating layer of a resin mixture in paste form functioned as an adhesive layer having a high adhesion strength to a non-conductive substrate to which a conductive circuit is manufactured, for example various polymeric film (sheet) surfaces.

A rectangular coating film of the resin mixture in paste form having a width 5 mm, a length 20 mm, and a mean coating film thickness of 20 µm was formed on a surface of polyimide non-conductive substrate in sheet form (Kapton 500H, manufactured by DuPont) and a surface of polycarbonate non-conductive substrate in sheet form (LEXAN 8010: manufactured by Piedomont Plastic, Inc) by mask printing using a metal mask having a thickness of 20 µm. Then, the film was dried for 10 minutes at a temperature of 110 °C to form a covering film layer (coating layer) having a mean film thickness of 18 µm without a tuck on the surface.

The above described "stretching process" over the entire polycarbonate film caused the coating layer of the resin mixture in paste form which was formed on the polycarbonate film substrate by mask printing to be uniaxially stretched up to 170% of the original size in length, and the resin mixture coating layer to be stretched up to 170% of the original size in length. While, after the stretching process, the resin mixture coating layer had a mean film thickness of 11 µm, which corresponds to 10/17 of the original size.

As an "ultraviolet ray irradiation treatment" to the resin mixture coating layer on the polycarbonate film after the "stretching process", the surface was irradiated with an ultraviolet ray in an exposure dose of 45 J/cm² (wavelength 365 nm) using the above described ultraviolet ray exposure apparatus. While, to the resin mixture coating layer on the polyimide substrate, an ultraviolet ray irradiation in an exposure dose of 27 J/cm² (wavelength 365 nm) was performed using the above described ultraviolet ray exposure apparatus.

Next, after the "ultraviolet ray irradiation treatment", the polyimide substrate and the polycarbonate film after the "stretching process" were immersed in an electroless plating solution (MK-421, manufactured by Muromachi Technos Co., Ltd.) at 40 °C for three hours to perform a treatment of electroless plating of copper to the surface of the substrate. During the immersion, the precipitation of the electroless plating copper covering layer was selectively enhanced on the surface of the resin mixture coating layer after the "ultraviolet ray irradiation treatment" which was formed on each non-conductive substrate, while no precipitation of the electroless plating copper covering layer was observed on the surface where each non-conductive substrate surface itself was exposed.

After non-conductive substrates were recovered from the electroless plating solution and the remained plating solution were rinsed, each of the non-conductive substrates was heated at 130 °C for three hours in a constant temperature furnace in an inert gas atmosphere to thermally cure the thermosetting epoxy resin composition contained in the resin mixture coating layer. Finally, the electroless plating copper layer fixedly attached to the surface of each non-conductive substrate via the cured layer of the thermosetting epoxy resin as an adhesive layer was evaluated with respect to a "volume resistivity" and "adhesion strength" in accordance with the above described evaluation methods.

The electroless plating copper layer formed had an average layer thickness of 9 µm, and no removed portion was observed in the above described tape removing test. The layer had a volume resistivity of 3.3 µΩ·cm, which meets the criteria for "good quality product" to have a volume resistivity of 10 µΩ·cm or less.

### (Example 2-7)

A resin mixture (adhesive for plating) having the following composition was prepared as a resin mixture comprising an organic metal compound uniformly blended in a curable binder resin composition.

The curable binder resin composition used as a solvent to the organic metal compound is a thermosetting epoxy resin composition that has the composition described in Example 2-6. As a metal salt of organic acid to be blended, silver salt of oleic acid is used in Example 2-7, instead of silver salt of benzoic acid in Example 2-6.

To the resin composition described in Example 2-6 of 93 parts by mass, silver salt of oleic acid (molecular weight 388.64) of 25.3 parts by mass as an organic metal compound was added, and the mixture was uniformly blended using three rollers to prepare a resin mixture in paste form. After the blending, the silver salt of oleic acid in fine powder form dispersed in the resin mixture in paste form had an average particle size on the order of 0.5 to 1 µm. The formed resin mixture in paste form had a liquid viscosity of 143 Pa·s (25 °C). When the curable binder resin composition used as a dispersion medium was subjected to a heat curing treatment at a temperature in a range of 100 °C to 160 °C, the coating layer of a resin mixture in paste form functioned as an adhesive layer having a high adhesion strength to a non-conductive substrate to which a conductive circuit is manufactured, for example various polymeric film (sheet) surfaces.

Using the prepared resin mixture (adhesive for plating), a rectangular coating film of the resin mixture in paste form having a width 5 mm, a length 20 mm, and a mean coating film thickness of 20 µm was formed on a surface of polyimide non-conductive substrate in sheet form (Kapton 500H, manufactured by DuPont) and a surface of polycarbonate non-conductive substrate in sheet form (LEXAN 8010: manufactured by Piedomont Plastic, Inc) by mask printing using a metal mask having a thickness of 20 µm. Then, the film was dried for 10 minutes at a temperature of 110 °C to form a covering film layer (coating layer) having a mean film thickness of 18 µm without a tuck on the surface.

After the condition of exposure dose of 27 J/cm² for the "ultraviolet ray irradiation treatment" to each of the resin mixture coating layers on the non-conductive substrate surface was selected, the surface was subjected to the procedure and condition of the "ultraviolet ray irradiation treatment" as described in Example 2-6 using the above described ultraviolet ray exposure apparatus to form an electroless copper plating layer.

During the immersion, the precipitation of the electroless plating copper covering layer was selectively enhanced on the surface of the resin mixture coating layer after the "ultraviolet ray irradiation treatment" which was formed on each non-conductive substrate, while no precipitation of the electroless plating copper covering layer was observed on the surface where each non-conductive substrate surface itself was exposed.

After non-conductive substrates were recovered from the electroless plating solution and the remained plating solution were rinsed, each of the non-conductive substrates was heated at 130 °C for three hours in a constant temperature furnace in an inert gas atmosphere to thermally cure the thermosetting epoxy resin composition contained in the resin mixture coating layer. Finally, the electroless plating copper layer fixedly attached to the surface of each non-conductive substrate via the cured layer of the thermosetting epoxy resin as an adhesive layer was evaluated with respect to a "volume resistivity" and "adhesion strength" in accordance with the above described evaluation methods.

The electroless plating copper layer formed had an average layer thickness of 8 µm, and no removed portion was observed in the above described tape removing test. The layer had a volume resistivity of 4 µΩ·cm, which meets the criteria for "good quality product" to have a volume resistivity of 10 µΩ·µm or less.

### (Example 2-8)

A resin mixture (adhesive for plating) having the following composition was prepared as a resin mixture comprising an organic metal compound uniformly blended in a curable binder resin composition.

The curable binder resin composition used as a solvent to the organic metal compound is a thermosetting epoxy resin composition that has the composition described in Example 2-6. As a metal salt of organic acid to be blended, palladium acetate is used in Example 2-8, instead of silver salt of benzoic acid in Example 2-6.

To the resin composition described in Example 2-6 of 93 parts by mass, palladium acetate (molecular weight 224.49) of 14.8 parts by mass, as an organic metal compound, was added, and the mixture was uniformly blended using three rollers to prepare a resin mixture in paste form. After the blending, the palladium acetate in fine powder form dispersed in the resin mixture in paste form had an average particle size on the order of 0.5 to 1 µm. The formed resin mixture in paste form had a liquid viscosity of 105 Pa·s (25 °C). When the curable binder resin composition used as a dispersion medium was subjected to a heat curing treatment at a temperature in a range of 100 °C to 160 °C, the coating layer of a resin mixture in paste form functioned as an adhesive layer having a high adhesion strength to a non-conductive substrate to which a conductive circuit is manufactured, for example various polymeric film (sheet) surfaces.

Using the prepared resin mixture (adhesive for plating), a rectangular coating film of the resin mixture in paste form having a width 5 mm, a length 20 mm, and a mean coating film thickness of 20 µm was formed on a surface of polyimide non-conductive substrate in sheet form (Kapton 500H, manufactured by DuPont) and a surface of polycarbonate non-conductive substrate in sheet form (LEXAN 8010: manufactured by Piedomont Plastic, Inc) by mask printing using a metal mask having a thickness of 20 µm. Then, the film was dried for 10 minutes at a temperature of 110 °C to form a covering film layer (coating layer) having a mean film thickness of 19 µm without a tuck on the surface.

After the condition of exposure dose of 27 J/cm² for the "ultraviolet ray irradiation treatment" to each of the resin mixture coating layers on the non-conductive substrate surface was selected, the surface was subjected to the procedure and condition as described in Example 2-6 using the above described ultraviolet ray exposure apparatus to form an electroless plating copper layer.

During the treatment, the precipitation of the electroless plating copper covering layer was selectively enhanced on the surface of the resin mixture coating layer after the "ultraviolet ray irradiation treatment" which was formed on each non-conductive substrate, while no precipitation of the electroless plating copper covering layer was observed on the surface where each non-conductive substrate surface itself was exposed.

After non-conductive substrates were recovered from the electroless plating solution and the remained plating solution were rinsed, each of the non-conductive substrates was heated at 130 °C for three hours in a constant temperature furnace in an inert gas atmosphere to thermally cure the thermosetting epoxy resin composition contained in the resin mixture coating layer. Finally, the electroless plating copper layer fixedly attached to the surface of each non-conductive substrate via the cured layer of the thermosetting epoxy resin as an adhesive layer was evaluated with respect to a "volume resistivity" and "adhesion strength" in accordance with the above described evaluation methods.

The electroless plating copper layer formed had an average layer thickness of 12 µm, and no removed portion was observed in the above described tape removing test. The layer had a volume resistivity of 4.6 µΩ·cm, which meets the criteria for "good quality product" to have a volume resistivity of 10 µΩ·cm or less.

### (Example 2-9)

A resin mixture (adhesive for plating) having the following composition was prepared as a resin mixture which comprises metal fine particles of an average particle size of 1 to 200 nm uniformly dispersed in a curable binder resin composition.

The curable binder resin composition used as a solvent was a photo-curable epoxy resin composition that has the following composition. The photo-curable resin composition contained Urethane Acrylate 3201 (manufactured by Loctite) of 10 parts by mass as a urethane acrylate resin component, the main component, to which a photo-polymerization initiator was added in advance. In addition, relative to the main component, Urethane Acrylate 3201 of 100 parts by mass, a radical generator which uses heat decomposition, Perbutyl Z (t-butyl peroxybenzoate, manufactured by NOF CORPORATION) of 1 part by mass was added. These components were sufficiently mixed and blended to prepare a resin composition. Therefore, in addition to the photo-curing which used a photo-polymerization initiator, a heat curing could be achieved by radical polymerization using the radical generator following a heat treatment.

To the resin composition of 70 parts by mass, a dispersion containing Ag ultra fine particles having an average particle size of 5 nm (product name: Perfect Silver manufactured by Vacuum Metallurgical Co., Ltd.) of 30 parts by mass as dispersoid metal fine particles in a toluene dispersion solvent component of 55.7 parts by mass was added, and the particles were uniformly dispersed using three rollers to prepare a resin mixture in paste form. The Ag ultra fine particles having an average particle size of 5 nm comprised Ag ultra fine particles having a metal surface individually on which a covering layer of covering molecule dodecylamine was formed, and the covering molecule dodecylamine was contained by 15 parts by mass relative to the Ag ultra fine particles of 100 parts by mass.

The obtained resin mixture in paste form had a liquid viscosity of 49 Pa·s (25 °C). In the coating layer of a resin mixture in paste form, the photo-curable binder resin composition as the dispersion medium was irradiated with an ultraviolet ray at a wavelength in a range of 180 nm or more and 400 nm or less, thereby a polymerization was initiated by the photo-polymerization initiator. Then, the photo-curable binder resin composition was subjected to a heat treatment at a temperature in a range of 120 °C to 160 °C, which achieved a radical polymerization by the blended peroxide-based radical generator, eventually, the coating layer of a resin mixture in paste form functioned as an adhesive layer having a high adhesion strength to a non-conductive substrate to which a conductive circuit is manufactured, for example various polymeric film (sheet) surfaces.

A rectangular coating film of the resin mixture in paste form having a width 5 mm, a length 20 mm, and a mean coating film thickness of 20 µm was formed on a surface of polyimide non-conductive substrate in sheet form (Kapton 500H, manufactured by DuPont) and a surface of polycarbonate non-conductive substrate in sheet form (LEXAN 8010: manufactured by Piedomont Plastic, Inc) by mask printing using a metal mask having a thickness of 20 µm. Then, the film was irradiated with an ultraviolet ray at a wavelength in a range of 180 nm or more and 400 nm or less for photo-curing at a room temperature in an exposure dose of 1 J/cm² (at wavelength 365 nm) to form a covering film layer (coating layer) having a mean film thickness of 18 µm without a tuck on the surface.

The above described "stretching process" over the entire polycarbonate film caused the coating layer of the resin mixture in paste form which was formed on the polycarbonate film substrate by mask printing to be uniaxially stretched up to 170% of the original size in length, and the resin mixture coating layer to be stretched up to 170% of the original size in length. While, after the stretching process, the resin mixture coating layer had a mean film thickness of 10 µm, which corresponds to 10/17 of the original size.

As an "ultraviolet ray irradiation treatment" to the resin mixture coating layer on the polycarbonate film after the "stretching process", the surface was irradiated with an ultraviolet ray in an exposure dose of 45 J/cm² (wavelength 365 nm) using the above described ultraviolet ray exposure apparatus. While, to the resin mixture coating layer on the polyimide substrate, an ultraviolet ray irradiation in an exposure dose of 27 J/cm² (wavelength 365 nm) was performed using the above described ultraviolet ray exposure apparatus. Following the "ultraviolet ray irradiation treatment", at the photo-curable resin composition in the resin mixture coating layer, a photo-curing was driven by the incident ultraviolet ray in the depth direction of the coating layer from the surface of the ultraviolet ray irradiation region.

Next, after the "ultraviolet ray irradiation treatment", the polyimide substrate and the polycarbonate film after the "stretching process" were immersed in an electroless plating solution (MK-142, manufactured by Muromachi Technos Co., Ltd.) at 40 °C for three hours to perform a treatment of electroless plating of copper to the surface of the substrate. During the immersion, the precipitation of the electroless plating copper covering layer was selectively enhanced on the surface of the resin mixture coating layer after the "ultraviolet ray irradiation treatment" which was formed on each non-conductive substrate, while no precipitation of the electroless plating copper covering layer was observed on the surface where each non-conductive substrate surface itself was exposed.

After non-conductive substrates were recovered from the electroless plating solution and the remained plating solution were rinsed, each of the non-conductive substrates was heated at 130 °C for three hours in a constant temperature furnace in an inert gas atmosphere to thermally cure the thermosetting epoxy resin composition contained in the resin mixture coating layer. Finally, the electroless plating copper layer fixedly attached to the surface of each non-conductive substrate via the cured layer of the thermosetting epoxy resin as an adhesive layer was evaluated with respect to a "volume resistivity" and "adhesion strength" in accordance with the above described evaluation methods.

The electroless plating copper layer formed had an average layer thickness of 9 µm, and no removed portion was observed in the above described tape removing test. The layer had a volume resistivity of 3.5 µΩ·cm, which meets the criteria for "good quality product" to have a volume resistivity of 10 µΩ·cm or less.

### (Comparative Example 2-1)

A resin mixture (adhesive for plating) having the following composition was prepared as a resin mixture which comprises metal fine particles of an average particle size of 1 to 200 nm uniformly blended in a curable binder resin composition.

The curable binder resin composition used as a dispersion medium was a thermosetting epoxy resin composition having the following composition. The thermosetting epoxy resin composition comprised: 1,6-dihydroxy naphthalene diglycidyl ether, EPICLON HP-4032 (epoxy equivalent weight 142) of 7 parts by mass, and bisphenol A epoxy resin, EPICOAT 828EL (epoxy equivalent weight 187) of 3 parts by mass, as epoxy resin components; acid anhydride, YH-307 (molecular weight 235) of 13.8 parts by mass, as a curing agent component; an amine based curing catalyst, Amicure PN-23 of 0.3 parts by mass, as a curing accelerator; and KBM-403 of 0.1 parts by mass as a coupling agent component. These components were sufficiently mixed and blended to prepare a resin composition.

To the resin composition of 70 parts by mass, a dispersion containing Ag ultra fine particles having an average particle size of 5 nm (product name: Perfect Silver, dispersed ultra fine particles manufactured by Vacuum Metallurgical Co., Ltd.) of 30 parts by mass as dispersoid metal fine particles in a toluene dispersion solvent component of 55.7 parts by mass was added, and the particles were uniformly dispersed using three rollers to prepare a resin mixture in paste form. The Ag ultra fine particles having an average particle size of 5 nm comprised Ag ultra fine particles having a metal surface individually on which a covering layer of covering molecule dodecylamine was formed, and the covering molecule dodecylamine was contained by 15 parts by mass relative to the Ag ultra fine particles of 100 parts by mass. Eventually, the mixed toluene was distilled off in a reduced pressure to obtain an intended resin mixture in paste form.

The obtained resin mixture in paste form had a liquid viscosity of 40 Pa·s (25 °C). When the curable binder resin composition used as a dispersion medium was subjected to a heat curing treatment at a temperature in a range of 100 °C to 160 °C, the coating layer of a resin mixture in paste form functioned as an adhesive layer having a high adhesion strength to a non-conductive substrate to which a conductive circuit is manufactured, for example various polymeric film (sheet) surfaces.

A rectangular coating film of the resin mixture in paste form having a width 5 mm, a length 20 mm, and a mean coating film thickness of 19 µm was formed on a surface of polyimide non-conductive substrate in sheet form (Kapton 500H, manufactured by DuPont) and a surface of polycarbonate non-conductive substrate in sheet form (LEXAN 8010: manufactured by Piedomont Plastic, Inc) by mask printing using a metal mask having a thickness of 20 µm. Then, the film was dried for 310 minutes at a temperature of 110 °C to form a covering film layer (coating layer) having a mean film thickness of 18 µm without a tuck on the surface.

The above described "stretching process" over the entire polycarbonate film caused the coating layer of the resin mixture in paste form which was formed on the polycarbonate film substrate by mask printing to be uniaxially stretched up to 170% of the original size in length, and the resin mixture coating layer to be stretched up to 170% of the original size in length. While, after the stretching process, the resin mixture coating layer had a mean film thickness of 10 µm, which corresponds to 10/17 of the original size.

Next, without the "ultraviolet ray irradiation treatment", the polyimide substrate and the polycarbonate film after the "stretching process" were immersed in an electroless plating solution (MK-142 manufactured by Muromachi Technos Co., Ltd.) at 40 °C for three hours to try to perform a treatment of electroless plating of copper to the surface of the substrate. During the immersion, no precipitation of the electroless plating copper covering layer was observed on both of the resin mixture coating layer surface without the "ultraviolet ray irradiation treatment" and each of the surface where each non-conductive substrate surface itself were exposed.

### (Comparative Example 2-2)

A resin mixture having the following composition was prepared as a resin mixture which comprises metal fine particles of an average particle size of 1 to 200 nm uniformly dispersed in a thermoplastic binder resin composition.

The thermoplastic binder resin composition used as a dispersion medium was a composition that contains a thermoplastic polyimide copolymer (solid content 27%) dissolved in a γ-butyrolactone and triglyme solvent. To the thermoplastic polyimide copolymer (solid content 27%) of 259 parts by mass, a dispersion containing Ag ultra fine particles having an average particle size of 5 nm (product name: Perfect Silver, dispersed ultra fine particles manufactured by Vacuum Metallurgical Co., Ltd.) of 30 parts by mass in a toluene dispersion solvent component of 55.7 parts by mass was added, and the particles were uniformly dispersed using three rollers to prepare a resin mixture in paste form. The Ag ultra fine particles having an average particle size of 5 nm comprised Ag ultra fine particles having a metal surface individually on which a covering layer of covering molecule dodecylamine was formed, and the covering molecule dodecylamine was contained by 15 parts by mass relative to the Ag ultra fine particles of 100 parts by mass. Eventually, the mixed toluene was distilled off in a reduced pressure to obtain an intended resin mixture in paste form.

The obtained resin mixture in paste form had a liquid viscosity of 83 Pa·s (25 °C). The coating layer of a resin mixture in paste form was subjected to a two-step curing by performing a heat treatment at a temperature of 100 °C for 30 minutes and a subsequent heat treatment at a temperature at 150 °C for 30 minutes to the contained thermoplastic binder resin to remove the solvent which was blended in the thermoplastic binder resin composition. As a result, after the curing treatment, the thermoplastic binder resin layer functioned as an adhesive layer to a non-conductive substrate to which a conductive circuit is manufactured, for example various polymeric film (sheet) surfaces.

A rectangular coating film of the resin mixture in paste form having a width 5 mm, a length 20 mm, and a mean coating film thickness of 19 µm was formed on a surface of polyimide non-conductive substrate in sheet form (Kapton 500H, manufactured by DuPont) by mask printing using a metal mask having a thickness of 20 µm. Then, the film was dried for 30 minutes at a temperature of 110 °C, and was heated at 200 °C for 30 minutes to form a covering film layer (coating layer) having a mean film thickness of 14 µm without a tuck on the surface.

As an "ultraviolet ray irradiation treatment" to the resin mixture coating layer on the polyimide substrate, the surface was irradiated with an ultraviolet ray in an exposure dose of 45 J/cm² (wavelength 365 nm) using the above described ultraviolet ray exposure apparatus.

Next, the polyimide substrate after the "ultraviolet ray irradiation treatment" was immersed in an electroless plating solution (MK-142 manufactured by Muromachi Technos Co., Ltd.) at 40 °C for three hours to try to perform a treatment of electroless plating of copper to the surface of the substrate. During the immersion, no precipitation of the electroless plating copper covering layer was observed on both of the resin mixture coating layer surface after the "ultraviolet ray irradiation treatment" and the surface where each non-conductive substrate surface itself was exposed.

### (Example 2-10)

A resin mixture (adhesive for plating) having the following composition was prepared as a resin mixture which comprises metal fine particles of an average particle size of 1 to 200 nm uniformly dispersed in a curable binder resin composition.

The curable binder resin composition used as a dispersion medium was a thermosetting epoxy resin composition having the following composition. The thermosetting epoxy resin composition comprised: 1,6-dihydroxy naphthalene diglycidyl ether, EPICLON HP-4032 (epoxy equivalent weight 142) of 7 parts by mass, and bisphenol A epoxy resin, EPICOAT 828EL (epoxy equivalent weight 187) of 3 parts by mass, as epoxy resin components; acid anhydride, YH-307 (molecular weight 235) of 13.8 parts by mass, as a curing agent component; an amine based curing catalyst, Amicure PN-23 of 0.3 parts by mass, as a curing accelerator; and KBM-403 of 0.1 parts by mass as a coupling agent component. These components were sufficiently mixed and blended to prepare a resin composition.

To the resin composition of 100 parts by mass, a dispersion containing Ag ultra fine particles having an average particle size of 5 nm (product name: Perfect Silver, dispersed ultra fine particles manufactured by Vacuum Metallurgical Co., Ltd.) of 30 parts by mass as dispersoid metal fine particles in a toluene dispersion solvent component of 55.7 parts by mass was added, and the particles were uniformly dispersed using three rollers to prepare a resin mixture in paste form. The Ag ultra fine particles having an average particle size of 5 nm comprised Ag ultra fine particles having a metal surface individually on which a covering layer of covering molecule dodecylamine was formed, and the covering molecule dodecylamine was contained by 15 parts by mass relative to the Ag ultra fine particles of 100 parts by mass. Eventually, the mixed toluene was distilled off in a reduced pressure to obtain an intended resin mixture (adhesive for plating) in paste form.

The obtained resin mixture in paste form had a liquid viscosity of 40 Pa·s (25 °C). When the curable binder resin composition used as a dispersion medium was subjected to a heat curing treatment at a temperature in a range of 100 °C to 160 °C, the coating layer of a resin mixture in paste form functioned as an adhesive layer having a high adhesion strength to a non-conductive substrate to which a conductive circuit is manufactured, for example various polymeric film (sheet) surfaces.

A rectangular coating film of the resin mixture in paste form having a width 5 mm, a length 20 mm, and a mean coating film thickness of 19 µm was formed on a surface of polyimide non-conductive substrate in sheet form (Kapton 500H, manufactured by DuPont) and a surface of polycarbonate non-conductive substrate in sheet form (LEXAN 8010: manufactured by Piedomont Plastic, Inc) by mask printing using a metal mask having a thickness of 20 µm. Then, the film was dried for 10 minutes at a temperature of 110 °C to form a covering film layer (coating layer) having a mean film thickness of 18 µm without a tuck on the surface.

The above described "stretching process" over the entire polycarbonate film caused the coating layer of the resin mixture in paste form which was formed on the polycarbonate film substrate by mask printing to be uniaxially stretched up to 170% of the original size in length, and the resin mixture coating layer to be stretched up to 170% of the original size in length. While, after the stretching process, the resin mixture coating layer had a mean film thickness of 10 µm, which corresponds to 10/17 of the original size.

As an "ultraviolet ray irradiation treatment" to the resin mixture coating layer on the polycarbonate film after the "stretching process", the surface was irradiated with an ultraviolet ray in an exposure dose of 45 J/cm² (wavelength 365 nm) using the above described ultraviolet ray exposure apparatus. While, to the resin mixture coating layer on the polyimide substrate, an ultraviolet ray irradiation in an exposure dose of 27 J/cm² (wavelength 365 nm) was performed using the above described ultraviolet ray exposure apparatus.

Next, after the "ultraviolet ray irradiation treatment", the polyimide substrate and the polycarbonate film after the "stretching process" were immersed in an electroless plating solution (Muden-Silver, manufactured by Okuno Chemical Industries Co., Ltd.) at 35 °C for three hours to perform a treatment of electroless plating of silver to the surface of the substrate. During the immersion, the precipitation of the electroless plating silver covering layer was selectively enhanced on the surface of the resin mixture coating layer after the "ultraviolet ray irradiation treatment" which was formed on each non-conductive substrate, while no precipitation of the electroless plating silver covering layer was observed on the surface where each non-conductive substrate surface itself was exposed.

After non-conductive substrates were recovered from the electroless plating solution and the remained plating solution were rinsed, each of the non-conductive substrates was heated at 130 °C for three hours in a constant temperature furnace in an inert gas atmosphere to thermally cure the thermosetting epoxy resin composition contained in the resin mixture coating layer. Finally, the electroless plating silver layer fixedly attached to the surface of each non-conductive substrate via the cured layer of the thermosetting epoxy resin as an adhesive layer was evaluated with respect to a "volume resistivity" and "adhesion strength" in accordance with the above described evaluation methods.

The electroless plating silver layer formed had the average layer thickness of 4 µm, and no removed portion was observed in the above described tape removing test. And the layer had a volume resistivity of 2.8 µΩ·cm, which meets the criteria for "good quality product" to have a volume resistivity of 10 µΩ·cm or less.

### III. Third Approach

First, a conductive circuit manufacturing method according to a third approach of the present invention will be explained in detail with reference to Examples.

The following Examples 3-1 to 3-2 are the examples of the best mode of the third approach of the present invention, but the third approach of the present invention is not limited to the Examples.

In Examples 3-1 to 3-2, as an "ultraviolet ray irradiation treatment", the following operation is used. And a resulting electroless plated layer is evaluated using the following conditions and criteria for each evaluation item.

### 1. "Ultraviolet Ray Irradiation Treatment"

An ultraviolet ray exposure apparatus which uses an ultra-highpressure mercury lamp of 2 kW is used as a source of ultraviolet ray so that a surface is exposed to an ultraviolet ray in a perpendicular direction to the surface. In the exposure, the exposure dose of the ultraviolet ray (irradiation intensity of light) is adjusted based on the intensity of light which is measured at a wavelength of 365 nm.

### 2. Evaluation of Electroless Plated Layer

"Volume Resistivity": In accordance with the test method of volume resistivity which is described in JIS-H-8646, a width (W), a length (L) of a forming rectangular electroless plated layer, and a mean thickness (T) of the cross-section of the electroless plated layer are measured, and a resistance value is measured using a 4 terminal method, thereby a volume resistivity is calculated for an assumed homogeneous conductor having the mean thickness (T).

An electroless plated layer of copper having a measured volume resistivity of 10 µΩ·cm or less is considered to be a good quality product.

"Adhesion Strength": In accordance with the tape test described in JIS-H-8504, a tape is pressed against a surface of a forming electroless plated layer for 10 seconds to adhere without air bubbles at the interface between the surface and the tape, and the adhesion tape is quickly removed. The adhesion force of the adhesion tape corresponds to 120 gf/cm.

An electroless plated layer on which no removed portion is observed on the tape-removed adhesion surface thereof is considered to be a good quality product.

### (Example 3-1)

A resin mixture comprising metal fine particles which have an average particle size of 1 to 200 nm uniformly dispersed in a resin composition was prepared. The metal fine particles are the silver ultra fine particles which have an average particles diameter of 5 nm and are individually provided with a metal surface on which a covering layer of covering molecule dodecylamine is formed, and the covering molecule dodecylamine is contained by 15 parts by mass relative to the silver ultra fine particles of 100 parts by mass. The silver ultra fine particles was added by 30 parts by mass to a polyimide resin of 70 parts by mass, which was heated to melt to uniformly disperse the silver ultra fine particles in the resin and obtain an intended plate-shaped resin mixture. The plate-shaped resin mixture (polyimide substrate) has a surface on which silver ultra fine particles uniformly dispersed in a polyimide resin were exposed at a uniform area density.

A mask having an opening in the shape of an intended wiring pattern was placed on the polyimide substrate, and as an "ultraviolet ray irradiation treatment", the surface was irradiated with an ultraviolet ray in an exposure dose of 45 J/cm² (wavelength 365 nm) using the above described ultraviolet ray exposure apparatus. The obtained board after the ultraviolet ray irradiation is set to be Sample A.

The polyimide substrate after the "ultraviolet ray irradiation treatment" is deformed to have the shape described in Figure 1, which is set to be Sample B.

To the obtained two samples, three commercially available plating solutions, MK-421A, MK-421 B, MK-421 M (manufactured by Muromachi Technos Co., Ltd.) each of which was diluted with water at the above ratio and had the following composition are used for an electroless plating process:
MK-421A (copper component + HCHO) 0.035 L
MK-421 B (sodium hydroxide) 0.035 L
MK-421 M (potassium hydroxide) 0.100 L
Water 0.830 L

The polyimide substrate was immersed in an electroless plating solution (MK-421, manufactured by Muromachi Technos Co., Ltd.) at 40 °C for three hours to perform a treatment of electroless plating of copper to the surface of the substrate. During the immersion, the precipitation of the electroless plating copper covering layer was selectively enhanced on the substrate surface after the "ultraviolet ray irradiation treatment" which was formed on each non-conductive substrate surface, while no precipitation of the electroless copper plating covering film was observed on the substrate surface without the "ultraviolet ray irradiation treatment".

After non-conductive substrates were recovered from the electroless plating solution and the remained plating solution were rinsed, the electroless copper plating layer fixedly attached to each of the substrate surface was evaluated with respect to a "volume resistivity" and "adhesion strength" in accordance with the above described evaluation methods.

All of the electroless plating copper layers formed had the average layer thickness of 4 µm, and no removed portion was observed in the above described tape removing test. And Sample A had a volume resistivity of 5.5 µΩ·cm and Sample B had a volume resistivity of 6.1 µΩ·cm, which means both of the Samples meet the criteria for "good quality product" to have a volume resistivity of 10 µΩ·cm or less.

### (Example 3-2)

The resin mixture which was prepared in a similar manner to that in Example 3-1 was deformed into a film form to obtain a polyimide film. The film-shaped resin mixture (polyimide film) had a surface on which silver ultra fine particles uniformly dispersed in a polyimide resin were exposed at a uniform area density.

A mask having an opening in the shape of an intended wiring pattern was placed on the polyimide film, and as an "ultraviolet ray irradiation treatment", the surface was irradiated with an ultraviolet ray in an exposure dose of 45 J/cm² (at wavelength of 365 nm) using the above described ultraviolet ray exposure apparatus. The obtained board after the ultraviolet ray irradiation is set to be Sample C. Also, the polyimide film after the "ultraviolet ray irradiation treatment" is deformed into a shape following an inner side of a rear lid of a cellular, which is set to be Sample D.

The obtained two samples were subjected to an electroless plating process in a similar manner to that in Example 3-1, and the electroless plating copper layer fixedly attached to the surface of each non-conductive substrate after the plating process was evaluated with respect to a "volume resistivity" and "adhesion strength" in accordance with the above described evaluation methods.

All of the electroless plating copper layers formed had the average layer thickness of 4 µm, and no removed portion was observed in the above described tape removing test. And Sample C had a volume resistivity of 5.3 µΩ·cm and Sample D had a volume resistivity of 5.8 µΩ·cm, which means both of the Samples meet the criteria for "good quality product" to have a volume resistivity of 10 µΩ·cm or less. And the polyimide film which was deformed to the shape following the inner side of the rear lid of the cellular and was provided with an electroless plating copper layer formed on a desired region was fixedly attached to the rear lid using an adhesive, so that a circuit could be formed on the rear lid of the cellular.

### Industrial Applicability

In a conductive circuit manufacturing method according to the present invention, a high adhesion property can be achieved by adhering an electroless plating metal layer having a desired shape of the circuit pattern via an adhesive layer to a surface of a non-conductive substrate which is subjected to a deforming process and made of polymeric material, and also a conductive circuit manufacturing method according to the present invention can be preferably used when an electroless plating metal layer having a desired shape of the circuit pattern is simply formed without using a plating mask layer. A conductive circuit manufacturing method according to the present invention is a preferable approach when a non-conductive substrate of a flexible polymeric material such as a polyimide or polycarbonate film is used as a non-conductive substrate of polymeric material which can be subjected to a deforming process for example.

## Claims

1. A method for forming a conductive circuit on a surface of a three dimensionally deformed non-conductive substrate, which methd comprises:
a step for coating a resin mixture comprising metal fine particles of an average particle size of 1 to 200 nm uniformly which are dispersed in a curable binder resin composition on a surface of the non-conductive substrate having a flat shape to form a coating layer of the resin mixture;
a step for heating the coating layer at a low temperature for prebaking;
a step for irradiating an energy beam to the surface of the resin mixture coating layer;
a step for performing a deforming operation in three dimensions to the non-conductive substrate having the flat shape, on the surface of which the resin mixture coating layer is formed;
a step for selectively forming an electroless plated layer only to the surface portion where the energy beam is irradiated in the resin mixture coating layer formed on the surface of the non-conductive substrate, by applying electroless plating to the surface of the non-conductive substrate to which the deforming operation in three dimensions is performed; and
a step for heating the non-conductive substrate having the electroless plated layer conductive layer for curing of the resin mixture coating layer, and
thereby a conductive circuit having a predetermined pattern which is made of the electroless plated layer is formed onto the surface of the three dimensionally deformed non-conductive substrate.

2. The conductive circuit manufacturing method according to claim 1, wherein
the deforming operation in three dimensions is a curved surface forming.

3. The conductive circuit manufacturing method according to claim 2, wherein
the radius of curvature of the curved surface of the non-conductive substrate surface which is formed in the curved surface forming is in a range of 5 mm to 1 m.

4. The conductive circuit manufacturing method according to claim 2, wherein
the non-conductive substrate to which the three dimensional deforming operation is performed has a thickness in a range of 0.1 mm to 1 cm, and
the radius of curvature of the curved surface of the non-conductive substrate surface which is formed in the curved surface forming is selected so that the ratio of a radius of curvature of the non-conductive substrate surface to a thickness of the non-conductive substrate is 10 or more.

5. The conductive circuit manufacturing method according to claim 1, wherein
the deforming operation in three dimensions is to form a bended shape with a predetermined angle between surfaces.

6. The conductive circuit manufacturing method according to claim 5, wherein
in the bended shape, the angle between the surfaces at the corners thereof is selected to be in a range of 60 to 160 ° or from 200 to 300°.

7. The conductive circuit manufacturing method according to any one of claims 1 to 6, wherein
the material of the non-conductive substrate is selected from the group consisting of polyimide, polycarbonate, polyacetal, polyphenylene ether (PPE), polybutylene terephthalate (PPB), polyamide imide, fluorocarbon polymer, polyalylate, polysulfone, polyphenylene sulfide, and polyether ether ketone.

8. A method for forming a conductive circuit on a surface of a non-conductive substrate, which method comprises:
a step for coating a resin mixture comprising metal fine particles of an average particle size of 1 to 200 nm uniformly which are dispersed in a curable binder resin composition on a surface of the non-conductive substrate to form a coating layer of the resin mixture;
a step for irradiating an energy beam to the surface of the resin mixture coating layer;
a step for performing a deforming operation in three dimensions to the non-conductive substrate, on the surface of which the resin mixture coating layer is formed; and
a step for applying electroless plating to the surface of the non-conductive substrate to which the deforming operation in three dimensions is performed, and
the electroless plating is applied to the surface portion where the energy beam is irradiated in the resin mixture coating layer which is formed to the non-conductive substrate surface to selectively form an electroless plated layer, so that the conductive circuit is formed in a predetermined pattern using the electroless plated layer as a conductive layer.

9. The conductive circuit manufacturing method according to claim 8, wherein
the metal composing the metal fine particles is a metal species or an alloy consisting of two or more metal species which is selected from the group consisting of Pd, Ag, Cu, Au, Pt, Zn, Cr, Fe, and Ni.

10. The conductive circuit manufacturing method according to claim 8, wherein
the metal fine particles are those which are selected to have an average particle size within a range of 1 to 70 nm.

11. The conductive circuit manufacturing method according to claim 8, wherein
the curable binder resin is a thermosetting resin.

12. The conductive circuit manufacturing method according to claim 8, wherein
the curable binder resin is a photo-curable resin.

13. The conductive circuit manufacturing method according to claim 8, wherein
the curable binder resin is an epoxy resin or an alkyd resin.

14. The conductive circuit manufacturing method according to claim 8, wherein
the energy beam is an electron beam or an ultraviolet ray.

15. The conductive circuit manufacturing method according to claim 8, wherein
the metal species used in the electroless plated layer is a metal selected from the group consisting of Pd, Ag, Cu, Au, Pt, Zn, Cr, Fe, and Ni.

16. A method for forming a conductive circuit on a surface of a non-conductive substrate, which method comprises:
a step for coating a resin mixture comprising an organic metal compound which is uniformly dispersed in a curable binder resin composition on a surface of the non-conductive substrate to form a coating layer of the resin mixture;
a step for irradiating an energy beam to the surface of the resin mixture coating layer;
a step for performing a deforming operation in three dimensions to the non-conductive substrate, on the surface of which the resin mixture coating layer is formed; and
a step for applying electroless plating to the surface of the non-conductive substrate to which the deforming operation in three dimensions is performed, and
the electroless plating is applied to the surface portion where the energy beam is irradiated in the resin mixture coating layer which is formed to the non-conductive substrate surface to selectively form an electroless plated layer, so that the conductive circuit is formed in a predetermined pattern using the electroless plated layer as a conductive layer.

17. The conductive circuit manufacturing method according to claim 16, wherein
the organic metal compound is a metal salt of organic acid or an organometallic complex.

18. The conductive circuit manufacturing method according to claim 16, wherein
the metal species contained in the organic metal compound is a metal selected from the group consisting of Pd, Ag, Cu, Au, Pt, Zn, Cr, Fe, and Ni.

19. The conductive circuit manufacturing method according to claim 16, wherein
the curable binder resin is a thermosetting resin.

20. The conductive circuit manufacturing method according to claim 16, wherein
the curable binder resin is a photo-curable resin.

21. The conductive circuit manufacturing method according to claim 16, wherein
the curable binder resin is an epoxy resin or an alkyd resin.

22. The conductive circuit manufacturing method according to claim 16, wherein
the energy beam is an electron beam or an ultraviolet ray.

23. The conductive circuit manufacturing method according to claim 16, wherein
the metal species used in the electroless plated layer is a metal selected from the group consisting of Pd, Ag, Cu, Au, Pt, Zn, Cr, Fe, and Ni.

24. A method for forming a conductive circuit on a surface of a non-conductive substrate, which method comprises:
a step for coating a resin mixture comprising metal fine particles of an average particle size of 1 to 200 nm uniformly which are dispersed in a curable binder resin composition on a surface of the non-conductive substrate to form a coating layer of the resin mixture;
a step for irradiating an energy beam to the surface of the resin mixture coating layer; and
a step for applying electroless plating to the surface of the non-conductive substrate, and
the electroless plating is applied to the surface portion where the energy beam is irradiated in the resin mixture coating layer which is formed to the non-conductive substrate surface to selectively form an electroless plated layer, so that the conductive circuit is formed in a predetermined pattern using the electroless plated layer as a conductive layer.

25. The conductive circuit manufacturing method according to claim 24, wherein
the metal composing the metal fine particles is a metal species or an alloy consisting of two or more metal species which is selected from the group consisting of Pd, Ag, Cu, Au, Pt, Zn, Cr, Fe, and Ni.

26. The conductive circuit manufacturing method according to claim 24, wherein
the metal fine particles are those which are selected to have an average particle size within a range of 1 to 70 nm.

27. The conductive circuit manufacturing method according to claim 24, wherein
the curable binder resin is a thermosetting resin.

28. The conductive circuit manufacturing method according to claim 24, wherein
the curable binder resin is a photo-curable resin.

29. The conductive circuit manufacturing method according to claim 24, wherein
the curable binder resin is an epoxy resin or an alkyd resin.

30. The conductive circuit manufacturing method according to claim 24, wherein
when a coating layer of the resin mixture is formed, the shape of the coating layer is formed by drawing in the predetermined pattern, and
used as the drawing method is a printing method selected from the group consisting of screen printing, inkjet printing and transfer printing.

31. The conductive circuit manufacturing method according to claim 24, wherein
the energy beam is an electron beam or an ultraviolet ray.

32. The conductive circuit manufacturing method according to claim 24, wherein
the metal species used in the electroless plated layer is a metal selected from the group consisting of Pd, Ag, Cu, Au, Pt, Zn, Cr, Fe, and Ni.

33. A method for forming a conductive circuit on a surface of a non-conductive substrate, which method comprises:
a step for coating a resin mixture comprising an organic metal compound which is uniformly dispersed in a curable binder resin composition on a surface of the non-conductive substrate to form a coating layer of the resin mixture;
a step for irradiating an energy beam to the surface of the resin mixture coating layer; and
a step for applying electroless plating to the surface of the non-conductive substrate, and
the electroless plating is applied to the surface portion where the energy beam is irradiated in the resin mixture coating layer which is formed to the non-conductive substrate surface to selectively form an electroless plated layer, so that the conductive circuit is formed in a predetermined pattern using the electroless plated layer as a conductive layer.

34. The conductive circuit manufacturing method according to claim 33, wherein
the organic metal compound is a metal salt of organic acid or an organometallic complex.

35. The conductive circuit manufacturing method according to claim 33, wherein
the metal species contained in the organic metal compound is a metal selected from the group consisting of Pd, Ag, Cu, Au, Pt, Zn, Cr, Fe, and Ni.

36. The conductive circuit manufacturing method according to claim 33, wherein
the curable binder resin is a thermosetting resin.

37. The conductive circuit manufacturing method according to claim 33, wherein
the curable binder resin is a photo-curable resin.

38. The conductive circuit manufacturing method according to claim 33, wherein
the curable binder resin is an epoxy resin or an alkyd resin.

39. The conductive circuit manufacturing method according to claim 33, wherein
when a coating layer of the resin mixture is formed, the shape of the coating layer is formed by drawing in the predetermined pattern, and
used as the drawing method is a printing method selected from the group consisting of screen printing, inkjet printing and transfer printing.

40. The conductive circuit manufacturing method according to claim 33, wherein
the energy beam is an electron beam or an ultraviolet ray.

41. The conductive circuit manufacturing method according to claim 33, wherein
the metal species used in the electroless plated layer is a metal selected from the group consisting of Pd, Ag, Cu, Au, Pt, Zn, Cr, Fe, and Ni.

42. A method for forming a conductive circuit on a surface of a non-conductive substrate, which non-conductive substrate is a substrate formed of a non-conductive material that comprises fine metal particles of an average particle size 1 to 200 nm uniformly dispersed in a non-conductive resin composition, which method comprises:
a step for irradiating an energy beam only to a portion of the surface of the non-conductive substrate where the conductive circuit is formed;
a step for performing a deforming operation in three dimensions to the non-conductive substrate; and
a step for applying electroless plating to the surface of the non-conductive substrate to which the deforming operation in three dimensions is performed, and
the electroless plating is applied to selectively form an electroless plated layer at the portion of the surface of the non-conductive substrate where the energy beam is irradiated, so that the conductive circuit is formed in a predetermined pattern using the electroless plated layer as a conductive layer.

43. The conductive circuit manufacturing method according to claim 42, wherein
the metal fine particles uniformly dispersed in the non-conductive resin composition are fine particles of a metal or fine particles of an alloy consisting of two or more species selected from the group consisting of gold, silver, copper, platinum, palladium, zinc, iron, chromium, and nickel.

44. The conductive circuit manufacturing method according to claim 42, wherein
the non-conductive material used in forming the non-conductive substrate contains a polyimide resin as a main component among resin components of the non-conductive resin composition.

45. The conductive circuit manufacturing method according to claim 42, wherein
the energy beam is an electron beam or an ultraviolet ray.

46. The conductive circuit manufacturing method according to claim 42, wherein
the deforming operation in three dimensions to the non-conductive substrate is embossing.

47. The conductive circuit manufacturing method according to claim 42, wherein
the metal species used in forming the electroless plated layer is a metal selected from the group consisting of gold, silver, copper, platinum, palladium, zinc, iron, chromium, and nickel.

48. A method for forming a conductive circuit on a surface of a non-conductive substrate, which non-conductive substrate is a substrate formed of a non-conductive material that comprises fine particles of an organic metal compound uniformly dispersed in a non-conductive resin composition, which method comprises:
a step for irradiating an energy beam only to a portion of the surface of the non-conductive substrate where the conductive circuit is to be formed;
a step for performing a deforming operation in three dimensions to the non-conductive substrate; and
a step for applying electroless plating to the surface of the non-conductive substrate to which the deforming operation in three dimensions is performed, and
the electroless plating is applied to selectively form an electroless plated layer at the portion of the surface of the non-conductive substrate where the energy beam is irradiated, so that the conductive circuit is formed in a predetermined pattern using the electroless plated layer as a conductive layer.

49. The conductive circuit manufacturing method according to claim 48, wherein
the organic metal compound of the fine particles of an organic metal compound is selected from a metal salt of organic acid or an organometallic complex.

50. The conductive circuit manufacturing method according to claim 48, wherein
the metal species contained in the organic metal compound of the organic metal compound fine particles which are exposed at the surface of the non-conductive substrate are fine particles of a metal species or two or more metal species selected from the group consisting of gold, silver, copper, platinum, palladium, zinc, iron, chromium, and nickel.

51. The conductive circuit manufacturing method according to claim 48, wherein
the non-conductive material used in forming the non-conductive substrate contains a polyimide resin as a main component among resin components of the non-conductive resin composition

52. The conductive circuit manufacturing method according to claim 48, wherein
the energy beam is an electron beam or an ultraviolet ray.

53. The conductive circuit manufacturing method according to claim 48, wherein
the deforming operation in three dimensions to the non-conductive substrate is embossing.

54. The conductive circuit manufacturing method according to claim 48, wherein
the metal species used in forming the electroless plated layer is a metal selected from the group consisting of gold, silver, copper, platinum, palladium, zinc, iron, chromium, and nickel.
